# EUROPÄISCHE PATENTSCHRIFT

(11) **EP 4 196 486 B1**
(45) Veröffentlichungstag und Bekanntmachung des Hinweises auf die Patenterteilung: **09.07.2025**
(21) Anmeldenummer: 21762641.5
(22) Anmeldetag: 10.08.2021
(51) Int. Cl.: C07F 15/00, C09K 11/06, H10K 85/30

(54) **METALLKOMPLEXE**
METAL COMPLEXES
COMPLEXES MÉTALLIQUES

(30) Priorität: 13.08.2020 EP 20190795
(43) Veröffentlichungstag der Anmeldung: 21.06.2023
(73) Patentinhaber: UDC Ireland Limited, Ballycoolin, Dublin 15 (IE)
(72) Erfinder: HAYER, Anna, 64293 DARMSTADT (DE); LINGE, Rouven, 64293 DARMSTADT (DE); AUCH, Armin, 64293 DARMSTADT (DE); STOESSEL, Philipp, 64293 DARMSTADT (DE); KOENEN, Nils, 64293 DARMSTADT (DE)
(74) Vertreter: Maiwald GmbH
(86) Internationale Anmeldenummer: PCT/EP2021/072214
(87) Internationale Veröffentlichungsnummer: WO 2022/034046

(56) Entgegenhaltungen:
- EP-A1- 3 507 294
- WO-A1-2018/041769

## Beschreibung

Die vorliegende Erfindung betrifft binukleare Metallkomplexe, welche sich für den Einsatz als Emitter in organischen Elektrolumineszenzvorrichtungen eignen.

Gemäß dem Stand der Technik werden in phosphoreszierenden organischen Elektrolumineszenzvorrichtungen (OLEDs) als Triplettemitter vor allem ortho-metallierte Iridiumkomplexe mit aromatischen Liganden eingesetzt, wobei die Liganden über ein negativ geladenes Kohlenstoffatom und ein neutrales Stickstoffatom an das Metall binden. Aus WO 2018/041769 sind binukleare Iridiumkomplexe, vor allem für rote Emission, bekannt, welche aus Lösung verarbeitet werden können.

Generell kann die externe Quanteneffizienz von OLED-Bauteilen deutlich erhöht werden, wenn das Übergangsdipolmoment der Emission der enthaltenen Emitter möglichst horizontal, d.h. in der Ebene der Emissionsschicht, orientiert wird. Dieser Effekt ist bekannt für vakuum-prozessierte Singulett- und Triplettemitter, sowie für lösungsprozessierte Singulettemitter. Auch die Orientierung lösungsprozessierter Polymere ist bekannt. Dagegen ist die Orientierung von Triplettemittern aus Lösung ein noch ungelöstes technisches Problem. So ist bekannt, dass Emitter, die sich beim Aufdampfen orientieren, dies aus Lösung nicht tun (z. B. Lampe et al., Chem. Mater. 2016, 28, 712-715). Auch in einem Übersichtsartikel aus 2019 (Watanabe et al., Bull. Chem. Soc. Jpn. 2019, 92, 716-728) wird die Orientierung aus Lösung als noch ausstehendes Problem beschrieben. Die Tatsache, dass Verbindungen, die orientiert aufgedampft werden können, aus Lösung nicht-orientierte Filme bilden, wird dabei auf Unterschiede im Filmbildungsmechanismus bezüglich der kinetischen Stabilität und der Molekulardynamik in Lösung zurückgeführt.

Bei vakuum-prozessierten Triplettemittern kann Orientierung und damit eine Verbesserung der externen Quanteneffizienz der OLED erreicht werden, indem der optisch aktive Ligand mit Gruppen substituiert wird, die durch die Wechselwirkung mit der Oberfläche beim Aufdampfprozess zu einer Orientierung führen. Geeignete Substituenten sind hier beispielsweise Biphenylgruppen oder ähnliche Gruppen, die am Liganden in Richtung des Übergangsdipolmoments verknüpft sind. Derartige Substituenten, die bei vakuum-prozessierten Triplettemittern bereits für Orientierung sorgen, führen bei lösungsprozessierten Triplettemittern allerdings nicht zu einer nennenswerten Orientierung, so dass dieses Konzept nicht direkt auf Triplettemitter, die aus Lösung verarbeitet werden sollen, übertragen werden kann. Auch Komplexe mit einem Acetylacetonat-Liganden führen häufig beim Aufdampfen, jedoch nicht bei Verarbeitung aus Lösung, zu einer Orientierung.

EP 3507294 A1 beschreibt bi- und trinukleare Metallkomplexe, welche sich für den Einsatz als Emitter in OLEDs eignen.

Aufgabe der vorliegenden Erfindung ist die Bereitstellung neuer Metallkomplexe, welche aus Lösung verarbeitet werden können und welche sich als Emitter für die Verwendung in OLEDs eignen. Insbesondere ist es die Aufgabe, Emitter bereitzustellen, welche bei Aufbringung aus Lösung zu Orientierung führen und welche so zu einer Verbesserung der externen Quanteneffizienz der OLED führen.

Überraschend wurde gefunden, dass die nachfolgend beschriebenen binuklearen Iridiumkomplexe, welche mit linearen langkettigen aromatischen Gruppen substituiert sind, bei Verarbeitung aus Lösung zu Orientierung und dadurch in der OLED zu einer deutlichen Verbesserung der externen Quanteneffizienz führen. Diese Komplexe und organische Elektrolumineszenzvorrichtungen, welche diese Komplexe enthalten, sind daher der Gegenstand der vorliegenden Erfindung.

Gegenstand der Erfindung ist eine Verbindung gemäß der folgenden Formel (1), 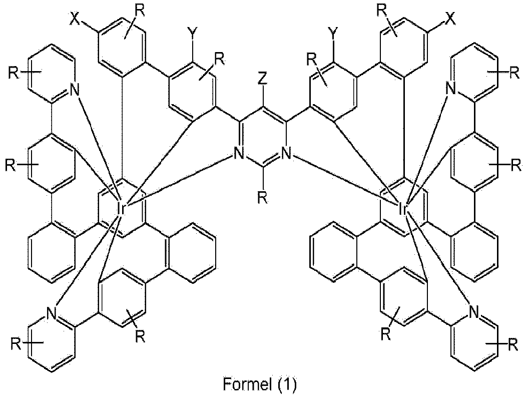 wobei für die verwendeten Symbole und Indizes gilt:
- X: ist bei jedem Auftreten gleich oder verschieden eine Gruppe der Formel -(Ar)ₙ-R;
- Y: ist bei jedem Auftreten gleich oder verschieden R oder X;
- Z: ist gleich oder verschieden R oder X;
- Ar: ist bei jedem Auftreten gleich oder verschieden eine bivalente Gruppe, welche ausgewählt ist aus den Strukturen (Ar1) bis (Ar7), 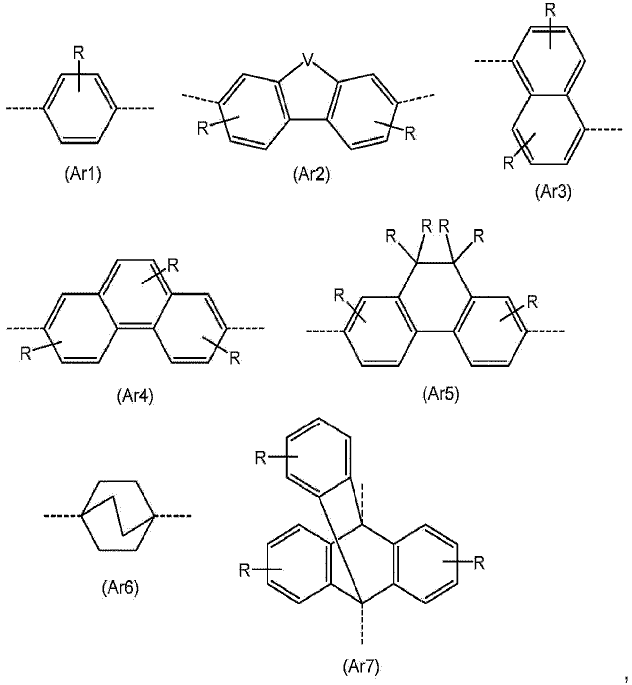 wobei die gestrichelte Bindung die Verknüpfung der Einheiten darstellt und V für CR₂, O, S oder NR steht;
- n: ist bei jedem Auftreten gleich oder verschieden eine ganze Zahl von 3 bis 20 mit der Maßgabe, dass in jeder Einheit -(Ar)ₙ-R mindestens 5 Phenyl- und/oder Cyclohexylgruppen linear miteinander verknüpft sind;
- R: kann jeweils einmal oder mehrfach auftreten und ist bei jedem Auftreten gleich oder verschieden H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
- R¹: ist bei jedem Auftreten gleich oder verschieden H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können.

Das charakterisierende Merkmal der erfindungsgemäßen Verbindung ist die Anwesenheit von zwei Gruppen X, bei welchen es sich um linear verknüpfte aromatische bzw. heteroaromatische Gruppen bzw. cyclische aliphatische Gruppen handelt. Dabei bedeutet in der Definition von n "mit der Maßgabe, dass in jeder Einheit -(Ar)ₙ-R mindestens 5 Phenyl- und/oder Cyclohexylgruppen linear miteinander verknüpft sind", dass die Struktur X mindestens 5 miteinander verknüpfte Phenyl- bzw. Cyclohexangruppen aufweist, wobei nur die direkt hintereinander verknüpften Phenyl- bzw. Cyclohexangruppen, aber nicht potenzielle Substituenten an diesen Strukturen gezählt werden. Dabei tragen die Strukturen (Ar1) und (Ar3) jeweils eine Phenylgruppe bei, die Strukturen (Ar2), (Ar4) und (Ar5) tragen jeweils zwei Phenylgruppen bei, und die Strukturen (Ar6) und (Ar7) tragen jeweils eine Cyclohexangruppe bei, wobei die Struktur (Ar7) im Sinne dieser Erfindung auch als eine Cyclohexangruppe betrachtet wird, auch wenn an diese Struktur noch aromatische Gruppen ankondensiert sind. Wenn also die Gruppe X beispielsweise nur aus Gruppen (Ar1) aufgebaut ist, muss n ≥ 5 sein, damit X mindestens 5 miteinander verknüpfte Phenylgruppen aufweist. Wenn X dagegen beispielsweise aus einer Kombination von Gruppen (Ar1) und (Ar2) aufgebaut ist, kann auch n = 3 sein, wenn eine Gruppe (Ar1) und zwei Gruppen (Ar2) vorliegen.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können die Reste, die miteinander ein Ringsystem bilden, benachbart sein, d. h. diese Reste sind an dasselbe Kohlenstoffatom oder an Kohlenstoffatome, die direkt aneinander gebunden sind, gebunden, oder sie können weiter voneinander entfernt sein. Bevorzugt ist eine solche Ringbildung bei Resten, die an direkt aneinander gebundene Kohlenstoffatome oder an dasselbe Kohlenstoffatom gebunden sind.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

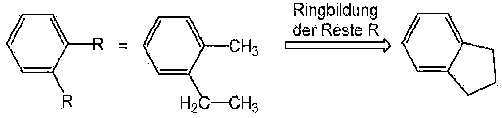

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

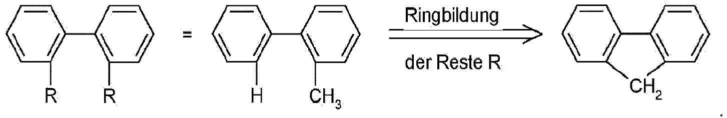

Die Bildung eines aromatischen bzw. heteroaromatischen Ringsystems soll durch das folgende Schema verdeutlicht werden:

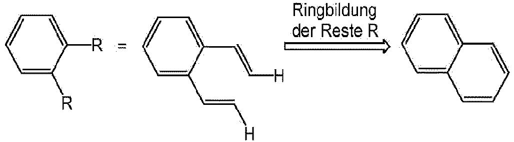

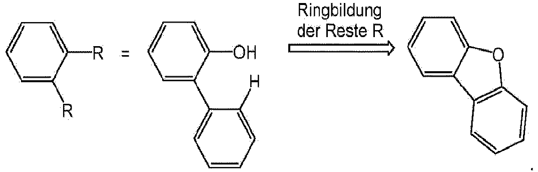

Eine Arylgruppe im Sinne dieser Erfindung enthält 6 bis 40 C-Atome, eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden. Bevorzugt ist das aromatische bzw. heteroaromatische Ringsystem ein System, in dem zwei oder mehrere Aryl- bzw. Heteroarylgruppen direkt über eine Einfachbindung miteinander verknüpft sind, oder ist Fluoren, Spirobifluoren oder eine andere Aryl- oder Heteroarylgruppe, an die eine gegebenenfalls substituierte Indengruppe ankondensiert ist, wie beispielsweise Indenocarbazol.

Im Rahmen der vorliegenden Erfindung wird der Begriff Alkylgruppe als Oberbegriff für lineare, verzweigte und cyclische Alkylgruppen verwendet. Analog werden die Begriffe Alkenylgruppe bzw. Alkinylgruppe als Oberbegriffe sowohl für lineare, verzweigte und cyclische Alkenyl- bzw. Alkinylgruppen verwendet.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₂₀-Alkoxygruppe, wie sie für OR¹ bzw. OR² vorliegt, werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Zur Veranschaulichung wird im Folgenden die erfindungsgemäße Verbindung genauer erläutert: Die Verbindung enthält eine Pyrimidingruppe, welche über jedes der beiden Stickstoffatome an jeweils ein Iridium koordiniert. An das Pyrimidin sind zwei Phenylgruppen gebunden, welche jeweils über ein Kohlenstoffatom an eines der beiden Iridiumatome koordinieren. An jede dieser beiden Phenylgruppen ist jeweils eine 1,3,5-Tris(ortho-phenyl)benzolgruppe gebunden, die jeweils den Brückenkopf des polypodalen Komplexes darstellt. An diese 1,3,5-Tris(ortho-phenyl)-benzolgruppen sind jeweils noch zwei optional substituierte Phenylpyridin-Teilliganden gebunden. Jedes der beiden Iridiumatome ist somit mit jeweils zwei Phenylpyridin-Teilliganden und einem Phenylpyrimidin-Teilliganden koordiniert, wobei die Pyrimidingruppe an beide Iridiumatome koordiniert.

Der Begriff Teilligand für die beiden Phenylpyridin-Liganden bedeutet im Sinne dieser Anmeldung, dass es sich hier um bidentate Liganden handeln würde, wenn die 1,3,5-Tris(ortho-phenyl)benzolgruppe nicht vorhanden wäre. Durch die formale Abstraktion eines Wasserstoffatoms am Phenylpyridin und die Verknüpfung mit der 1,3,5-Tris(ortho-phenyl)benzol-gruppe ist das Phenylpyridin jedoch kein separater Ligand, sondern ein Teil des so entstehenden dodekadentaten Liganden, also eines Liganden mit insgesamt 12 Koordinationsstellen, so dass hierfür der Begriff "Teilligand" verwendet wird.

Die Bindung des Liganden an das Iridium kann sowohl eine Koordinationsbindung als auch eine kovalente Bindung sein bzw. der kovalente Anteil an der Bindung kann je nach Ligand variieren. Wenn in der vorliegenden Anmeldung die Rede davon ist, dass der Ligand bzw. der Teilligand an Ir koordiniert oder bindet, so bezeichnet dies im Sinne der vorliegenden Anmeldung jede Art der Bindung des Liganden bzw. Teilliganden an das Ir, unabhängig vom kovalenten Anteil der Bindung.

Eine bevorzugte Ausführungsform der Erfindung sind die Verbindungen der folgenden Formel (1a), 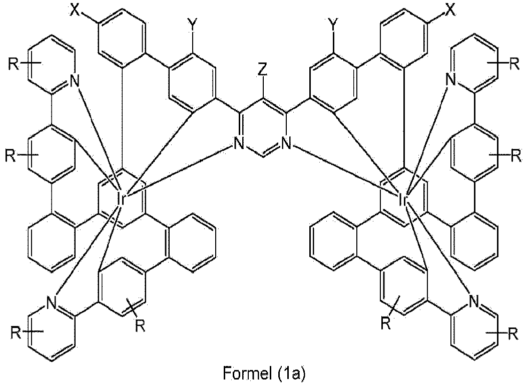 wobei die verwendeten Symbole die oben genannten Bedeutungen aufweisen.

In einer bevorzugten Ausführungsform der Erfindung sind beide Substituenten X gleich.

In einer Ausführungsform der Erfindung stehen Y und Z für H. In einer weiteren Ausführungsform der Erfindung stehen beide Gruppen Y für eine Gruppe der Formel -(Ar)ₙ-R, wobei die beiden Gruppen Y bevorzugt gleich sind, aber gleich oder verschieden den Gruppen X sein können, und Z steht für H. In nochmals einer weiteren Ausführungsform der Erfindung stehen beide Gruppen Y für H, und Z steht für eine Gruppe der Formel -(Ar)ₙ-R, die gleich oder verschieden den Gruppen X sein kann.

Bevorzugte Ausführungsformen der Formel (1) bzw. (1a) sind daher die Strukturen der folgenden Formeln (1a-1), (1a-2) bzw. (1a-3), 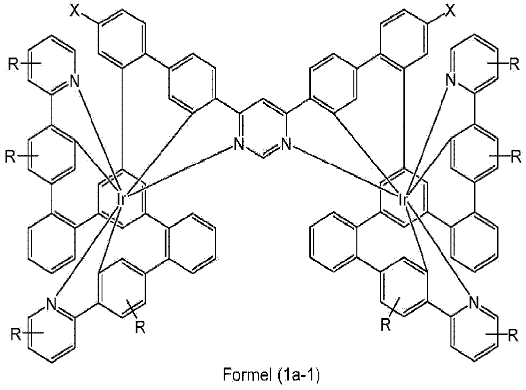 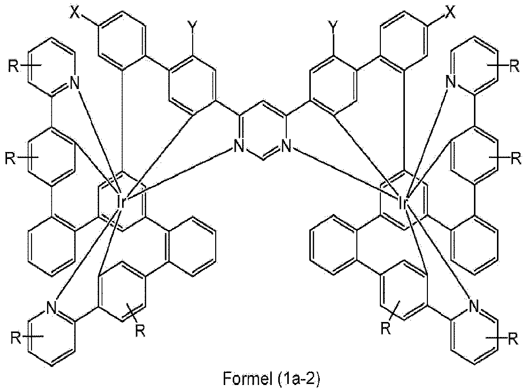 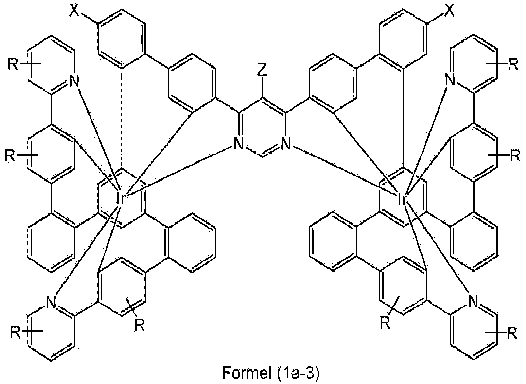 wobei beide Gruppen X jeweils gleich gewählt sind, und wobei die Gruppen Y in Formel (1a-2) jeweils für eine Gruppe -(Ar)ₙ-R stehen und gleich gewählt sind, und wobei die Gruppe Z in Formel (1a-3) für eine Gruppe -(Ar)ₙ-R steht. Besonders bevorzugt sind die Verbindungen der Formel (1a-1).

Der Rest R in der Gruppe -(Ar)ₙ-R steht bevorzugt bei jedem Auftreten gleich oder verschieden für H, eine lineare Alkylgruppe mit 1 bis 10 C-Atomen oder eine verzweigte oder cyclische Alkylgruppe mit 3 bis 10 C-Atomen, insbesondere für H.

Nachfolgend werden bevorzugte Gruppen Ar ausgeführt, die die Strukturen X bzw. gegebenenfalls auch Y und Z aufbauen. Hierbei handelt es sich, wie oben beschrieben, um die bivalenten Strukturen (Ar1) bis (Ar7), die jeweils gleich oder verschieden sein können. Den Gruppen (Ar1) bis (Ar7) ist gemeinsam, dass sie durch die para-Verknüpfung, bzw. in Formel (Ar3) einer Verknüpfung, die der para-Verknüpfung ähnlich ist, zu einer linearen Verknüpfung der Einheiten innerhalb der Gruppe X bzw. Y bzw. Z führen. Dies ist wesentlich, da nur dann die erfindungsgemäßen Verbindungen bei Abscheidung aus Lösung Orientierung zeigen.

Bevorzugte Ausführungsformen der Strukturen (Ar1) sind die folgenden Strukturen (Ar1a) bis (Ar1f), 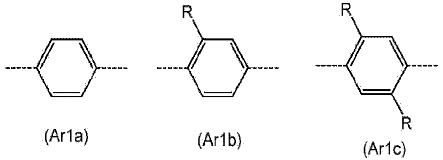 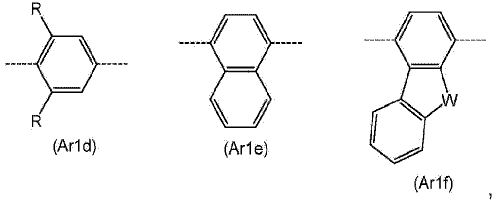 wobei die gestrichelten Bindungen die Verknüpfung der Strukturen darstellen, W für C(R¹)₂, O, S oder NR¹ steht und R und R¹ die oben genannten Bedeutungen aufweisen. Dabei steht W bevorzugt für O oder S.

Bevorzugte Substituenten R in den Strukturen (Ar1b) bis (Ar1d) sind gleich oder verschieden bei jedem Auftreten gewählt aus der Gruppe bestehend aus einer linearen Alkylgruppe mit 1 bis 20 C-Atomen oder einer verzweigten oder cyclischen Alkylgruppe mit 3 bis 20 C-Atomen, die jeweils durch einen oder mehrere Reste R¹ substituiert sein kann, bevorzugt aber unsubstituiert ist, oder einem aromatischen Ringsystem mit 6 bis 12 aromatischen Ringatomen, das durch einen oder mehrere Reste R¹ substituiert sein kann, wobei R¹ bevorzugt für eine lineare Alkylgruppe mit 1 bis 20 C-Atomen oder eine verzweigte oder cyclische Alkylgruppe mit 3 bis 20 C-Atomen steht, oder einer Gruppe OR¹, wobei R¹ für eine lineare Alkylgruppe mit 1 bis 20 C-Atomen oder eine verzweigte oder cyclische Alkylgruppe mit 3 bis 20 C-Atomen steht.

Wenn W in Formel (Ar1f) für C(R¹)₂ steht, steht R¹ bevorzugt für eine lineare Alkylgruppe mit 1 bis 20 C-Atomen oder eine verzweigte oder cyclische Alkylgruppe mit 3 bis 20 C-Atomen. Wenn W in Formel (Ar1f) für NR¹ steht, steht R¹ bevorzugt für ein aromatisches Ringsystem mit 6 bis 24 aromatischen Ringatomen, bevorzugt mit 6 bis 12 aromatischen Ringatomen, das auch durch eine oder mehrere Alkylgruppen mit jeweils 1 bis 20 C-Atomen substituiert sein kann.

Bevorzugte Ausführungsformen der Strukturen (Ar2) sind die Strukturen (Ar2a) und (Ar2b), 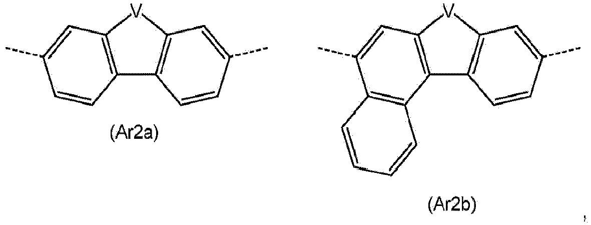 wobei die gestrichelten Bindungen die Verknüpfung der Strukturen darstellen und R und V die oben genannten Bedeutungen aufweisen.

Besonders bevorzugte Ausführungsformen der Struktur (Ar2) sind die folgenden Strukturen (Ar2a-1) bis (Ar2a-5) und (Ar2b-1), 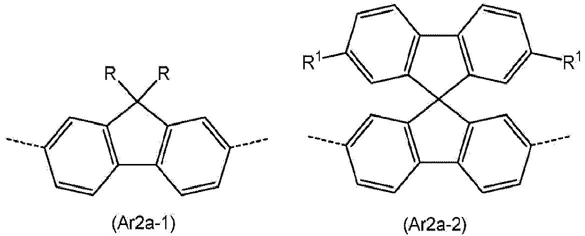 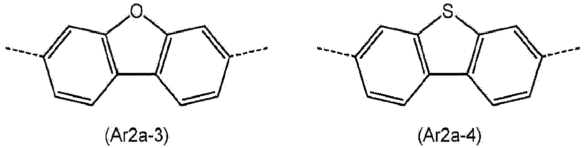 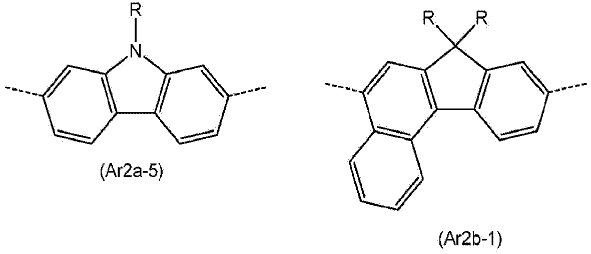 wobei die gestrichelten Bindungen die Verknüpfung der Struktur darstellen und R und R¹ die oben genannten Bedeutungen aufweisen.

Bevorzugte Substituenten R in den Strukturen (Ar2a-1) und (Ar2b-1) sind gleich oder verschieden bei jedem Auftreten gewählt aus der Gruppe bestehend aus einer linearen Alkylgruppe mit 1 bis 20 C-Atomen oder einer verzweigten oder cyclischen Alkylgruppe mit 3 bis 20 C-Atomen, die jeweils durch einen oder mehrere Reste R¹ substituiert sein kann, bevorzugt aber unsubstituiert ist, oder einem aromatischen Ringsystem mit 6 bis 12 aromatischen Ringatomen, das durch einen oder mehrere Reste R¹ substituiert sein kann, wobei R¹ bevorzugt für lineare Alkylgruppe mit 1 bis 20 C-Atomen oder eine verzweigte oder cyclische Alkylgruppe mit 3 bis 20 C-Atomen steht.

Bevorzugte Substituenten R¹ in den Strukturen (Ar2a-2) sind gleich oder verschieden bei jedem Auftreten gewählt aus der Gruppe bestehend aus H, einer linearen Alkylgruppe mit 1 bis 20 C-Atomen oder einer verzweigten oder cyclischen Alkylgruppe mit 3 bis 20 C-Atomen, die jeweils durch einen oder mehrere Reste R² substituiert sein kann, bevorzugt aber unsubstituiert ist.

Bevorzugte Substituenten R in den Strukturen (Ar2a-5) sind gleich oder verschieden bei jedem Auftreten gewählt aus der Gruppe bestehend aus einem aromatischen oder heteroaromatischen Ringsystem mit 6 bis 18 aromatischen Ringatomen, das durch einen oder mehrere Reste R¹ substituiert sein kann, bevorzugt einem aromatischen Ringsystem mit 6 bis 12 aromatischen Ringatomen, das durch einen oder mehrere Reste R¹ substituiert sein kann, wobei R¹ bevorzugt für eine lineare Alkylgruppe mit 1 bis 20 C-Atomen oder eine verzweigte oder cyclische Alkylgruppe mit 3 bis 20 C-Atomen steht.

Bevorzugte Ausführungsformen der Strukturen (Ar3) sind die folgenden Strukturen (Ar3a), 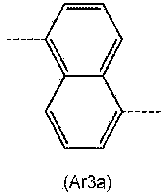 wobei die gestrichelten Bindungen die Verknüpfung der Struktur darstellen.

Bevorzugte Ausführungsformen der Strukturen (Ar4) sind die folgenden Strukturen (Ar4a) und (Ar4b), 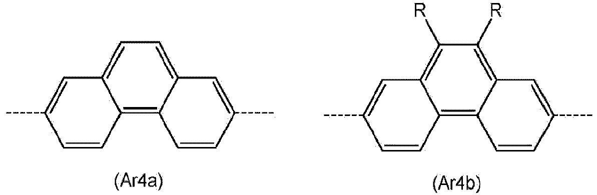 wobei die gestrichelten Bindungen die Verknüpfung der Struktur darstellen und R die oben genannten Bedeutungen aufweist.

Bevorzugte Substituenten R in der Strukturen (Ar4b) sind gleich oder verschieden bei jedem Auftreten gewählt aus der Gruppe bestehend aus einer linearen Alkylgruppe mit 1 bis 20 C-Atomen oder einer verzweigten oder cyclischen Alkylgruppe mit 3 bis 20 C-Atomen, die jeweils durch einen oder mehrere Reste R¹ substituiert sein kann, bevorzugt aber unsubstituiert ist, oder einem aromatischen Ringsystem mit 6 bis 12 aromatischen Ringatomen, das durch einen oder mehrere Reste R¹ substituiert sein kann, wobei R¹ bevorzugt für eine lineare Alkylgruppe mit 1 bis 20 C-Atomen oder eine verzweigte oder cyclische Alkylgruppe mit 3 bis 20 C-Atomen steht.

Bevorzugte Ausführungsformen der Strukturen (Ar5) sind die folgenden Strukturen (Ar5a) und (Ar5b), 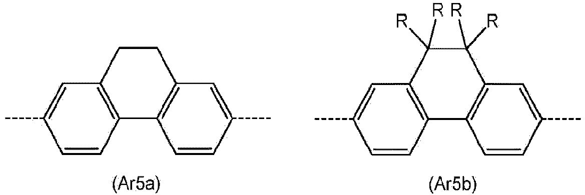 wobei die gestrichelten Bindungen die Verknüpfung der Struktur darstellen und R die oben genannten Bedeutungen aufweist.

Bevorzugte Substituenten R in den Strukturen (Ar5b) sind gleich oder verschieden bei jedem Auftreten gewählt aus der Gruppe bestehend aus H, einer linearen Alkylgruppe mit 1 bis 20 C-Atomen oder einer verzweigten oder cyclischen Alkylgruppe mit 3 bis 20 C-Atomen, die jeweils durch einen oder mehrere Reste R¹ substituiert sein kann, bevorzugt aber unsubstituiert ist.

Bevorzugte Ausführungsformen der Strukturen (Ar7) sind die folgenden Strukturen (Ar7a), 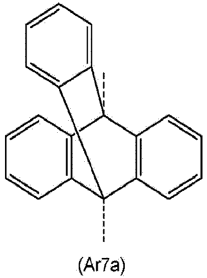 wobei die gestrichelten Bindungen die Verknüpfung der Struktur darstellen.

In einer bevorzugten Ausführungsform der Erfindung ist mindestens eine Gruppe Ar gleich oder verschieden bei jedem Auftreten ausgewählt aus den Strukturen (Ar1) und/oder (Ar2), besonders bevorzugt mindestens zwei Gruppen Ar und ganz besonders bevorzugt mindestens 3 Gruppen Ar. Insbesondere bevorzugt sind alle Gruppen Ar ausgewählt aus den Strukturen (Ar1) und/oder (Ar2). Dabei sind die Strukturen (Ar1) bevorzugt gleich oder verschieden bei jedem Auftreten ausgewählt aus den Strukturen (Ar1a) bis (Ar1d) und die Strukturen (Ar2) aus den Strukturen (Ar2a), besonders bevorzugt den Strukturen (Ar2a-1).

Wenn die Reste R bzw. R¹ in den Strukturen (Ar1) bis (Ar7) bzw. in den oben ausgeführten bevorzugten Strukturen für lineare, verzweigte oder cyclische Alkylgruppen stehen, so haben die Alkylgruppen bevorzugt 1 bis 15 C-Atome, besonders bevorzugt 1 bis 12 C-Atomen und ganz besonders bevorzugt 1 bis 10 C-Atome. Beispiele für geeignete Alkylgruppen als Substituenten R bzw. R¹ in den Strukturen (Ar1) bis (Ar7) bzw. in den bevorzugten Strukturen sind Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Adamantyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl-. Dabei können die Alkylgruppen jeweils auch ein oder mehrere Stereozentren aufweisen, wobei dann sowohl die enantiomeren- oder diastereomerenreinen Strukturen wie auch die entsprechenden Racemate verwendet werden können.

Wie oben beschrieben, steht n für eine ganze Zahl von 3 bis 20 mit der Maßgabe, dass mindestens 5 Phenyl- bzw. Cyclohexangruppen linear miteinander verknüpft sind. In einer bevorzugten Ausführungsform der Erfindung ist n eine ganze Zahl von 5 bis 20, insbesondere von 5 bis 15. Besonders bevorzugt ist n so gewählt, dass insgesamt 8 bis 24 Phenyl- bzw. Cyclohexangruppen linear miteinander verknüpft sind, besonders bevorzugt 12 bis 24 Phenyl- bzw. Cyclohexangruppen und ganz besonders bevorzugt 15 bis 20 Phenyl- bzw. Cyclohexangruppen. Wie oben beschrieben, tragen dabei die Strukturen (Ar2), (Ar4) und (Ar5) jeweils zwei Phenylgruppen bei.

Nachfolgend werden bevorzugte Ausführungsformen der Phenylpyridin-Teilliganden beschrieben. Wenn die Phenylpyridin-Teilliganden in Formel (1) mit einem oder mehreren Resten R substituiert sind, dann sind diese Substituenten bevorzugt so gebunden, wie in der folgenden Formel (2) dargestellt, 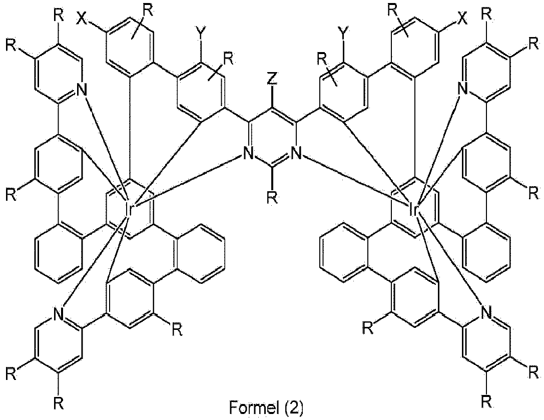 wobei die verwendeten Symbole die oben aufgeführten Bedeutungen aufweisen.

Dieselben bevorzugten Positionen der Reste R an den Phenylpyridin-Teilliganden gelten auch in den bevorzugten Strukturen.

Bevorzugt sind die Strukturen der folgenden Formel (2a), 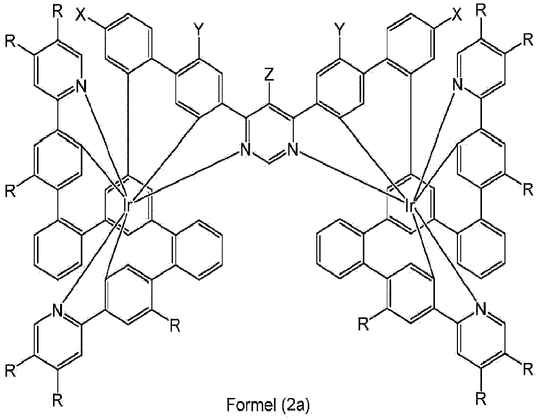 wobei die verwendeten Symbole die oben genannten Bedeutungen aufweisen.

Dabei gilt bevorzugt für die Substituenten an den Phenylpyridinteilliganden, dass jeder der vier Teilliganden gleich substiutiert ist. Weiterhin bevorzugt enthält jeder Phenylpyridinteilligand maximal drei Substituenten R, die ungleich H sind, besonders bevorzugt maximal zwei Substituenten R. Wenn an den Pyridinring zwei Substituenten R ungleich H gebunden sind, so ist bevorzugt mindestens einer der beiden Substituenten eine Alkylgruppe. Besonders bevorzugt steht maximal ein Substituent R am Pyridin für eine Gruppe ungleich H. In einer weiteren bevorzugten Ausführungsform der Erfindung enthält die Phenylgruppe des Phenylpyridin-teilliganden einen Substituenten R, der in para-Position zum Iridium gebunden ist, wobei dieser Substituent R bevorzugt ausgewählt ist aus aromatischen Ringsystemen mit 6 bis 24 aromatischen Ringatomen, bevorzugt mit 6 bis 12 aromatischen Ringatomen, das jeweils mit einem oder mehreren Resten R¹ substituiert sein kann, wobei R¹ bevorzugt ausgewählt ist aus linearen Alkylgruppen mit 1 bis 10 C-Atomen oder verzweigten oder cyclischen Alkylgruppen mit 3 bis 10 C-Atomen, wobei R insbesondere für eine unsubstituierte Phenylgruppe steht. In einer weiteren bevorzugten Ausführungsform der Erfindung enthält die Pyridingruppe des Phenylpyridinteilliganden einen Substituenten R, der in para-Position zum Stickstoffatom gebunden ist, wobei dieser Substituent R bevorzugt ausgewählt ist aus einer linearen Alkylgruppe mit 1 bis 10 C-Atomen oder einer verzweigten oder cyclischen Alkylgruppe mit 3 bis 10 C-Atomen, insbesondere einer Methylgruppe.

Die Reste R an den Phenylpyridin-Teilliganden in Formel (1) bzw. den bevorzugten Ausführungsformen sind bevorzugt bei jedem Auftreten gleich oder verschieden ausgewählt aus der Gruppe bestehend aus H, D, F, OR¹, CN, einer geradkettigen Alkylgruppe mit 1 bis 10 C-Atomen oder einer verzweigten oder cyclischen Alkylgruppe mit 3 bis 10 C-Atomen, wobei die Alkylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Reste R auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, OR¹, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, bevorzugt mit 6 bis 13 aromatischen Ringatomen, das jeweils durch einen oder mehrere Reste R¹ substituiert sein kann; dabei können zwei benachbarte Reste R auch miteinander ein mono- oder polycyclisches, aliphatisches oder aromatisches Ringsystem bilden. Besonders bevorzugte aromatische Ringsysteme sind Phenyl, welches auch durch ein oder zwei Alkylgruppen mit jeweils 1 bis 6 C-Atomen substituiert sein kann, oder Biphenyl.

Bevorzugte Reste R¹, die an R gebunden sind, sind bei jedem Auftreten gleich oder verschieden H, D, F, CN, eine geradkettige Alkylgruppe mit 1 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind innerhalb des Umfangs der Ansprüche beliebig miteinander kombinierbar. In einer besonders bevorzugten Ausführungsform der Erfindung gelten die oben genannten bevorzugten Ausführungsformen gleichzeitig.

Bei den erfindungsgemäßen Verbindungen handelt es sich um chirale Strukturen. Je nach genauer Struktur der Komplexe und Liganden ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere. Die Diastereomerenpaare können mit herkömmlichen Methoden, z. B. chromatographisch oder durch fraktionierte Kristallisation, getrennt werden. Die Racemattrennung kann via fraktionierter Kristallisation von diastereomeren Salzpaaren oder an chiralen Säulen nach üblichen Methoden erfolgen.

Nachfolgend werden Beispiele für geeignete erfindungsgemäße Verbindungen aufgeführt. In diesen Beispielstrukturen weisen die Gruppen X die folgende allgemeine Struktur auf:

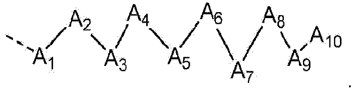

Dabei sind die nachfolgend aufgeführten Strukturen 1 bis 34 geeignete Strukturen für A₁ bis A₁₀. Dabei bindet A₁ über die gestrichelte Bindung an den Metallkomplex, und in den Strukturen in der nachfolgenden Tabelle besitzt die letzte Aₙ-Gruppe ein Wasserstoffatom anstelle der gestrichelten Bindung. Asymmetrische Gruppen (die Gruppen 3, 4, 6, 9, 10 und 18) können über jede der beiden gestrichelten Linien mit der vorherigen Gruppe verknüpft werden. Zur besseren Übersicht wurde in diesen Fällen nur eine isomere Form angegeben.

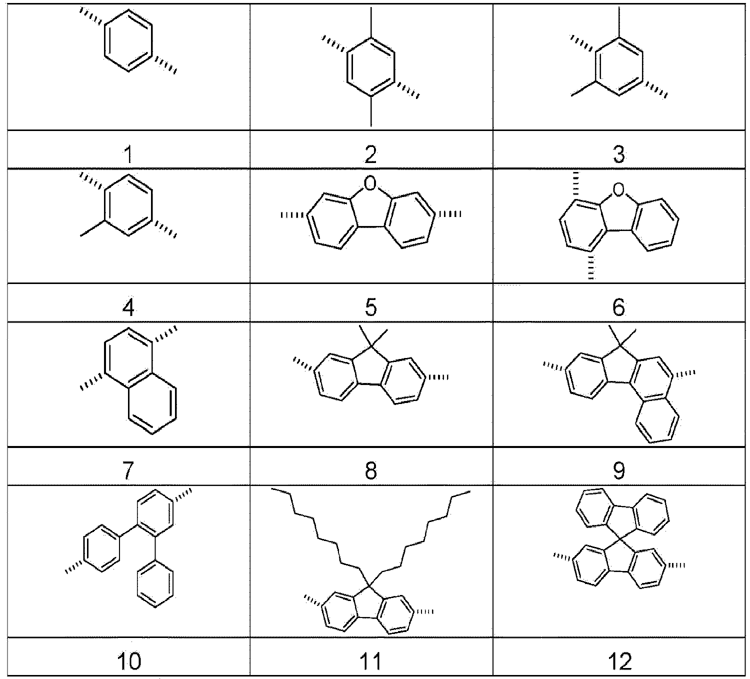

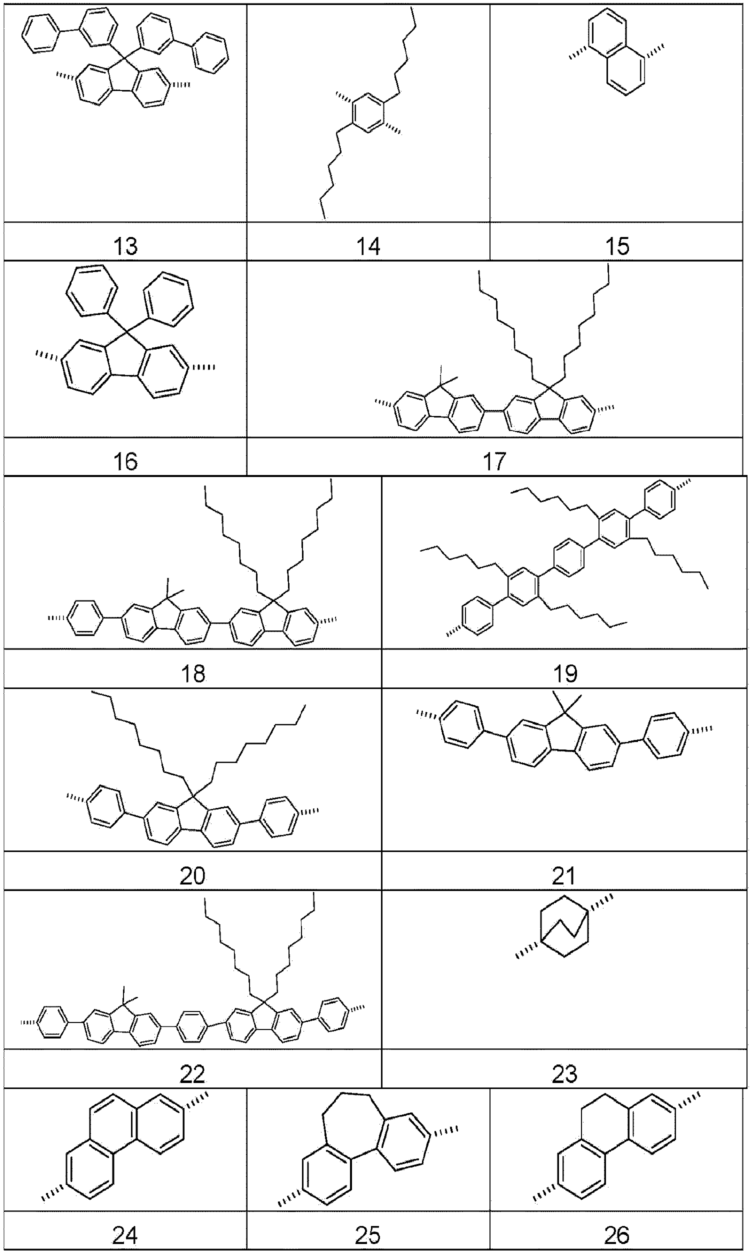

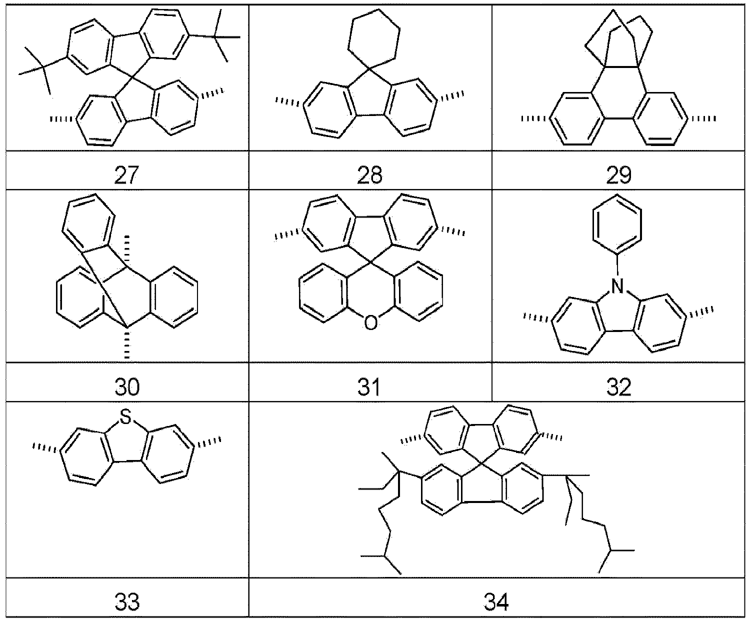

Aus den oben aufgeführten Strukturen 1 bis 34 lassen sich die in der folgenden Tabelle dargestellten geeigneten Gruppen X konstruieren:

| ***X*** | ***A1*** | ***A2*** | ***A3*** | ***A4*** | ***A5*** | ***A6*** | ***A7*** | ***A8*** | ***A9*** | ***A10*** |
|---|---|---|---|---|---|---|---|---|---|---|
| ***1*** | 1 | 17 | 18 | 18 | - | - | - | - | - | - |
| ***2*** | 2 | 17 | 18 | 18 | - | - | - | - | - | - |
| ***3*** | 3 | 17 | 18 | 18 | - | - | - | - | - | - |
| ***4*** | 4 | 17 | 18 | 18 | - | - | - | - | - | - |
| ***5*** | 5 | 17 | 18 | 18 | - | - | - | - | - | - |
| ***6*** | 6 | 17 | 18 | 18 | - | - | - | - | - | - |
| ***7*** | 7 | 17 | 18 | 18 | - | - | - | - | - | - |
| ***8*** | 10 | 17 | 18 | 18 | - | - | - | - | - | - |
| ***9*** | 14 | 17 | 18 | 18 | - | - | - | - | - | - |
| ***10*** | 15 | 17 | 18 | 18 | - | - | - | - | - | - |
| ***11*** | 19 | 17 | 18 | 18 | - | - | - | - | - | - |
| ***11*** | 20 | 17 | 18 | 18 | - | - | - | - | - | - |
| ***13*** | 21 | 17 | 18 | 18 | - | - | - | - | - | - |
| ***14*** | 22 | 17 | 18 | 18 | - | - | - | - | - | - |
| ***15*** | 23 | 17 | 18 | 18 | - | - | - | - | - | - |
| ***16*** | 24 | 17 | 18 | 18 | - | - | - | - | - | - |
| ***17*** | 25 | 17 | 18 | 18 | - | - | - | - | - | - |
| ***18*** | 26 | 17 | 18 | 18 | - | - | - | - | - | - |
| ***19*** | 27 | 17 | 18 | 18 | - | - | - | - | - | - |
| ***20*** | 1 | 17 | 18 | 18 | 18 | - | - | - | - | - |
| ***21*** | 2 | 17 | 18 | 18 | 18 | - | - | - | - | - |
| ***22*** | 3 | 17 | 18 | 18 | 18 | - | - | - | - | - |
| ***23*** | 4 | 17 | 18 | 18 | 18 | - | - | - | - | - |
| ***24*** | 5 | 17 | 18 | 18 | 18 | - | - | - | - | - |
| ***25*** | 6 | 17 | 18 | 18 | 18 | - | - | - | - | - |
| ***26*** | 7 | 17 | 18 | 18 | 18 | - | - | - | - | - |
| ***27*** | 10 | 17 | 18 | 18 | 18 | - | - | - | - | - |
| ***28*** | 14 | 17 | 18 | 18 | 18 | - | - | - | - | - |
| ***29*** | 15 | 17 | 18 | 18 | 18 | - | - | - | - | - |
| ***30*** | 19 | 17 | 18 | 18 | 18 | - | - | - | - | - |
| ***31*** | 20 | 17 | 18 | 18 | 18 | - | - | - | - | - |
| ***32*** | 21 | 17 | 18 | 18 | 18 | - | - | - | - | - |
| ***33*** | 22 | 17 | 18 | 18 | 18 | - | - | - | - | - |
| ***34*** | 23 | 17 | 18 | 18 | 18 | - | - | - | - | - |
| ***35*** | 24 | 17 | 18 | 18 | 18 | - | - | - | - | - |
| ***36*** | 25 | 17 | 18 | 18 | 18 | - | - | - | - | - |
| ***37*** | 26 | 17 | 18 | 18 | 18 | - | - | - | - | - |
| ***38*** | 27 | 17 | 18 | 18 | 18 | - | - | - | - | - |
| ***39*** | 1 | 4 | 1 | 8 | 1 | 8 | 18 | - | - | - |
| ***40*** | 2 | 4 | 1 | 8 | 1 | 8 | 18 | - | - | - |
| ***41*** | 3 | 4 | 1 | 8 | 1 | 8 | 18 | - | - | - |
| ***42*** | 4 | 4 | 1 | 8 | 1 | 8 | 18 | - | - | - |
| ***43*** | 5 | 4 | 1 | 8 | 1 | 8 | 18 | - | - | - |
| ***44*** | 6 | 4 | 1 | 8 | 1 | 8 | 18 | - | - | - |
| ***45*** | 7 | 4 | 1 | 8 | 1 | 8 | 18 | - | - | - |
| ***46*** | 10 | 4 | 1 | 8 | 1 | 8 | 18 | - | - | - |
| ***47*** | 14 | 4 | 1 | 8 | 1 | 8 | 18 | - | - | - |
| ***48*** | 15 | 4 | 1 | 8 | 1 | 8 | 18 | - | - | - |
| ***49*** | 19 | 4 | 1 | 8 | 1 | 8 | 18 | - | - | - |
| ***50*** | 20 | 4 | 1 | 8 | 1 | 8 | 18 | - | - | - |
| ***51*** | 21 | 4 | 1 | 8 | 1 | 8 | 18 | - | - | - |
| ***52*** | 22 | 4 | 1 | 8 | 1 | 8 | 18 | - | - | - |
| ***53*** | 23 | 4 | 1 | 8 | 1 | 8 | 18 | - | - | - |
| ***54*** | 24 | 4 | 1 | 8 | 1 | 8 | 18 | - | - | - |
| ***55*** | 25 | 4 | 1 | 8 | 1 | 8 | 18 | - | - | - |
| ***56*** | 26 | 4 | 1 | 8 | 1 | 8 | 18 | - | - | - |
| ***57*** | 27 | 4 | 1 | 8 | 1 | 8 | 18 | - | - | - |
| ***58*** | 1 | 1 | 13 | 1 | 21 | 13 | 21 | 13 | - | - |
| ***59*** | 1 | 2 | 13 | 1 | 21 | 13 | 21 | 13 | - | - |
| ***60*** | 1 | 3 | 13 | 1 | 21 | 13 | 21 | 13 | - | - |
| ***61*** | 1 | 4 | 13 | 1 | 21 | 13 | 21 | 13 | - | - |
| ***62*** | 1 | 6 | 13 | 1 | 21 | 13 | 21 | 13 | - | - |
| ***63*** | 1 | 7 | 13 | 1 | 21 | 13 | 21 | 13 | - | - |
| ***64*** | 1 | 9 | 13 | 1 | 21 | 13 | 21 | 13 | - | - |
| ***65*** | 1 | 23 | 1 | 21 | 22 | 16 | - | - | - | - |
| ***66*** | 1 | 24 | 1 | 21 | 22 | 16 | - | - | - | - |
| ***67*** | 1 | 25 | 1 | 21 | 22 | 16 | - | - | - | - |
| ***68*** | 1 | 26 | 1 | 21 | 22 | 16 | - | - | - | - |
| ***69*** | 1 | 27 | 1 | 21 | 22 | 16 | - | - | - | - |
| ***70*** | 4 | 13 | 14 | 13 | 14 | 13 | 14 | 13 | 14 | 13 |
| ***71*** | 4 | 13 | 1 | 13 | 1 | 13 | 1 | 13 | 1 | 13 |
| ***72*** | 4 | 13 | 2 | 13 | 2 | 13 | 2 | 13 | 2 | 13 |
| ***73*** | 4 | 13 | 4 | 13 | 4 | 13 | 4 | 13 | 4 | 13 |
| ***74*** | 4 | 13 | 7 | 13 | 7 | 13 | 7 | 13 | 7 | 13 |
| ***75*** | 4 | 13 | 23 | 13 | 23 | 13 | 23 | 13 | 23 | 13 |
| ***76*** | 4 | 13 | 26 | 13 | 26 | 13 | 26 | 13 | 26 | 13 |
| ***77*** | 1 | 13 | 14 | 13 | 14 | 13 | 14 | 13 | 14 | 13 |
| ***78*** | 1 | 13 | 1 | 13 | 1 | 13 | 1 | 13 | 1 | 13 |
| ***79*** | 1 | 13 | 2 | 13 | 2 | 13 | 2 | 13 | 2 | 13 |
| ***80*** | 1 | 13 | 4 | 13 | 4 | 13 | 4 | 13 | 4 | 13 |
| ***81*** | 1 | 13 | 7 | 13 | 7 | 13 | 7 | 13 | 7 | 13 |
| ***82*** | 1 | 13 | 23 | 13 | 23 | 13 | 23 | 13 | 23 | 13 |
| ***83*** | 1 | 13 | 26 | 13 | 26 | 13 | 26 | 13 | 26 | 13 |
| ***84*** | 4 | 27 | 14 | 27 | 14 | 27 | 14 | 27 | 14 | 27 |
| ***85*** | 4 | 27 | 1 | 27 | 1 | 27 | 1 | 27 | 1 | 27 |
| ***86*** | 4 | 27 | 2 | 27 | 2 | 27 | 2 | 27 | 2 | 27 |
| ***87*** | 4 | 27 | 4 | 27 | 4 | 27 | 4 | 27 | 4 | 27 |
| ***88*** | 4 | 27 | 7 | 27 | 7 | 27 | 7 | 27 | 7 | 27 |
| ***89*** | 4 | 27 | 23 | 27 | 23 | 27 | 23 | 27 | 23 | 27 |
| ***90*** | 4 | 27 | 26 | 27 | 26 | 27 | 26 | 27 | 26 | 27 |
| ***91*** | 1 | 27 | 14 | 27 | 14 | 27 | 14 | 27 | 14 | 27 |
| ***92*** | 1 | 27 | 1 | 27 | 1 | 27 | 1 | 27 | 1 | 27 |
| ***93*** | 1 | 27 | 2 | 27 | 2 | 27 | 2 | 27 | 2 | 27 |
| ***94*** | 1 | 27 | 4 | 27 | 4 | 27 | 4 | 27 | 4 | 27 |
| ***95*** | 1 | 27 | 7 | 27 | 7 | 27 | 7 | 27 | 7 | 27 |
| ***96*** | 1 | 27 | 23 | 27 | 23 | 27 | 23 | 27 | 23 | 27 |
| ***97*** | 1 | 27 | 26 | 27 | 26 | 27 | 26 | 27 | 26 | 27 |
| ***98*** | 4 | 11 | 14 | 11 | 14 | 11 | 14 | 11 | 14 | 11 |
| ***99*** | 4 | 11 | 1 | 11 | 1 | 11 | 1 | 11 | 1 | 11 |
| ***100*** | 4 | 11 | 2 | 11 | 2 | 11 | 2 | 11 | 2 | 11 |
| ***101*** | 4 | 11 | 4 | 11 | 4 | 11 | 4 | 11 | 4 | 11 |
| ***102*** | 4 | 11 | 7 | 11 | 7 | 11 | 7 | 11 | 7 | 11 |
| ***103*** | 4 | 11 | 23 | 11 | 23 | 11 | 23 | 11 | 23 | 11 |
| ***104*** | 4 | 11 | 26 | 11 | 26 | 11 | 26 | 11 | 26 | 11 |
| ***105*** | 1 | 11 | 14 | 11 | 14 | 11 | 14 | 11 | 14 | 11 |
| ***106*** | 1 | 11 | 1 | 11 | 1 | 11 | 1 | 11 | 1 | 11 |
| ***107*** | 1 | 11 | 2 | 11 | 2 | 11 | 2 | 11 | 2 | 11 |
| ***108*** | 1 | 11 | 4 | 11 | 4 | 11 | 4 | 11 | 4 | 11 |
| ***109*** | 1 | 11 | 7 | 11 | 7 | 11 | 7 | 11 | 7 | 11 |
| ***110*** | 1 | 11 | 23 | 11 | 23 | 11 | 23 | 11 | 23 | 11 |
| ***111*** | 1 | 11 | 26 | 11 | 26 | 11 | 26 | 11 | 26 | 11 |
| ***112*** | 1 | 17 | 1 | 18 | 18 | - | - | - | - | - |
| ***113*** | 2 | 17 | 2 | 18 | 18 | - | - | - | - | - |
| ***114*** | 3 | 17 | 3 | 18 | 18 | - | - | - | - | - |
| ***115*** | 4 | 17 | 4 | 18 | 18 | - | - | - | - | - |
| ***116*** | 5 | 17 | 5 | 18 | 18 | - | - | - | - | - |
| ***117*** | 6 | 17 | 6 | 18 | 18 | - | - | - | - | - |
| ***118*** | 7 | 17 | 7 | 18 | 18 | - | - | - | - | - |
| ***119*** | 10 | 17 | 10 | 18 | 18 | - | - | - | - | - |
| ***120*** | 14 | 17 | 14 | 18 | 18 | - | - | - | - | - |
| ***121*** | 15 | 17 | 15 | 18 | 18 | - | - | - | - | - |
| ***122*** | 19 | 17 | 19 | 18 | 18 | - | - | - | - | - |
| ***123*** | 20 | 17 | 20 | 18 | 18 | - | - | - | - | - |
| ***124*** | 21 | 17 | 21 | 18 | 18 | - | - | - | - | - |
| ***125*** | 22 | 17 | 22 | 18 | 18 | - | - | - | - | - |
| ***126*** | 23 | 17 | 23 | 18 | 18 | - | - | - | - | - |
| ***127*** | 24 | 17 | 24 | 18 | 18 | - | - | - | - | - |
| ***128*** | 25 | 17 | 25 | 18 | 18 | - | - | - | - | - |
| ***129*** | 26 | 17 | 26 | 18 | 18 | - | - | - | - | - |
| ***130*** | 27 | 17 | 27 | 18 | 18 | - | - | - | - | - |
| ***131*** | 1 | 21 | 18 | 18 | - | - | - | - | - | - |
| ***132*** | 2 | 21 | 18 | 18 | - | - | - | - | - | - |
| ***133*** | 3 | 21 | 18 | 18 | - | - | - | - | - | - |
| ***134*** | 4 | 21 | 18 | 18 | - | - | - | - | - | - |
| ***135*** | 5 | 21 | 18 | 18 | - | - | - | - | - | - |
| ***136*** | 6 | 21 | 18 | 18 | - | - | - | - | - | - |
| ***137*** | 7 | 21 | 18 | 18 | - | - | - | - | - | - |
| ***138*** | 10 | 21 | 18 | 18 | - | - | - | - | - | - |
| ***139*** | 14 | 21 | 18 | 18 | - | - | - | - | - | - |
| ***140*** | 15 | 21 | 18 | 18 | - | - | - | - | - | - |
| ***141*** | 19 | 21 | 18 | 18 | - | - | - | - | - | - |
| ***142*** | 20 | 21 | 18 | 18 | - | - | - | - | - | - |
| ***143*** | 21 | 21 | 18 | 18 | - | - | - | - | - | - |
| ***144*** | 22 | 21 | 18 | 18 | - | - | - | - | - | - |
| ***145*** | 23 | 21 | 18 | 18 | - | - | - | - | - | - |
| ***146*** | 24 | 21 | 18 | 18 | - | - | - | - | - | - |
| ***147*** | 25 | 21 | 18 | 18 | - | - | - | - | - | - |
| ***148*** | 26 | 21 | 18 | 18 | - | - | - | - | - | - |
| ***149*** | 27 | 21 | 18 | 18 | - | - | - | - | - | - |
| ***150*** | 1 | 22 | 18 | 18 | - | - | - | - | - | - |
| ***151*** | 2 | 22 | 18 | 18 | - | - | - | - | - | - |
| ***152*** | 3 | 22 | 18 | 18 | - | - | - | - | - | - |
| ***153*** | 4 | 22 | 18 | 18 | - | - | - | - | - | - |
| ***154*** | 5 | 22 | 18 | 18 | - | - | - | - | - | - |
| ***155*** | 6 | 22 | 18 | 18 | - | - | - | - | - | - |
| ***156*** | 7 | 22 | 18 | 18 | - | - | - | - | - | - |
| ***157*** | 10 | 22 | 18 | 18 | - | - | - | - | - | - |
| ***158*** | 14 | 22 | 18 | 18 | - | - | - | - | - | - |
| ***159*** | 15 | 22 | 18 | 18 | - | - | - | - | - | - |
| ***160*** | 19 | 22 | 18 | 18 | - | - | - | - | - | - |
| ***161*** | 20 | 22 | 18 | 18 | - | - | - | - | - | - |
| ***162*** | 21 | 22 | 18 | 18 | - | - | - | - | - | - |
| ***163*** | 22 | 22 | 18 | 18 | - | - | - | - | - | - |
| ***164*** | 23 | 22 | 18 | 18 | - | - | - | - | - | - |
| ***165*** | 24 | 22 | 18 | 18 | - | - | - | - | - | - |
| ***166*** | 25 | 22 | 18 | 18 | - | - | - | - | - | - |
| ***167*** | 26 | 22 | 18 | 18 | - | - | - | - | - | - |
| ***168*** | 27 | 22 | 18 | 18 | - | - | - | - | - | - |
| ***169*** | 18 | 1 | 18 | 18 | - | - | - | - | - | - |
| ***170*** | 18 | 2 | 18 | 18 | - | - | - | - | - | - |
| ***171*** | 18 | 3 | 18 | 18 | - | - | - | - | - | - |
| ***172*** | 18 | 4 | 18 | 18 | - | - | - | - | - | - |
| ***173*** | 18 | 5 | 18 | 18 | - | - | - | - | - | - |
| ***174*** | 18 | 6 | 18 | 18 | - | - | - | - | - | - |
| ***175*** | 18 | 7 | 18 | 18 | - | - | - | - | - | - |
| ***176*** | 18 | 10 | 18 | 18 | - | - | - | - | - | - |
| ***177*** | 18 | 14 | 18 | 18 | - | - | - | - | - | - |
| ***178*** | 18 | 15 | 18 | 18 | - | - | - | - | - | - |
| ***179*** | 18 | 19 | 18 | 18 | - | - | - | - | - | - |
| ***180*** | 18 | 20 | 18 | 18 | - | - | - | - | - | - |
| ***181*** | 18 | 21 | 18 | 18 | - | - | - | - | - | - |
| **182** | 18 | 22 | 18 | 18 | - | - | - | - | - | - |
| ***183*** | 18 | 23 | 18 | 18 | - | - | - | - | - | - |
| ***184*** | 18 | 24 | 18 | 18 | - | - | - | - | - | - |
| ***185*** | 18 | 25 | 18 | 18 | - | - | - | - | - | - |
| ***186*** | 18 | 26 | 18 | 18 | - | - | - | - | - | - |
| ***187*** | 18 | 27 | 18 | 18 | - | - | - | - | - | - |
| ***188*** | 18 | 28 | 18 | 18 | - | - | - | - | - | - |
| ***189*** | 18 | 29 | 18 | 18 | - | - | - | - | - | - |
| ***190*** | 18 | 30 | 18 | 18 | - | - | - | - | - | - |
| ***191*** | 18 | 31 | 18 | 18 | - | - | - | - | - | - |
| ***192*** | 18 | 32 | 18 | 18 | - | - | - | - | - | - |
| ***193*** | 18 | 33 | 18 | 18 | - | - | - | - | - | - |
| ***194*** | 18 | 34 | 18 | 18 | - | - | - | - | - | - |
| ***195*** | 28 | 28 | 18 | 18 | - | - | - | - | - | - |
| ***196*** | 29 | 29 | 18 | 18 | - | - | - | - | - | - |
| ***197*** | 30 | 30 | 18 | 18 | - | - | - | - | - | - |
| ***198*** | 31 | 31 | 18 | 18 | - | - | - | - | - | - |
| ***199*** | 32 | 32 | 18 | 18 | - | - | - | - | - | - |
| ***200*** | 33 | 33 | 18 | 18 | - | - | - | - | - | - |
| ***201*** | 34 | 34 | 18 | 18 | - | - | - | - | - | - |
| ***202*** | 1 | 28 | 1 | 28 | 11 | 28 | - | - | - | - |
| ***203*** | 1 | 29 | 1 | 29 | 11 | 29 | - | - | - | - |
| ***204*** | 1 | 30 | 1 | 30 | 11 | 30 | - | - | - | - |
| ***205*** | 1 | 31 | 1 | 31 | 11 | 31 | - | - | - | - |
| ***206*** | 1 | 32 | 1 | 32 | 11 | 32 | - | - | - | - |
| ***207*** | 1 | 33 | 1 | 33 | 11 | 33 | - | - | - | - |
| ***208*** | 1 | 34 | 1 | 34 | 11 | 34 | - | - | - | - |
| ***209*** | 1 | 8 | 1 | 8 | 1 | - | - | - | - | - |
| ***210*** | 2 | 8 | 2 | 8 | 2 | - | - | - | - | - |
| ***211*** | 3 | 8 | 3 | 8 | 3 | - | - | - | - | - |
| ***212*** | 4 | 8 | 4 | 8 | 4 | - | - | - | - | - |
| ***213*** | 5 | 8 | 5 | 8 | 5 | - | - | - | - | - |
| ***214*** | 6 | 8 | 6 | 8 | 6 | - | - | - | - | - |
| ***215*** | 7 | 8 | 7 | 8 | 7 | - | - | - | - | - |
| ***216*** | 8 | 8 | 8 | 8 | 8 | - | - | - | - | - |
| ***217*** | 9 | 8 | 9 | 8 | 9 | - | - | - | - | - |
| ***218*** | 10 | 8 | 10 | 8 | 10 | - | - | - | - | - |
| ***219*** | 11 | 8 | 11 | 8 | 11 | - | - | - | - | - |
| ***220*** | 12 | 8 | 12 | 8 | 12 | - | - | - | - | - |
| ***221*** | 13 | 8 | 13 | 8 | 13 | - | - | - | - | - |
| ***222*** | 14 | 8 | 14 | 8 | 14 | - | - | - | - | - |
| ***223*** | 15 | 8 | 15 | 8 | 15 | - | - | - | - | - |
| ***224*** | 16 | 8 | 16 | 8 | 16 | - | - | - | - | - |
| ***225*** | 1 | 8 | 1 | 8 | 1 | 8 | - | - | - | - |
| ***226*** | 2 | 8 | 2 | 8 | 2 | 8 | - | - | - | - |
| ***227*** | 3 | 8 | 3 | 8 | 3 | 8 | - | - | - | - |
| ***228*** | 4 | 8 | 4 | 8 | 4 | 8 | - | - | - | - |
| ***229*** | 5 | 8 | 5 | 8 | 5 | 8 | - | - | - | - |
| ***230*** | 6 | 8 | 6 | 8 | 6 | 8 | - | - | - | - |
| ***231*** | 7 | 8 | 7 | 8 | 7 | 8 | - | - | - | - |
| ***232*** | 8 | 8 | 8 | 8 | 8 | 8 | - | - | - | - |
| ***233*** | 9 | 8 | 9 | 8 | 9 | 8 | - | - | - | - |
| ***234*** | 10 | 8 | 10 | 8 | 10 | 8 | - | - | - | - |
| ***235*** | 11 | 8 | 11 | 8 | 11 | 8 | - | - | - | - |
| ***236*** | 12 | 8 | 12 | 8 | 12 | 8 | - | - | - | - |
| ***237*** | 13 | 8 | 13 | 8 | 13 | 8 | - | - | - | - |
| ***238*** | 14 | 8 | 14 | 8 | 14 | 8 | - | - | - | - |
| ***239*** | 15 | 8 | 15 | 8 | 15 | 8 | - | - | - | - |
| ***240*** | 16 | 8 | 16 | 8 | 16 | 8 | - | - | - | - |
| ***241*** | 1 | 8 | 1 | 8 | 1 | 11 | - | - | - | - |
| ***242*** | 2 | 8 | 2 | 8 | 2 | 11 | - | - | - | - |
| ***243*** | 3 | 8 | 3 | 8 | 3 | 11 | - | - | - | - |
| ***244*** | 4 | 8 | 4 | 8 | 4 | 11 | - | - | - | - |
| ***245*** | 5 | 8 | 5 | 8 | 5 | 11 | - | - | - | - |
| ***246*** | 6 | 8 | 6 | 8 | 6 | 11 | - | - | - | - |
| ***247*** | 7 | 8 | 7 | 8 | 7 | 11 | - | - | - | - |
| ***248*** | 8 | 8 | 8 | 8 | 8 | 11 | - | - | - | - |
| ***249*** | 9 | 8 | 9 | 8 | 9 | 11 | - | - | - | - |
| ***250*** | 10 | 8 | 10 | 8 | 10 | 11 | - | - | - | - |
| ***251*** | 11 | 8 | 11 | 8 | 11 | 11 | - | - | - | - |
| ***252*** | 12 | 8 | 12 | 8 | 12 | 11 | - | - | - | - |
| ***253*** | 13 | 8 | 13 | 8 | 13 | 11 | - | - | - | - |
| ***254*** | 14 | 8 | 14 | 8 | 14 | 11 | - | - | - | - |
| ***255*** | 15 | 8 | 15 | 8 | 15 | 11 | - | - | - | - |
| ***256*** | 16 | 8 | 16 | 8 | 16 | 11 | - | - | - | - |
| ***257*** | 1 | 11 | 1 | 11 | 1 | 11 | - | - | - | - |
| ***258*** | 2 | 11 | 2 | 11 | 2 | 11 | - | - | - | - |
| ***259*** | 3 | 11 | 3 | 11 | 3 | 11 | - | - | - | - |
| ***260*** | 4 | 11 | 4 | 11 | 4 | 11 | - | - | - | - |
| ***261*** | 5 | 11 | 5 | 11 | 5 | 11 | - | - | - | - |
| ***262*** | 6 | 11 | 6 | 11 | 6 | 11 | - | - | - | - |
| ***263*** | 7 | 11 | 7 | 11 | 7 | 11 | - | - | - | - |
| ***264*** | 8 | 11 | 8 | 11 | 8 | 11 | - | - | - | - |
| ***265*** | 9 | 11 | 9 | 11 | 9 | 11 | - | - | - | - |
| ***266*** | 10 | 11 | 10 | 11 | 10 | 11 | - | - | - | - |
| ***267*** | 11 | 11 | 11 | 11 | 11 | 11 | - | - | - | - |
| ***268*** | 12 | 11 | 12 | 11 | 12 | 11 | - | - | - | - |
| ***269*** | 13 | 11 | 13 | 11 | 13 | 11 | - | - | - | - |
| ***270*** | 14 | 11 | 14 | 11 | 14 | 11 | - | - | - | - |
| ***271*** | 15 | 11 | 15 | 11 | 15 | 11 | - | - | - | - |
| ***272*** | 16 | 11 | 16 | 11 | 16 | 11 | - | - | - | - |
| ***273*** | 1 | 18 | 1 | 20 | 20 | - | - | - | - | - |
| ***274*** | 1 | 18 | 1 | 20 | 20 | 1 | - | - | - | - |
| ***275*** | 1 | 18 | 1 | 20 | 20 | 2 | - | - | - | - |
| ***276*** | 1 | 18 | 1 | 20 | 20 | 3 | - | - | - | - |
| ***277*** | 1 | 18 | 1 | 20 | 20 | 4 | - | - | - | - |
| ***278*** | 1 | 18 | 1 | 20 | 20 | 5 | - | - | - | - |
| ***279*** | 1 | 18 | 1 | 20 | 20 | 6 | - | - | - | - |
| ***280*** | 1 | 18 | 1 | 20 | 20 | 7 | - | - | - | - |
| ***281*** | 1 | 18 | 1 | 20 | 20 | 8 | - | - | - | - |
| ***282*** | 1 | 18 | 1 | 20 | 20 | 9 | - | - | - | - |
| ***283*** | 1 | 18 | 1 | 20 | 20 | 10 | - | - | - | - |
| ***284*** | 1 | 18 | 1 | 20 | 20 | 11 | - | - | - | - |
| ***285*** | 1 | 18 | 1 | 20 | 20 | 12 | - | - | - | - |

Diese oben aufgeführten Gruppen X können beispielsweise mit den folgenden bimetallischen Komplexen über die gestrichelten Bindungen verknüpft werden:

| | |
|---|---|
| H1 | 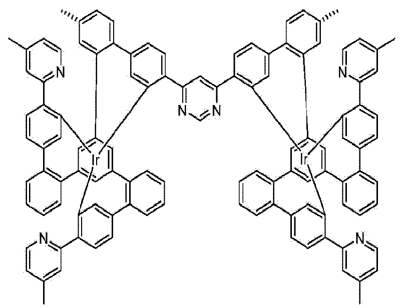 |
| H2 | 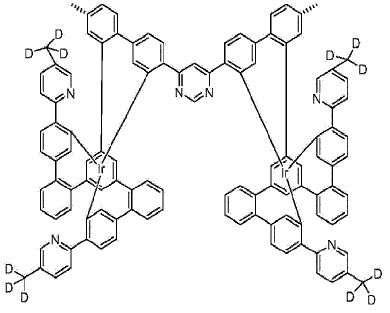 |
| H3 | 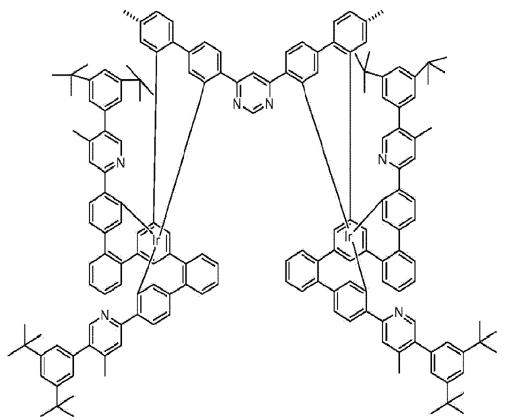 |
| H4 | 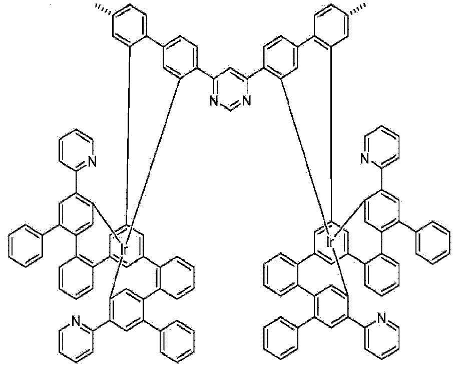 |
| H5 | 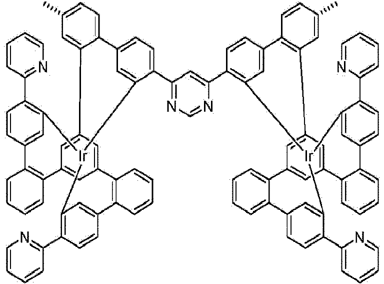 |
| H6 | 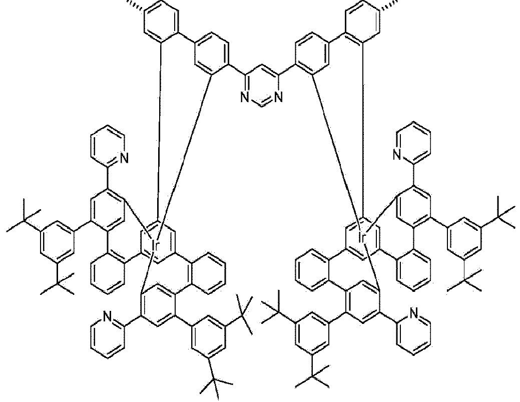 |
| H7 | 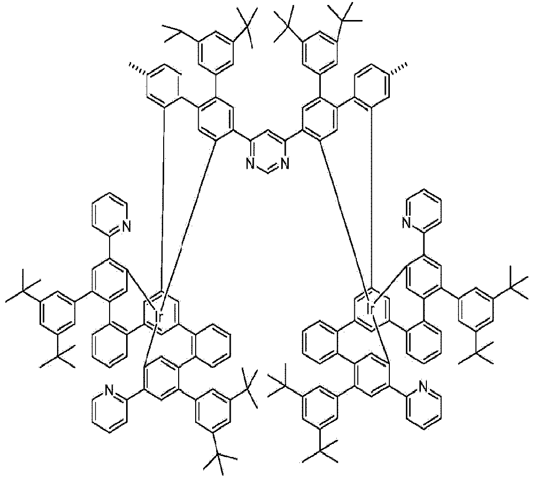 |
| H8 | 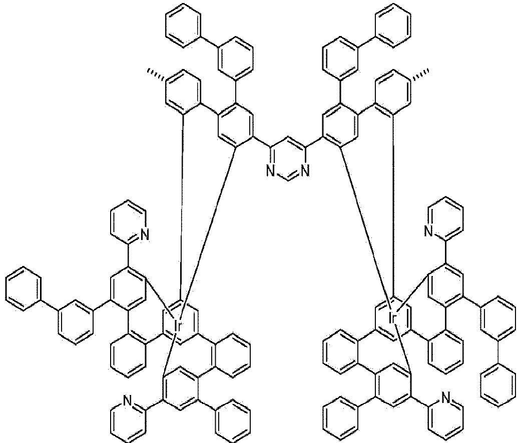 |
| H9 | 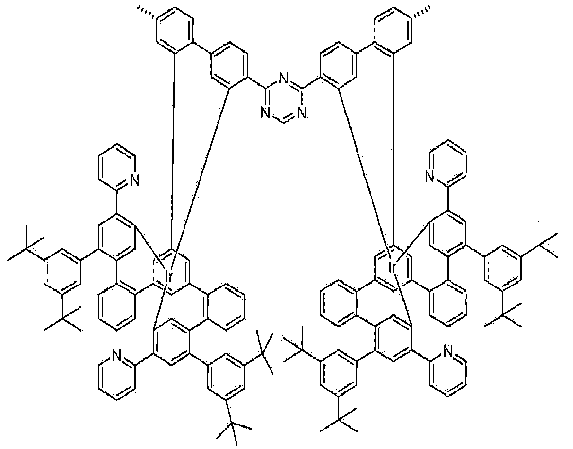 |
| H10 | 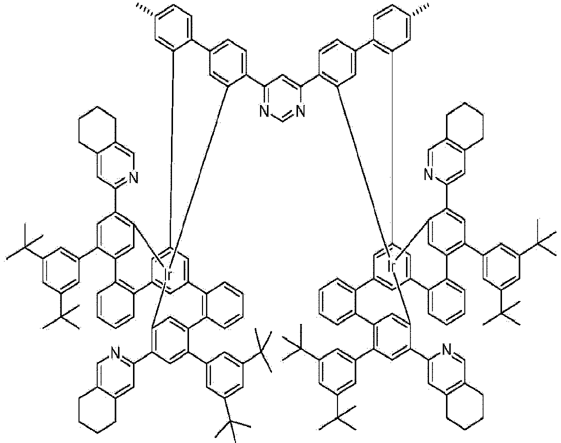 |

H1-H10 in der obigen Tabelle sind jeweils über beide gestrichelten Linien mit den Gruppen X verknüpft. Dabei können alle oben aufgeführten Gruppen X mit jedem der Komplexe H1 bis H10 verknüpft werden. Dies ist exemplarisch für H1 und die Gruppen X1-X285 in der nachfolgenden Tabelle aufgeführt:

| | **H** | **X** | | | **H** | **X** |
|---|---|---|---|---|---|---|
| **1** | H1 | X1 | | **144** | H1 | X144 |
| **2** | H1 | X2 | | **145** | H1 | X145 |
| **3** | H1 | X3 | | **146** | H1 | X146 |
| **4** | H1 | X4 | | **147** | H1 | X147 |
| **5** | H1 | X5 | | **148** | H1 | X148 |
| **6** | H1 | X6 | | **149** | H1 | X149 |
| **7** | H1 | X7 | | **150** | H1 | X150 |
| **8** | H1 | X8 | | **151** | H1 | X151 |
| **9** | H1 | X9 | | **152** | H1 | X152 |
| **10** | H1 | X10 | | **153** | H1 | X153 |
| **11** | H1 | X11 | | **154** | H1 | X154 |
| **12** | H1 | X12 | | **155** | H1 | X155 |
| **13** | H1 | X13 | | **156** | H1 | X156 |
| **14** | H1 | X14 | | **157** | H1 | X157 |
| **15** | H1 | X15 | | **158** | H1 | X158 |
| **16** | H1 | X16 | | **159** | H1 | X159 |
| **17** | H1 | X17 | | **160** | H1 | X160 |
| **18** | H1 | X18 | | **161** | H1 | X161 |
| **19** | H1 | X19 | | **162** | H1 | X162 |
| **20** | H1 | X20 | | **163** | H1 | X163 |
| **21** | H1 | X21 | | **164** | H1 | X164 |
| **22** | H1 | X22 | | **165** | H1 | X165 |
| **23** | H1 | X23 | | **166** | H1 | X166 |
| **24** | H1 | X24 | | **167** | H1 | X167 |
| **25** | H1 | X25 | | **168** | H1 | X168 |
| **26** | H1 | X26 | | **169** | H1 | X169 |
| **27** | H1 | X27 | | **170** | H1 | X170 |
| **28** | H1 | X28 | | **171** | H1 | X171 |
| **29** | H1 | X29 | | **172** | H1 | X172 |
| **30** | H1 | X30 | | **173** | H1 | X173 |
| **31** | H1 | X31 | | **174** | H1 | X174 |
| **32** | H1 | X32 | | **175** | H1 | X175 |
| **33** | H1 | X33 | | **176** | H1 | X176 |
| **34** | H1 | X34 | | **177** | H1 | X177 |
| **35** | H1 | X35 | | **178** | H1 | X178 |
| **36** | H1 | X36 | | **179** | H1 | X179 |
| **37** | H1 | X37 | | **180** | H1 | X180 |
| **38** | H1 | X38 | | **181** | H1 | X181 |
| **39** | H1 | X39 | | **182** | H1 | X182 |
| **40** | H1 | X40 | | **183** | H1 | X183 |
| **41** | H1 | X41 | | **184** | H1 | X184 |
| **42** | H1 | X42 | | **185** | H1 | X185 |
| **43** | H1 | X43 | | **186** | H1 | X186 |
| **44** | H1 | X44 | | **187** | H1 | X187 |
| **45** | H1 | X45 | | **188** | H1 | X188 |
| **46** | H1 | X46 | | **189** | H1 | X189 |
| **47** | H1 | X47 | | **190** | H1 | X190 |
| **48** | H1 | X48 | | **191** | H1 | X191 |
| **49** | H1 | X49 | | **192** | H1 | X192 |
| **50** | H1 | X50 | | **193** | H1 | X193 |
| **51** | H1 | X51 | | **194** | H1 | X194 |
| **52** | H1 | X52 | | **195** | H1 | X195 |
| **53** | H1 | X53 | | **196** | H1 | X196 |
| **54** | H1 | X54 | | **197** | H1 | X197 |
| **55** | H1 | X55 | | **198** | H1 | X198 |
| **56** | H1 | X56 | | **199** | H1 | X199 |
| **57** | H1 | X57 | | **200** | H1 | X200 |
| **58** | H1 | X58 | | **201** | H1 | X201 |
| **59** | H1 | X59 | | **202** | H1 | X202 |
| **60** | H1 | X60 | | **203** | H1 | X203 |
| **61** | H1 | X61 | | **204** | H1 | X204 |
| **62** | H1 | X62 | | **205** | H1 | X205 |
| **63** | H1 | X63 | | **206** | H1 | X206 |
| **64** | H1 | X64 | | **207** | H1 | X207 |
| **65** | H1 | X65 | | **208** | H1 | X208 |
| **66** | H1 | X66 | | **209** | H1 | X209 |
| **67** | H1 | X67 | | **210** | H1 | X210 |
| **68** | H1 | X68 | | **211** | H1 | X211 |
| **69** | H1 | X69 | | **212** | H1 | X212 |
| **70** | H1 | X70 | | **213** | H1 | X213 |
| **71** | H1 | X71 | | **214** | H1 | X214 |
| **72** | H1 | X72 | | **215** | H1 | X215 |
| **73** | H1 | X73 | | **216** | H1 | X216 |
| **74** | H1 | X74 | | **217** | H1 | X217 |
| **75** | H1 | X75 | | **218** | H1 | X218 |
| **76** | H1 | X76 | | **219** | H1 | X219 |
| **77** | H1 | X77 | | **220** | H1 | X220 |
| **78** | H1 | X78 | | **221** | H1 | X221 |
| **79** | H1 | X79 | | **222** | H1 | X222 |
| **80** | H1 | X80 | | **223** | H1 | X223 |
| **81** | H1 | X81 | | **224** | H1 | X224 |
| **82** | H1 | X82 | | **225** | H1 | X225 |
| **83** | H1 | X83 | | **226** | H1 | X226 |
| **84** | H1 | X84 | | **227** | H1 | X227 |
| **85** | H1 | X85 | | **228** | H1 | X228 |
| **86** | H1 | X86 | | **229** | H1 | X229 |
| **87** | H1 | X87 | | **230** | H1 | X230 |
| **88** | H1 | X88 | | **231** | H1 | X231 |
| **89** | H1 | X89 | | **232** | H1 | X232 |
| **90** | H1 | X90 | | **233** | H1 | X233 |
| **91** | H1 | X91 | | **234** | H1 | X234 |
| **92** | H1 | X92 | | **235** | H1 | X235 |
| **93** | H1 | X93 | | **236** | H1 | X236 |
| **94** | H1 | X94 | | **237** | H1 | X237 |
| **95** | H1 | X95 | | **238** | H1 | X238 |
| **96** | H1 | X96 | | **239** | H1 | X239 |
| **97** | H1 | X97 | | **240** | H1 | X240 |
| **98** | H1 | X98 | | **241** | H1 | X241 |
| **99** | H1 | X99 | | **242** | H1 | X242 |
| **100** | H1 | X100 | | **243** | H1 | X243 |
| **101** | H1 | X101 | | **244** | H1 | X244 |
| **102** | H1 | X102 | | **245** | H1 | X245 |
| **103** | H1 | X103 | | **246** | H1 | X246 |
| **104** | H1 | X104 | | **247** | H1 | X247 |
| **105** | H1 | X105 | | **248** | H1 | X248 |
| **106** | H1 | X106 | | **249** | H1 | X249 |
| **107** | H1 | X107 | | **250** | H1 | X250 |
| **108** | H1 | X108 | | **251** | H1 | X251 |
| **109** | H1 | X109 | | **252** | H1 | X252 |
| **110** | H1 | X110 | | **253** | H1 | X253 |
| **111** | H1 | X111 | | **254** | H1 | X254 |
| **112** | H1 | X112 | | **255** | H1 | X255 |
| **113** | H1 | X113 | | **256** | H1 | X256 |
| **114** | H1 | X114 | | **257** | H1 | X257 |
| **115** | H1 | X115 | | **258** | H1 | X258 |
| **116** | H1 | X116 | | **259** | H1 | X259 |
| **117** | H1 | X117 | | **260** | H1 | X260 |
| **118** | H1 | X118 | | **261** | H1 | X261 |
| **119** | H1 | X119 | | **262** | H1 | X262 |
| **120** | H1 | X120 | | **263** | H1 | X263 |
| **121** | H1 | X121 | | **264** | H1 | X264 |
| **122** | H1 | X122 | | **265** | H1 | X265 |
| **123** | H1 | X123 | | **266** | H1 | X266 |
| **124** | H1 | X124 | | **267** | H1 | X267 |
| **125** | H1 | X125 | | **268** | H1 | X268 |
| **126** | H1 | X126 | | **269** | H1 | X269 |
| **127** | H1 | X127 | | **270** | H1 | X270 |
| **128** | H1 | X128 | | **271** | H1 | X271 |
| **129** | H1 | X129 | | **272** | H1 | X272 |
| **130** | H1 | X130 | | **273** | H1 | X273 |
| **131** | H1 | X131 | | **274** | H1 | X274 |
| **132** | H1 | X132 | | **275** | H1 | X275 |
| **133** | H1 | X133 | | **276** | H1 | X276 |
| **134** | H1 | X134 | | **277** | H1 | X277 |
| **135** | H1 | X135 | | **278** | H1 | X278 |
| **136** | H1 | X136 | | **279** | H1 | X279 |
| **137** | H1 | X137 | | **280** | H1 | X280 |
| **138** | H1 | X138 | | **281** | H1 | X281 |
| **139** | H1 | X139 | | **282** | H1 | X282 |
| **140** | H1 | X140 | | **283** | H1 | X283 |
| **141** | H1 | X141 | | **284** | H1 | X284 |
| **142** | H1 | X142 | | **285** | H1 | X285 |
| **143** | H1 | X143 | | | | |

Die erfindungsgemäßen Komplexe können insbesondere durch den nachfolgend beschriebenen Weg dargestellt werden. Dazu wird der 12-zähnige Ligand dargestellt, welcher statt der Gruppen X und ggf. Y und/oder Z jeweils reaktive Abgangsgruppen enthält, und dann an die Iridiummetalle durch eine ortho-Metallierungsreaktion koordiniert. Alternativ ist es auch möglich, zunächst den Metallkomplex zu synthetisieren, der noch keine reaktive Abgangsgruppen enthält, und die reaktiven Abgangsgruppen dann am Komplex einzuführen. Als reaktive Abgangsgruppen eignen sich beispielsweise Halogen, insbesondere Chlor, Brom oder lod, Triflat, Tosylat oder ein Boronsäurederivat, beispielsweise Boronsäure oder ein Boronsäureester. Die Gruppen X und ggf. Y und/oder Z können dann durch eine Kupplungsreaktion mit einer Verbindung A-(Ar)ₙ-R umgesetzt werden, wobei A für eine reaktive Abgangsgruppe steht, beispielsweise für Halogen, insbesondere Chlor, Brom oder lod, Triflat, Tosylat oder ein Boronsäurederivat, beispielsweise Boronsäure oder ein Boronsäureester. Generell eignen sich hier alle C-C-Kupplungsreaktionen, insbesondere die Suzuki-Kupplung. Derartige Reaktionen sind dem Fachmann bekannt, und er hat keinerlei Schwierigkeiten, diese auf die erfindungsgemäßen Verbindungen anzuwenden.

Daher ist ein weiterer Gegenstand der vorliegenden Erfindung ein Verfahren zur Herstellung der erfindungsgemäßen Verbindung durch Umsetzung einer Verbindung, die statt X und ggf. Y und/oder Z mit reaktiven Abgangsgruppen substituiert ist, mit einer Verbindung A-(Ar)ₙ-R, wobei A für eine reaktive Abgangsgruppe steht. Dabei handelt es sich bei der Umsetzung bevorzugt um eine Suzuki-Kupplung.

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Die Lösemittel sind bevorzugt ausgewählt aus Kohlenwasserstoffen, Alkoholen, Estern, Ethern, Ketonen und Aminen. Geeignete und bevorzugte Lösemittel sind beispielsweise ausgewählt aus Toluol, Anisol, o-, m- oder p-Xylol, Methylbenzoat, Mesitylen, Tetralin, Verartrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 1-Ethylnaphthalin, Decylbenzol, Phenylnaphthalin, Menthyl isovalerat, para-Tolylisobutyrat, Cyclohexyl-hexanoat, Ethyl-para-toluat, Ethyl-ortho-toluat, Ethyl-meta-toluat, Decahydronaphthalin, Ethyl-2-methoxybenzoat, Dibutylanilin, Dicyclohexylketon, Isosorbid-dimethylether, Decahydronaphthalin, 2-Methylbiphenyl, Ethyl-octanoat, Octyl-octanoat, Diethyl-sebacat, 3,3-Dimethylbiphenyl, 1,4-Dimethylnaphthalin, 2,2'-Dimethylbiphenyl, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethyl-benzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis-(3,4-dimethylphenyl)ethan oder Mischungen dieser Lösemittel.

Ein weiterer Gegenstand der vorliegenden Erfindung ist daher eine Formulierung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die oben beschriebene erfindungsgemäße Verbindung bzw. die oben aufgeführten bevorzugten Ausführungsformen können als aktive Komponente in einer elektronischen Vorrichtung verwendet werden. Ein weiterer Gegenstand der vorliegenden Erfindung ist somit die Verwendung einer erfindungsgemäßen Verbindung in einer elektronischen Vorrichtung. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine erfindungsgemäße Verbindung enthält. Dabei sind bevorzugte elektronische Vorrichtungen ausgewählt aus der Gruppe bestehend aus organischen Elektrolumineszenzvorrichtungen (OLEDs, PLEDs), organischen Infrarot-Elektrolumineszenzsensoren, organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen (Grätzel-Zellen) verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens eine erfindungsgemäße Verbindung. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Weiß emittierende organische Elektrolumineszenzvorrichtungen können für Beleuchtungsanwendungen oder mit Farbfilter auch für Vollfarb-Displays verwendet werden. Weiß emittierende OLEDs können auch durch Tandem-OLEDs realisiert werden. Weiterhin können weiß emittierende OLEDs auch dadurch realisiert werden, dass zwei oder mehr Emitter, die Licht in unterschiedlicher Farbe emittieren und von denen mindestens einer eine erfindungsgemäße Verbindung ist, in einer emittierenden Schicht vorliegen, so dass sich das emittierte Licht der einzelnen Emitter zu weißem Licht addiert.

In einer bevorzugten Ausführungsform der Erfindung enthält die organische Elektrolumineszenzvorrichtung die erfindungsgemäße Verbindung als emittierende Verbindung in einer oder mehreren emittierenden Schichten.

Viele der erfindungsgemäßen Verbindungen emittieren Licht im roten Spektralbereich. Es ist aber auch möglich, durch geeignete Wahl der Liganden und Substitutionsmuster, die Emission einerseits bis in den infraroten Bereich zu verschieben und andererseits hypsochrom zu verschieben, bevorzugt in den orange oder gelben Bereich.

Wenn die erfindungsgemäße Verbindung als emittierende Verbindung in einer emittierenden Schicht eingesetzt wird, wird sie bevorzugt in Kombination mit einem oder mehreren Matrixmaterialien eingesetzt, wobei nachfolgend die Begriffe "Matrixmaterial" und "Hostmaterial" synonym verwendet werden. Die Mischung aus der erfindungsgemäßen Verbindung und dem Matrixmaterial enthält zwischen 0.1 und 99 Gew.-%, vorzugsweise zwischen 3 und 90 Gew.-%, besonders bevorzugt zwischen 5 und 40 Gew.-%, insbesondere zwischen 10 und 25 Gew.-% der erfindungsgemäßen Verbindung bezogen auf die Gesamtmischung aus Emitter und Matrixmaterial. Entsprechend enthält die Mischung zwischen 99.9 und 1 Gew.-%, vorzugsweise zwischen 97 und 10 Gew.-%, besonders bevorzugt zwischen 95 und 60 Gew.-%, insbesondere zwischen 90 und 75 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, Carbazolamine oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines Triazin-, Pyrimidin-, Chinazolin- oder Chinoxalinderivats mit einem Triarylaminderivat oder einem Carbazolderivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial (so genannter "wide bandgap host"), welches nicht bzw. nicht in wesentlichem Maße am Ladungstransport beteiligt ist, wie z. B. in WO 2010/108579 oder WO 2016/184540 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Nachfolgend sind Beispiele für Verbindungen abgebildet, die sich als Matrixmaterialien für die erfindungsgemäßen Verbindungen eignen.

Bevorzugte elektronentransportierende Matrixmaterialien sind ausgewählt aus der Gruppe bestehend aus Triazinderivaten, Pyrimidinderivaten, Chinazolinderivaten und Chinoxalinderivaten. Bevorzugte Triazin-, Pyrimidin-, Chinazolin- bzw. Chinoxalinderivate, welche als Mischung zusammen mit den erfindungsgemäßen Verbindungen eingesetzt werden können, sind die Verbindungen der folgenden Formeln (19), (20), (21) und (22), 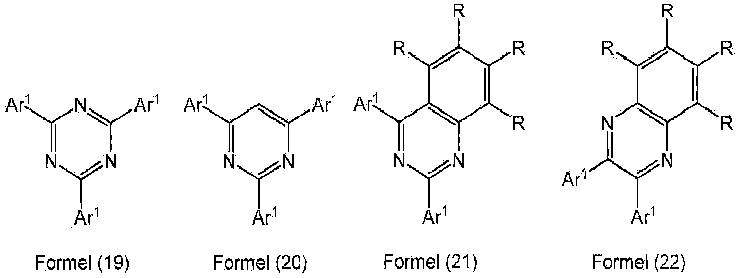 wobei R und R¹ die oben genannten Bedeutungen aufweisen und Ar¹ gleich oder verschieden bei jedem Auftreten für ein aromatisches oder heteroaromatisches Ringsystem mit 5 bis 40 aromatischen Ringatomen, das jeweils durch einen oder mehrere Reste R¹ substituiert sein kann.

Besonders bevorzugt sind die Triazinderivate der Formel (19) und die Chinazolinderivate der Formel (21), insbesondere die Triazinderivate der Formel (19).

In einer bevorzugten Ausführungsform der Erfindung ist Ar¹ in den Formeln (19) bis (22) bei jedem Auftreten gleich oder verschieden ein aromatisches oder heteroaromatisches Ringsystem mit 6 bis 30 aromatischen Ringatomen, insbesondere mit 6 bis 24 aromatischen Ringatomen, das durch einen oder mehrere Reste R¹ substituiert sein kann.

Beispiele für geeignete Triazinverbindungen, welche als Matrixmaterialien zusammen mit den erfindungsgemäßen Verbindungen eingesetzt werden können, sind die in der folgenden Tabelle abgebildeten Verbindungen.

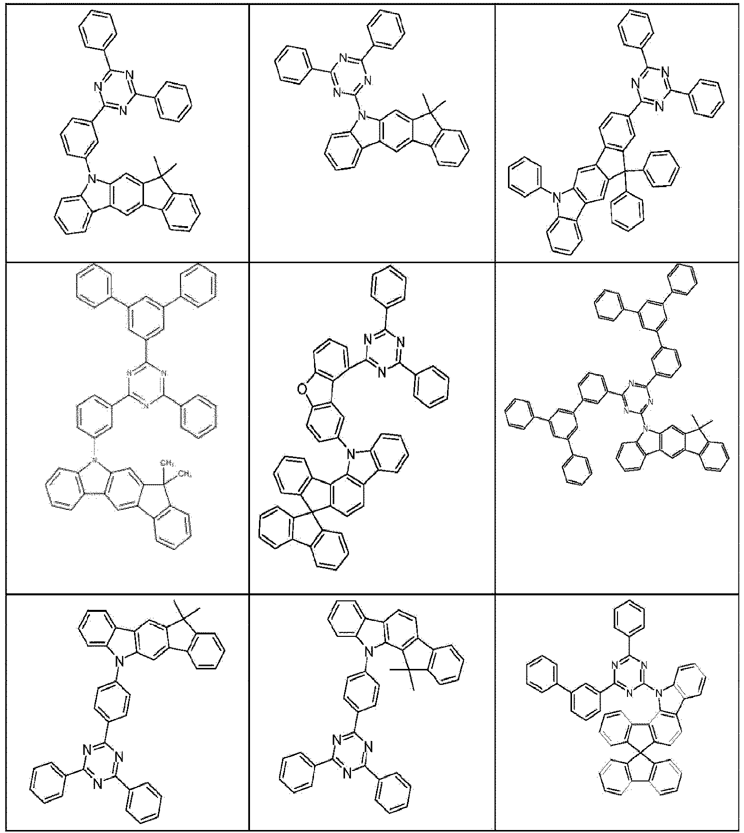

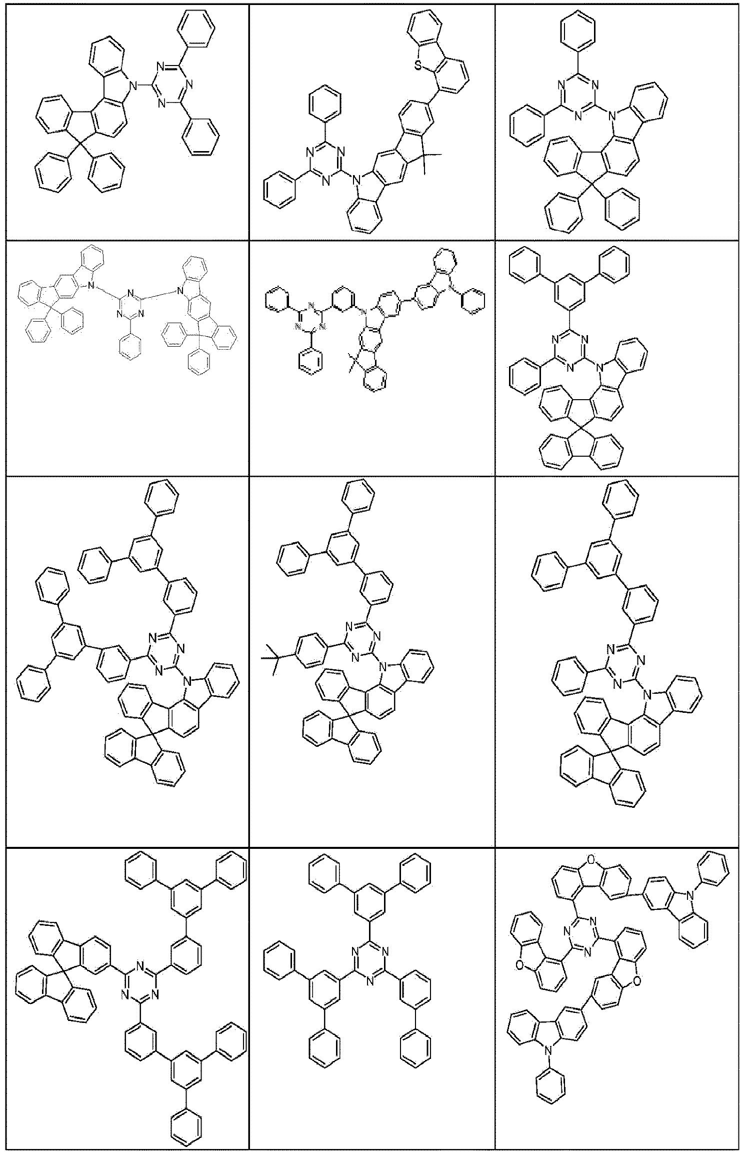

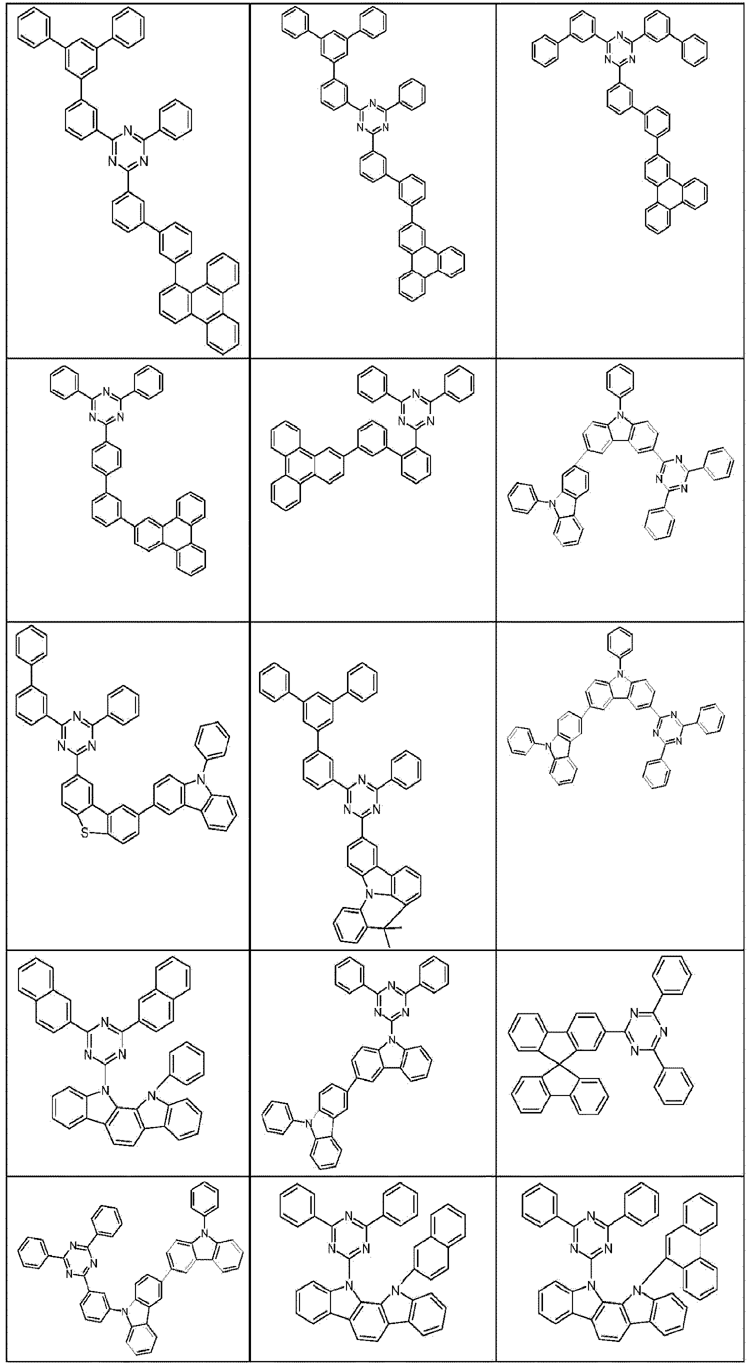

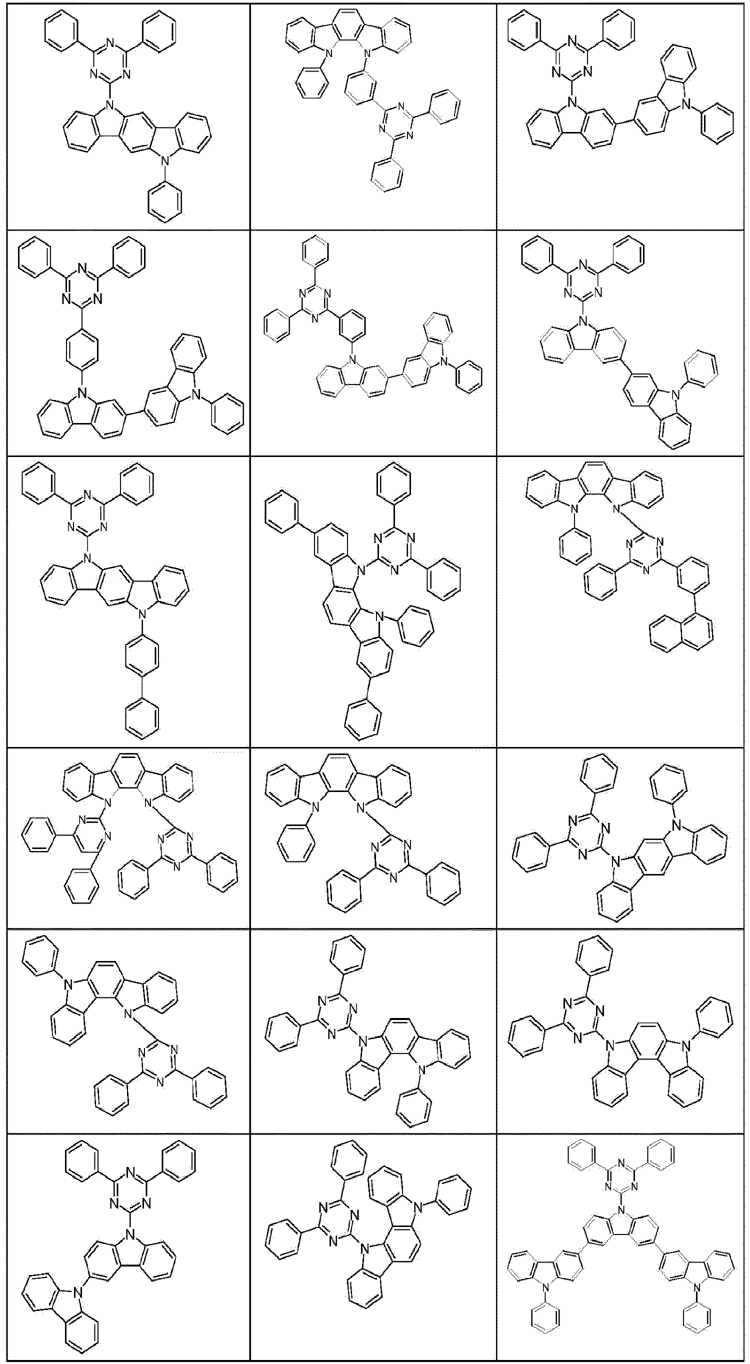

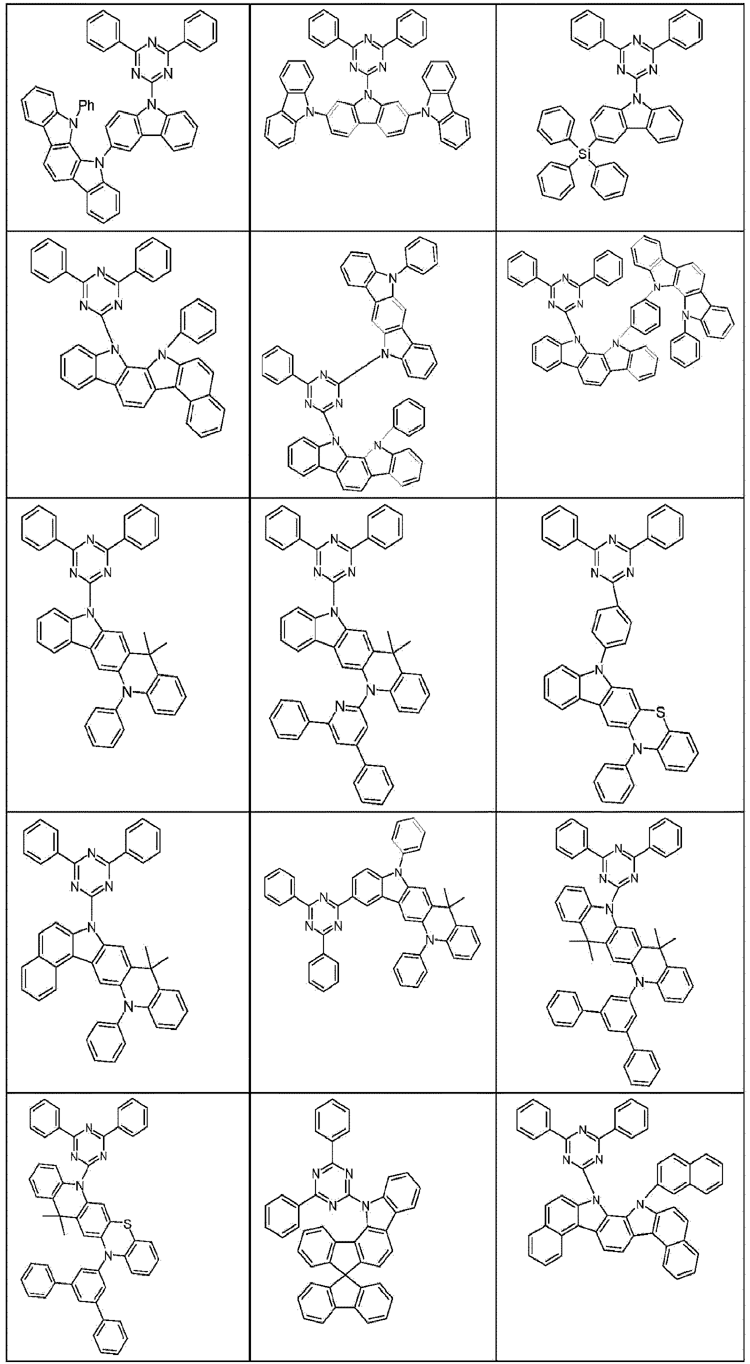

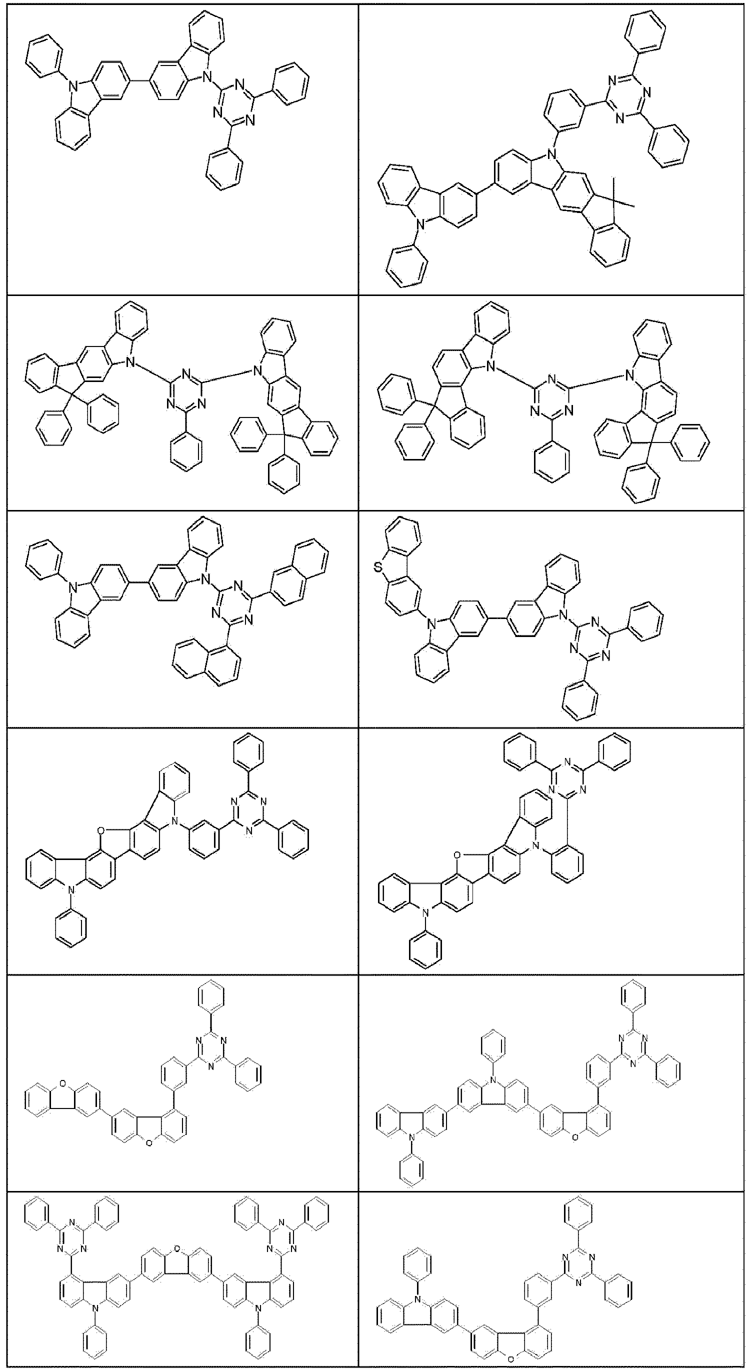

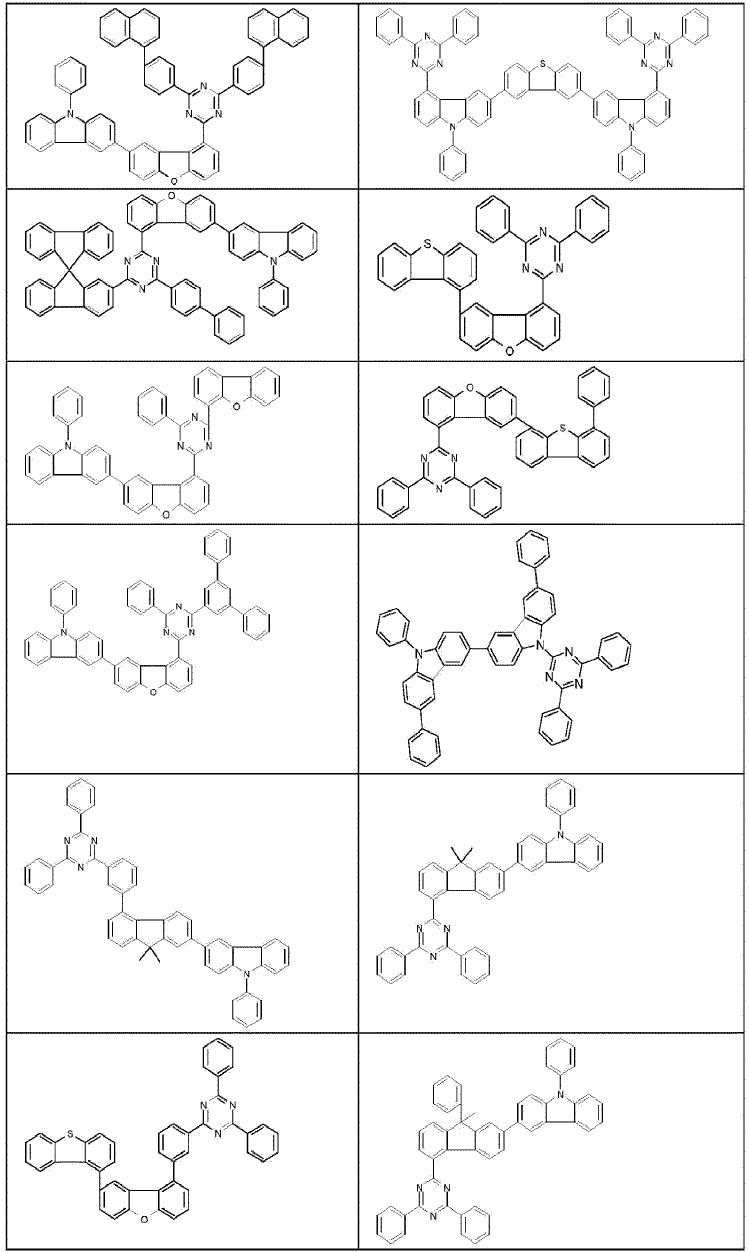

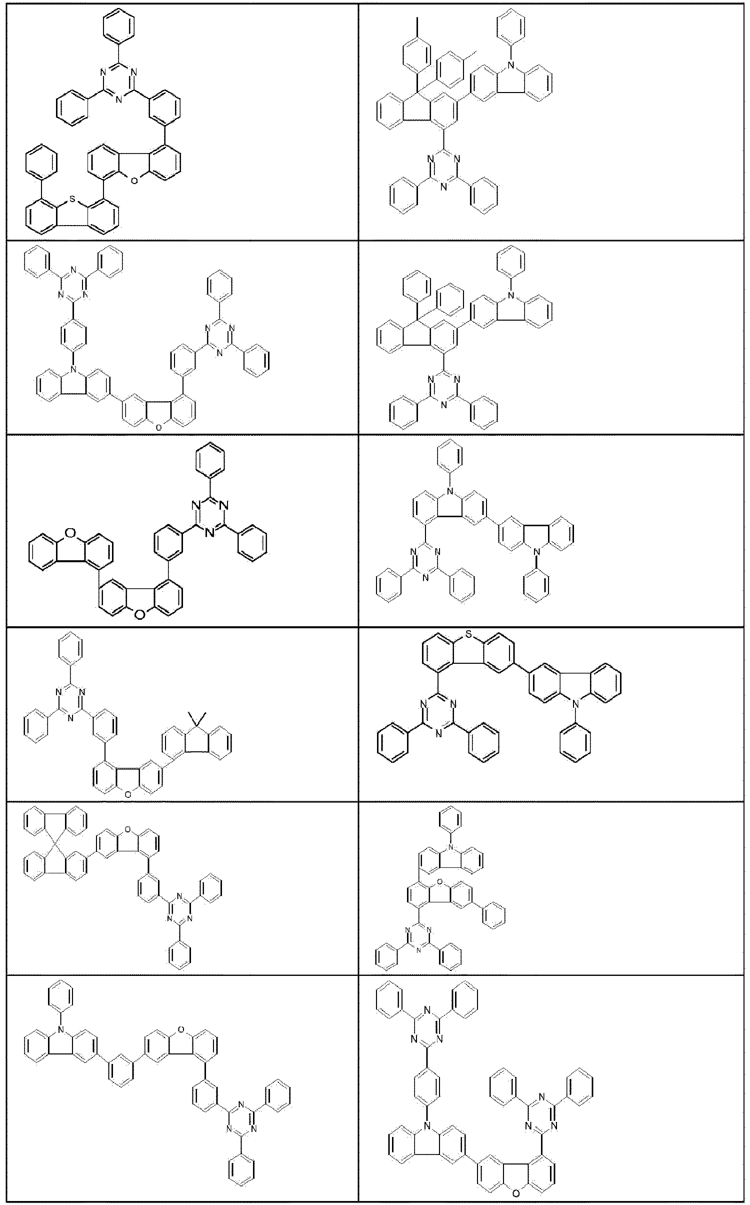

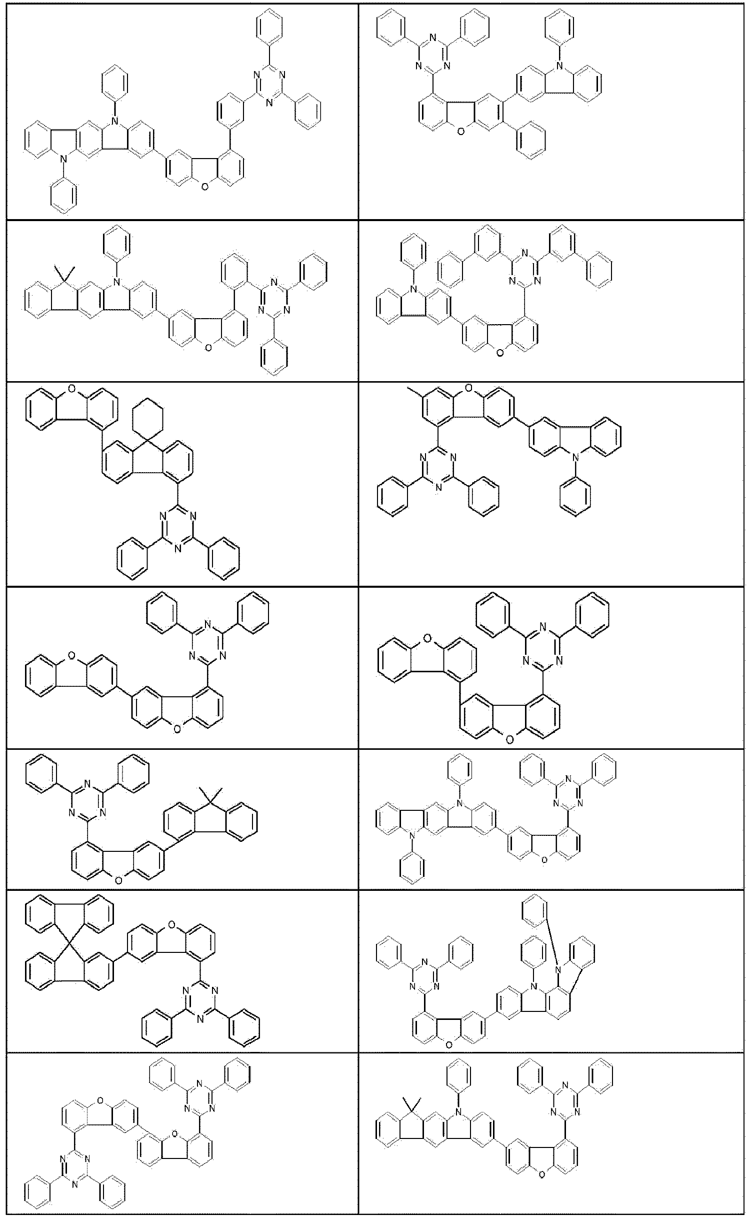

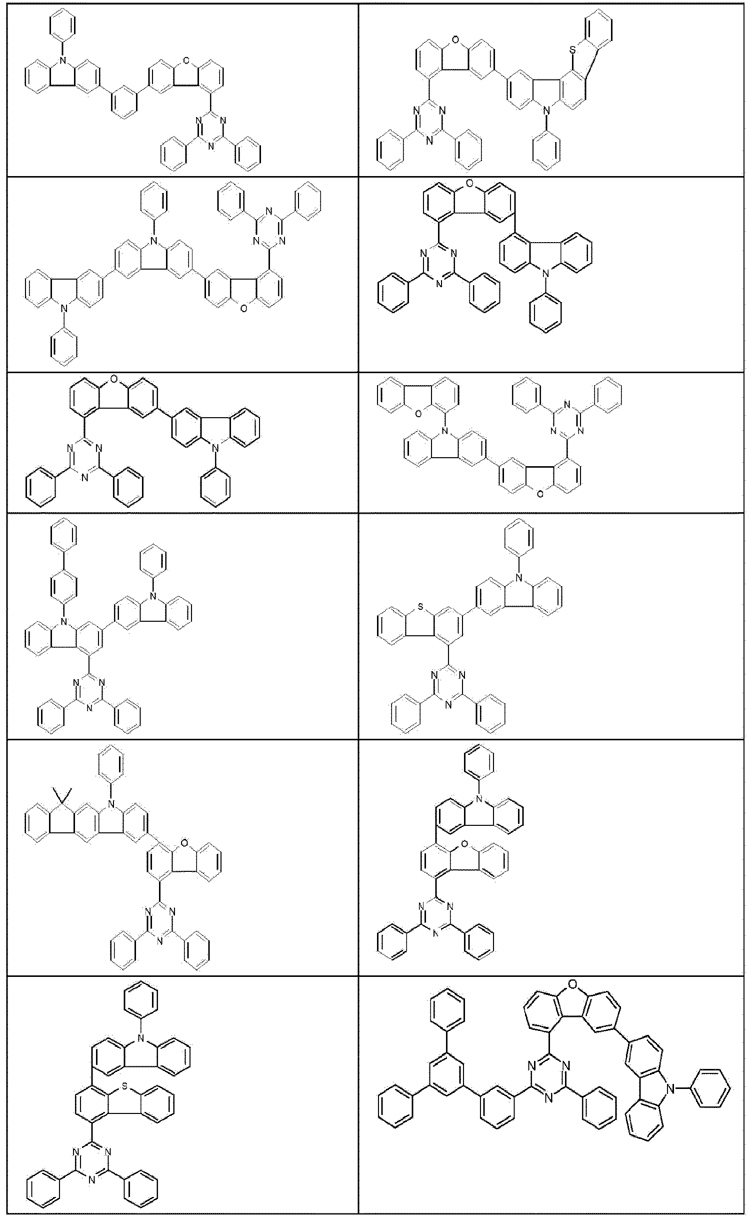

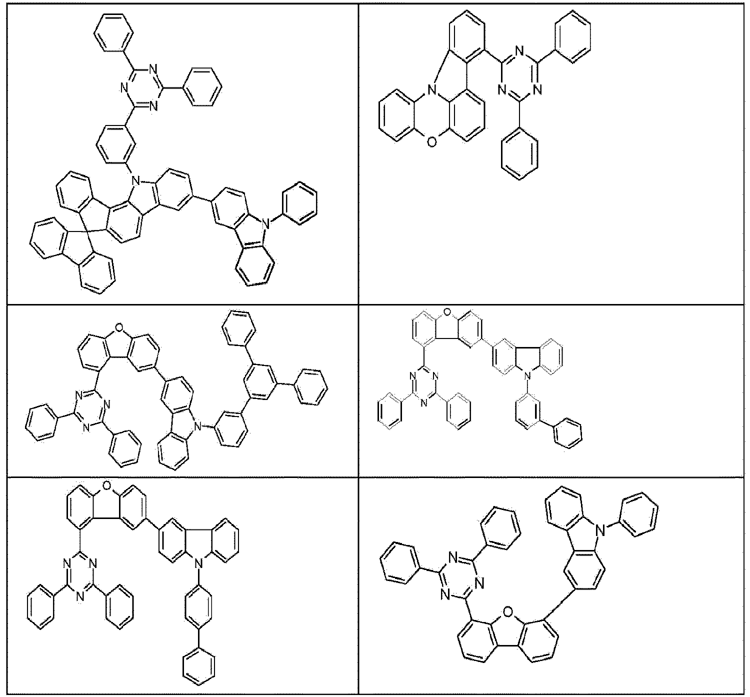

Beispiele für geeignete Chinazolinverbindungen sind die in der folgenden Tabelle abgebildeten Verbindungen:

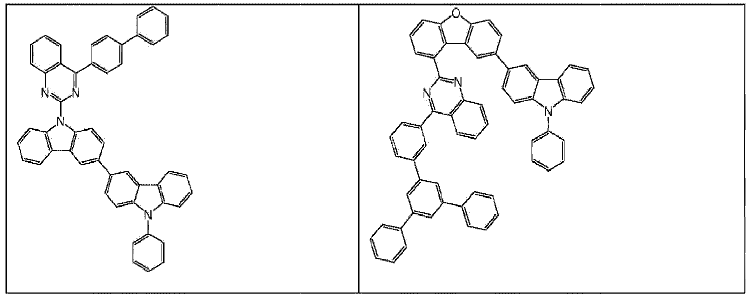

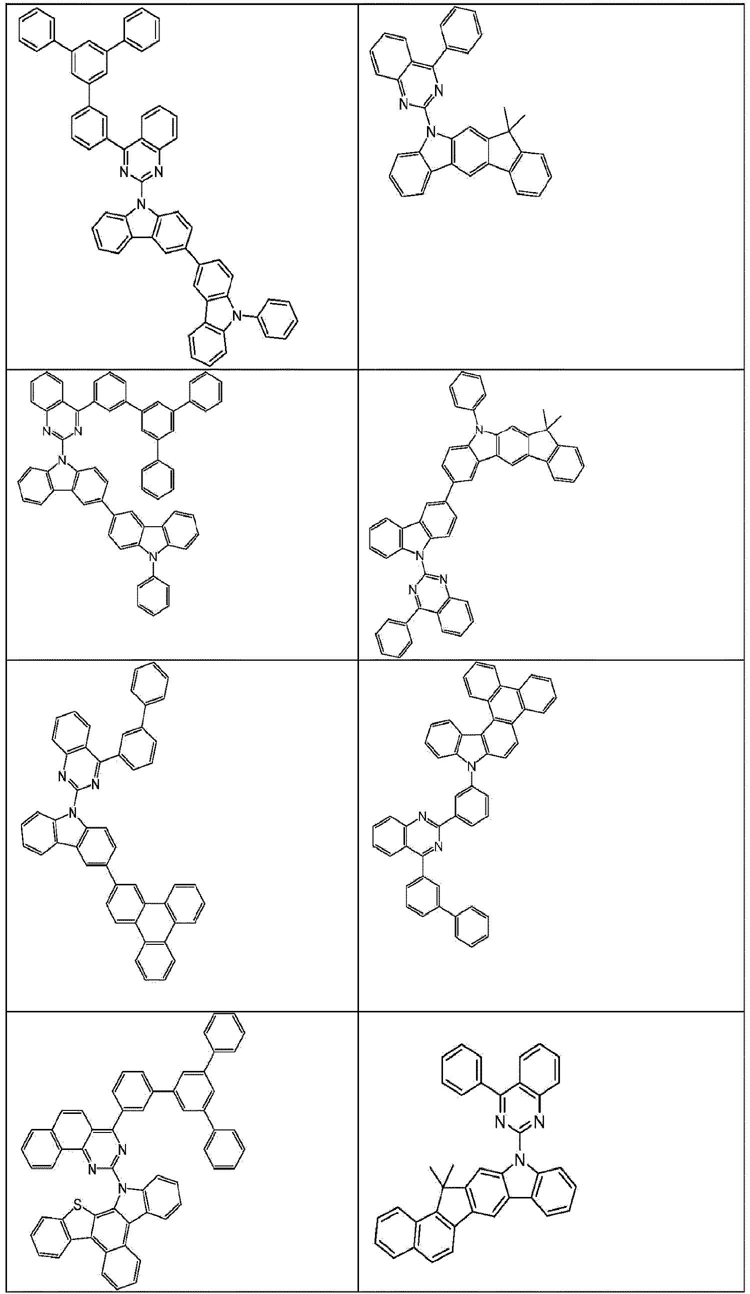

Bevorzugte Biscarbazole sind die Strukturen der folgenden Formeln (23) und (24), 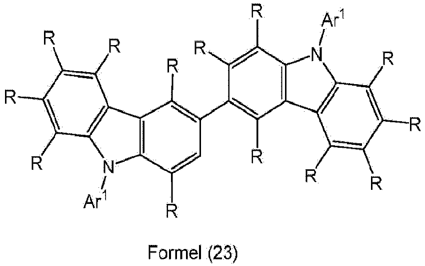 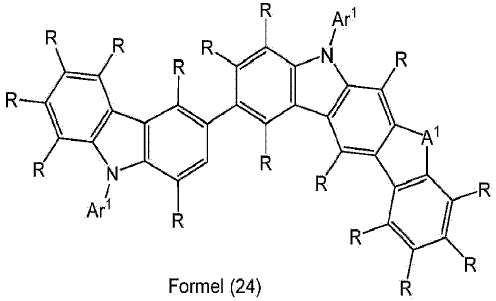 wobei Ar¹ und R die oben genannten Bedeutungen aufweisen und A¹ für CR₂, NR, O oder S steht. In einer bevorzugten Ausführungsform der Erfindung steht A¹ für CR₂.

Bevorzugte Ausführungsformen der Verbindungen der Formeln (23) bzw. (24) sind die Verbindungen der folgenden Formeln (23a) bzw. (24a), 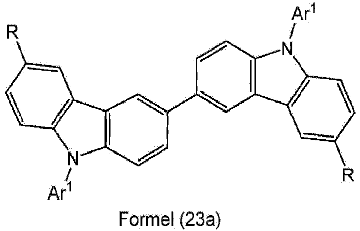 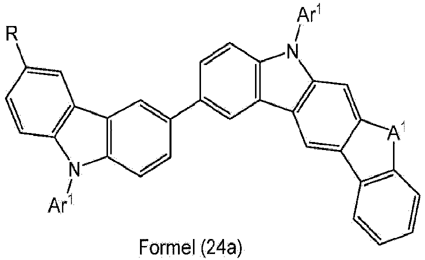 wobei die verwendeten Symbole die oben genannten Bedeutungen aufweisen.

Beispiele für geeignete Verbindungen gemäß Formel (23) oder (24) sind die nachfolgend abgebildeten Verbindungen.

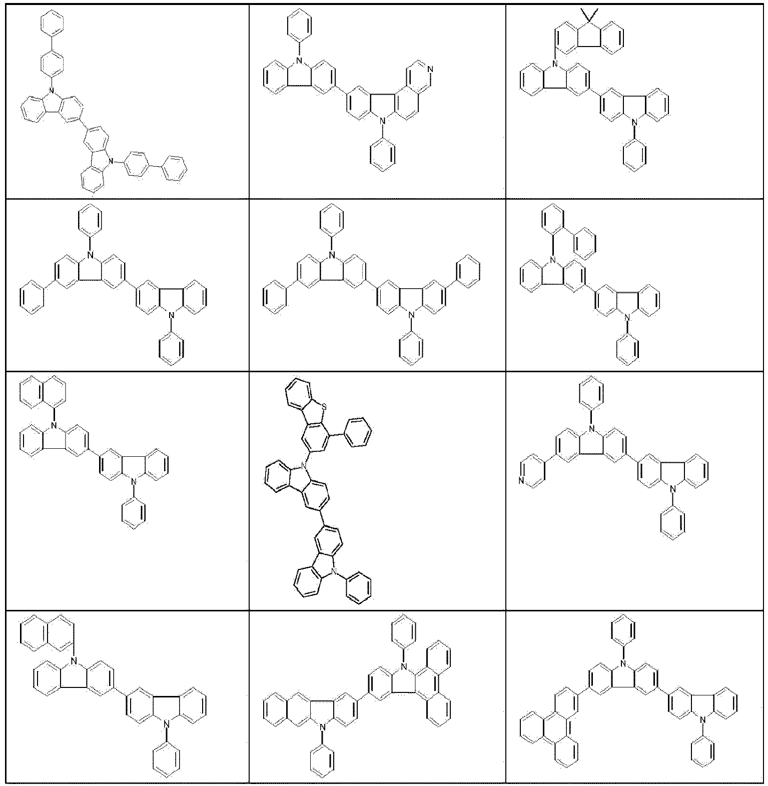

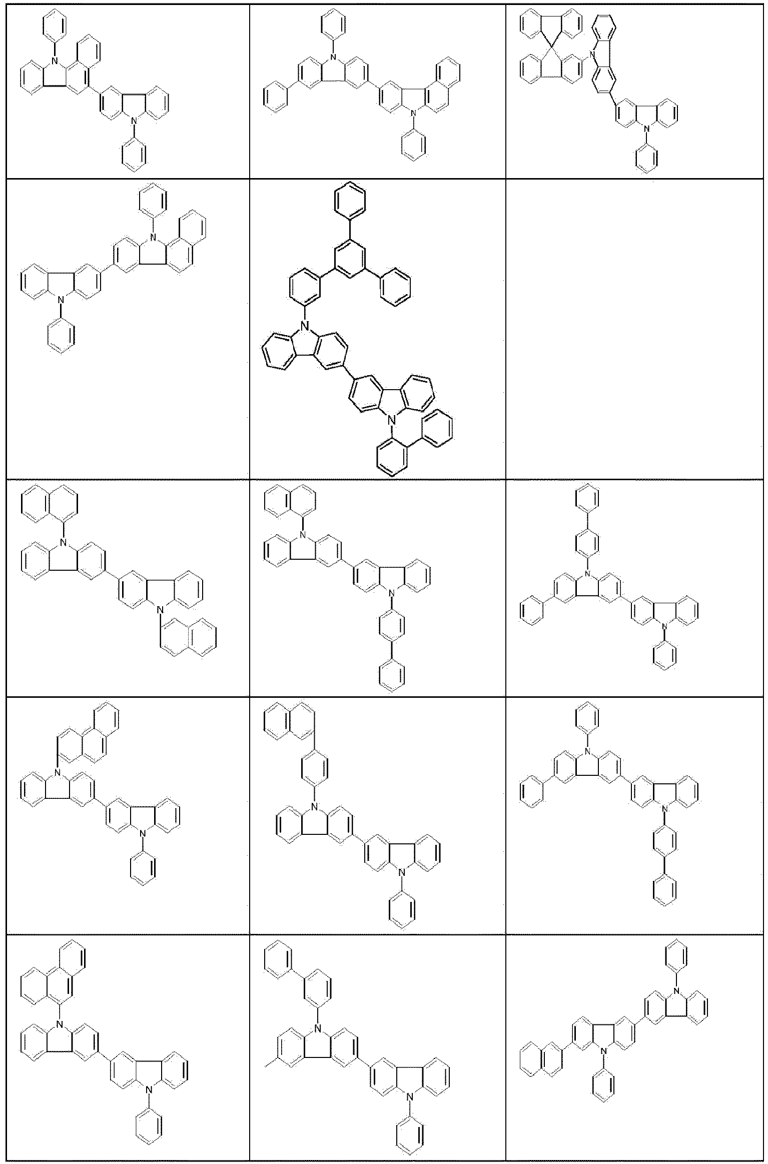

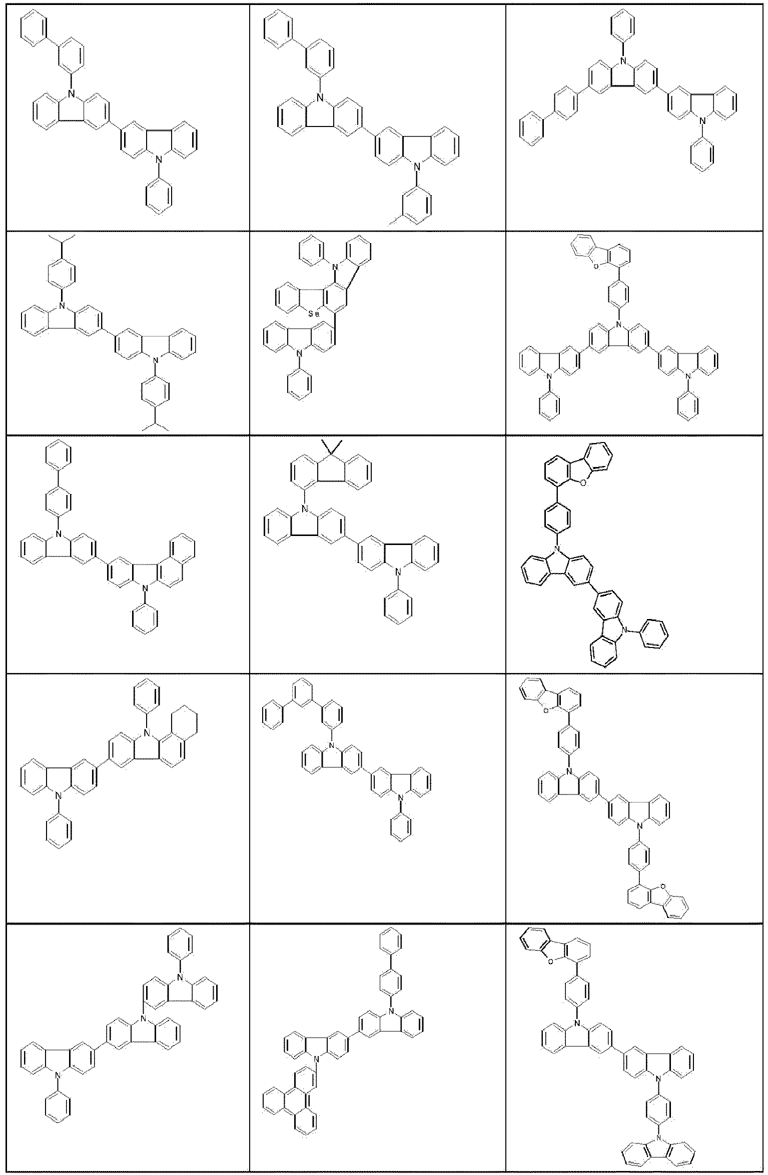

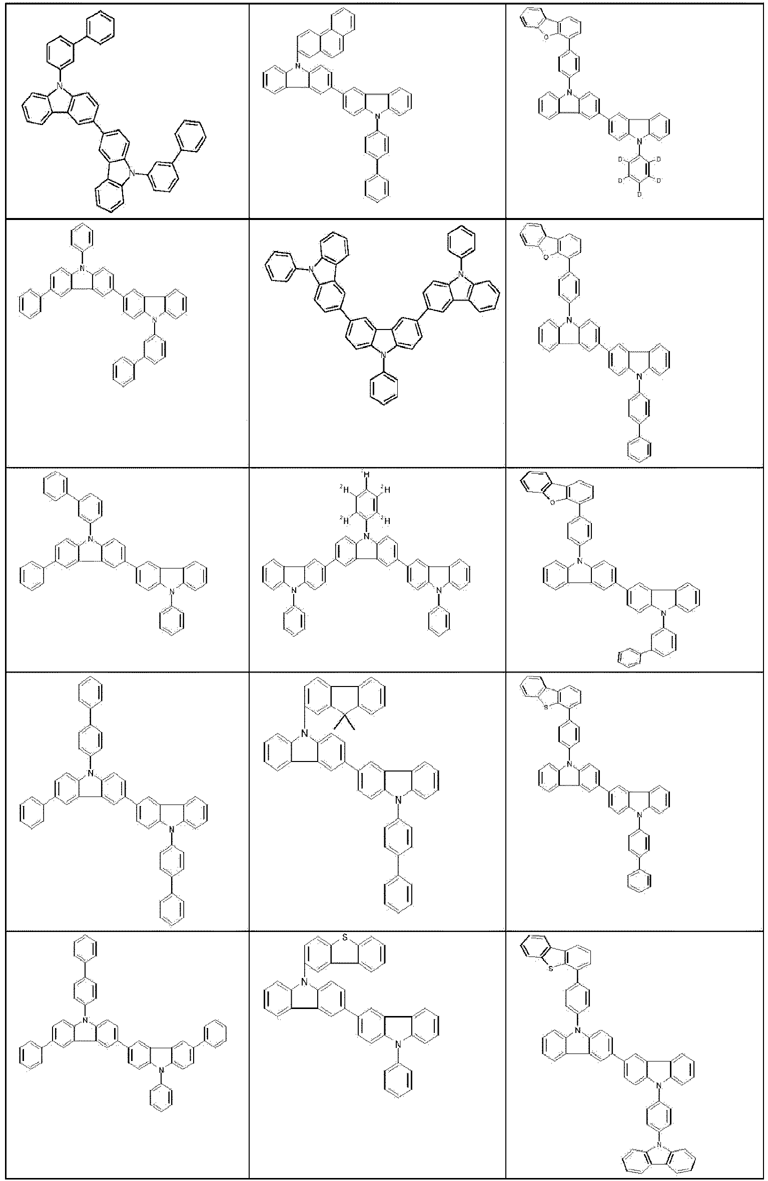

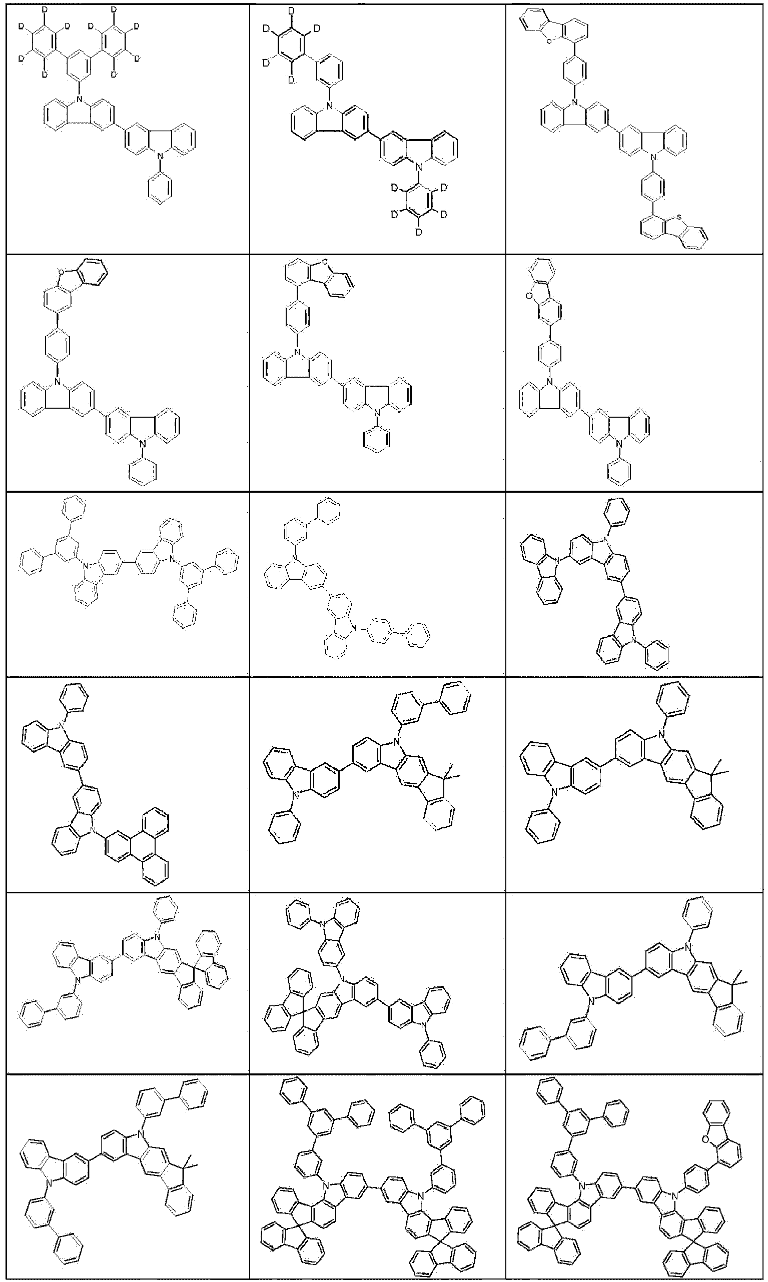

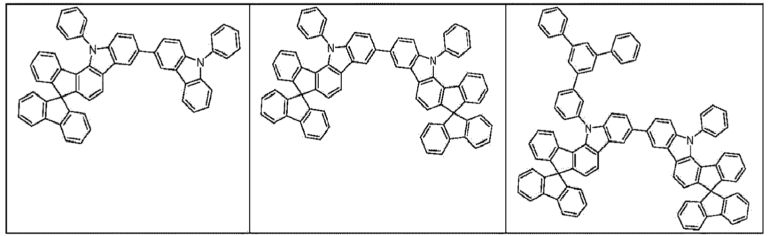

Bevorzugte verbrückte Carbazole sind die Strukturen der folgenden Formel (25), 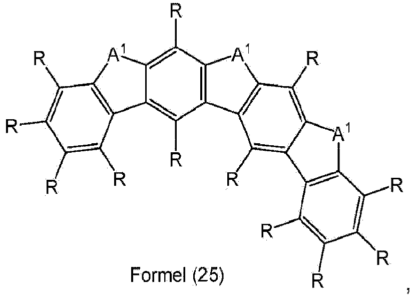 wobei A¹ und R die oben genannten Bedeutungen aufweisen und A¹ bevorzugt gleich oder verschieden bei jedem Auftreten ausgewählt ist aus der Gruppe bestehend aus NAr¹ und CR₂.

Bevorzugte Dibenzofuran-Derivate sind die Verbindungen der folgenden Formel (26), 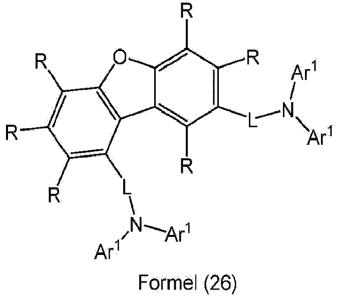 wobei der Sauerstoff auch durch Schwefel ersetzt sein kann, so dass ein Dibenzothiophen entsteht, L für eine Einfachbindung oder ein aromatisches oder heteroaromatisches Ringsystem mit 5 bis 30 aromatischen Ringatomen steht, welches auch durch eine oder mehrere Reste R substituiert sein kann, und R und Ar¹ die oben genannten Bedeutungen aufweisen. Dabei können die beiden Gruppen Ar¹, die an dasselbe Stickstoffatom binden, oder eine Gruppe Ar¹ und eine Gruppe L, die an dasselbe Stickstoffatom binden, auch miteinander verbunden sein, beispielsweise zu einem Carbazol.

Beispiele für geeignete Dibenzofuran-Derivate sind die nachfolgend abgebildeten Verbindungen.

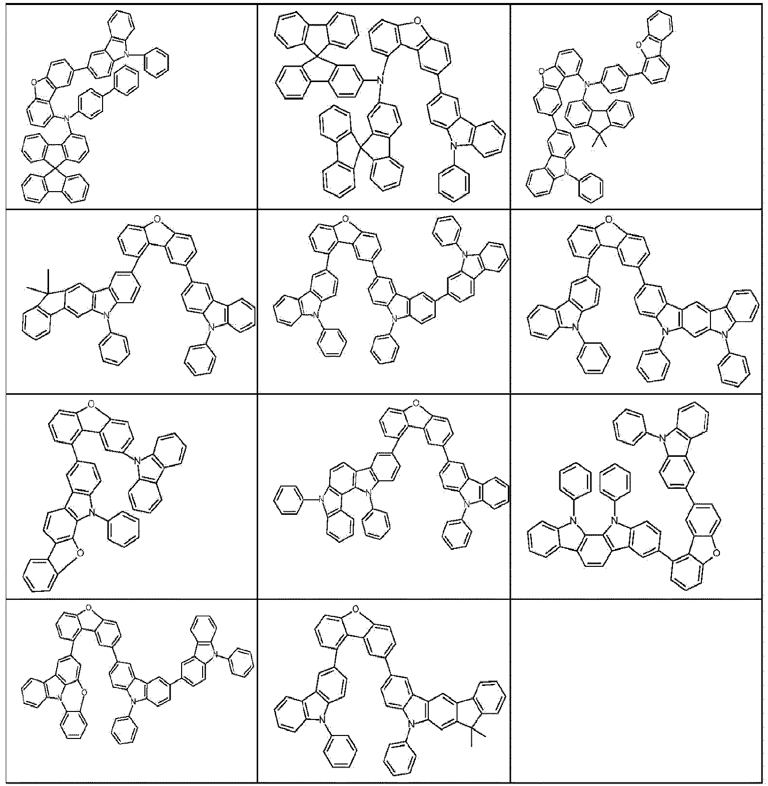

Geeignete Verbindungen, die als Wide Bandgap Matrixmaterialien eingesetzt werden können, sind die Verbindungen der folgenden Formel (27), 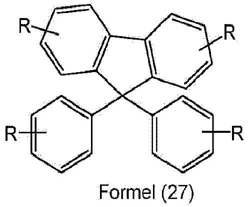 wobei die R die oben genannten Bedeutungen hat und bevorzugt gleich oder verschieden bei jedem Auftreten für H, D, eine lineare Alkylgruppe mit 1 bis 10 C-Atomen, eine verzweigte oder cyclische Alkylgruppe mit 3 bis 10 C-Atomen oder ein aromatisches Ringsystem mit 6 bis 24 aromatischen Ringatomen, das auch durch eine oder mehrere Alkylgruppen mit 1 bis 10 C-Atomen substituiert sein kann, bevorzugt aber unsubstituiert ist, steht.

Beispiele für Materialien, welche als Wide Bandgap Matrixmaterialien eingesetzt werden können:

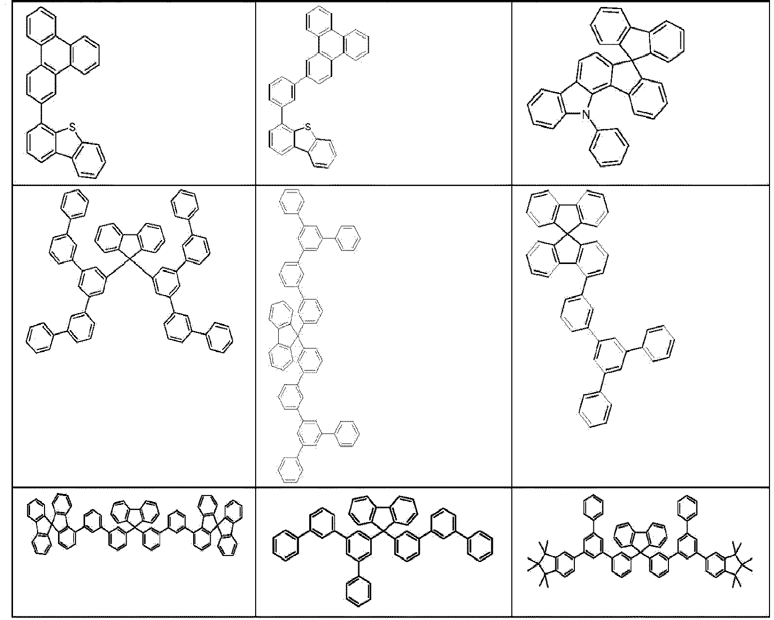

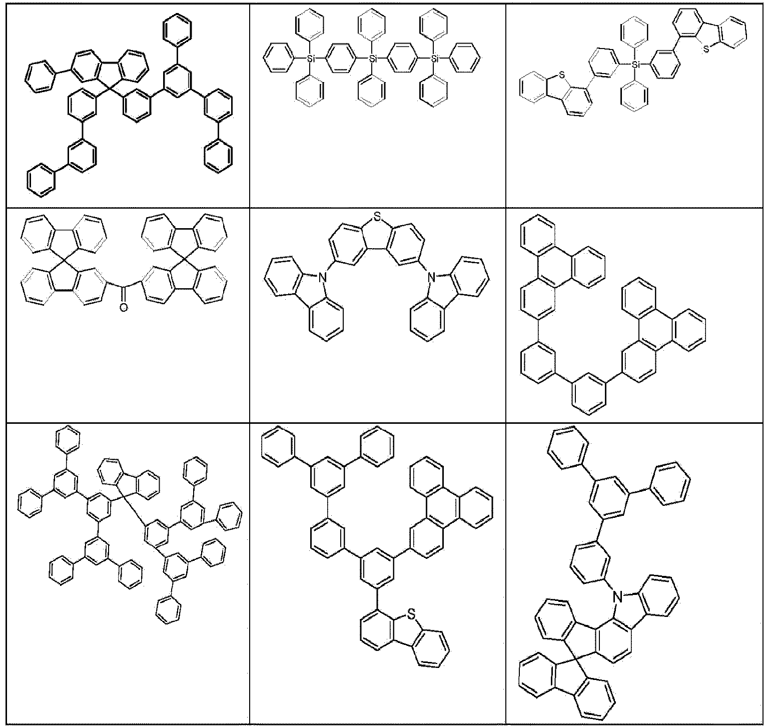

Weiterhin bevorzugt ist es, eine Mischung aus zwei oder mehr Triplettemittern, insbesondere zwei Triplettemittern, zusammen mit einem oder mehreren Matrixmaterialien einzusetzen. Dabei dient der Triplettemitter mit dem kürzerwelligen Emissionsspektrum als Co-Matrix für den Triplettemitter mit dem längerwelligen Emissionsspektrum. Im vorliegenden Fall ist im Allgemeinen die Verbindung der Formel (1) der Triplettemitter mit dem längerwelligen Emissionsmaximum. So können beispielsweise die erfindungsgemäßen Verbindungen mit einem kürzerwelligen, z. B. blau, grün oder gelb emittierenden, Metallkomplex als Co-Matrix kombiniert werden.

Eine bevorzugte Mischung in der emittierenden Schicht enthält ein elektronentransportierendes Hostmaterial, ein so genanntes "wide bandgap" Hostmaterial, das aufgrund seiner elektronischen Eigenschaften nicht oder nicht in wesentlichem Umfang am Ladungstransport in der Schicht beteiligt ist, einen Co-Dotanden, welcher ein Triplettemitter ist, welcher bei einer kürzeren Wellenlänge als die erfindungsgemäße Verbindung emittiert, sowie eine erfindungsgemäße Verbindung.

Eine weitere bevorzugte Mischung in der emittierenden Schicht enthält ein elektronentransportierendes Hostmaterial, ein so genanntes "wide band gap" Hostmaterial, das aufgrund seiner elektronischen Eigenschaften nicht oder nicht in wesentlichem Umfang am Ladungstransport in der Schicht beteiligt ist, ein lochtransportierendes Hostmaterial, einen Co-Dotanden, welcher ein Triplettemitter ist, welcher bei einer kürzeren Wellenlänge als die erfindungsgemäße Verbindung emittiert, sowie eine erfindungsgemäße Verbindung.

Beispiele der oben beschriebenen Emitter können den Anmeldungen WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094961, WO 2014/094960, WO 2015/036074, WO 2015/104045, WO 2015/117718, WO 2016/015815, WO 2016/124304, WO 2017/032439, WO 2018/011186, WO 2018/041769, WO 2019/020538, WO 2018/178001, WO 2019/115423 und WO 2019/158453 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Beispiele für geeignete Triplettemitter, welche als Co-Dotanden für die erfindungsgemäßen Verbindungen eingesetzt werden können, sind in der folgenden Tabelle abgebildet.

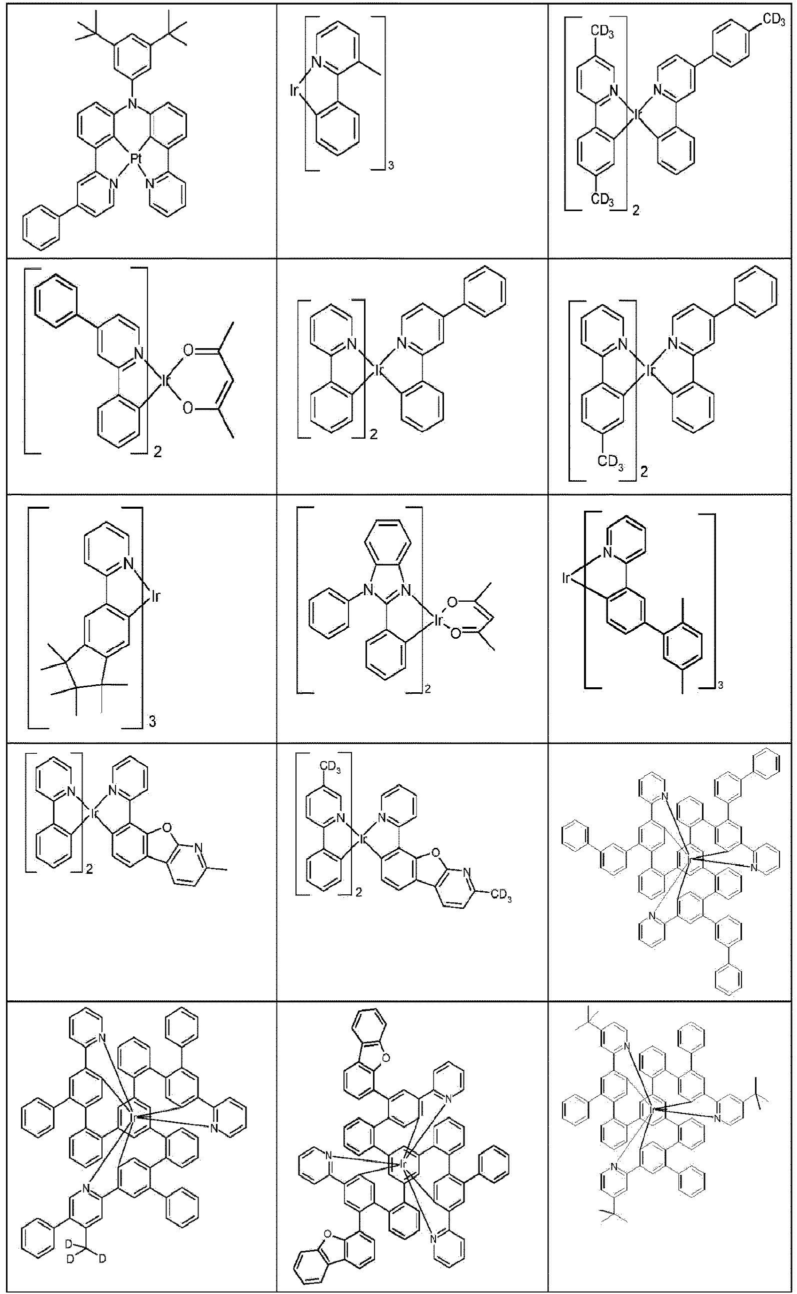

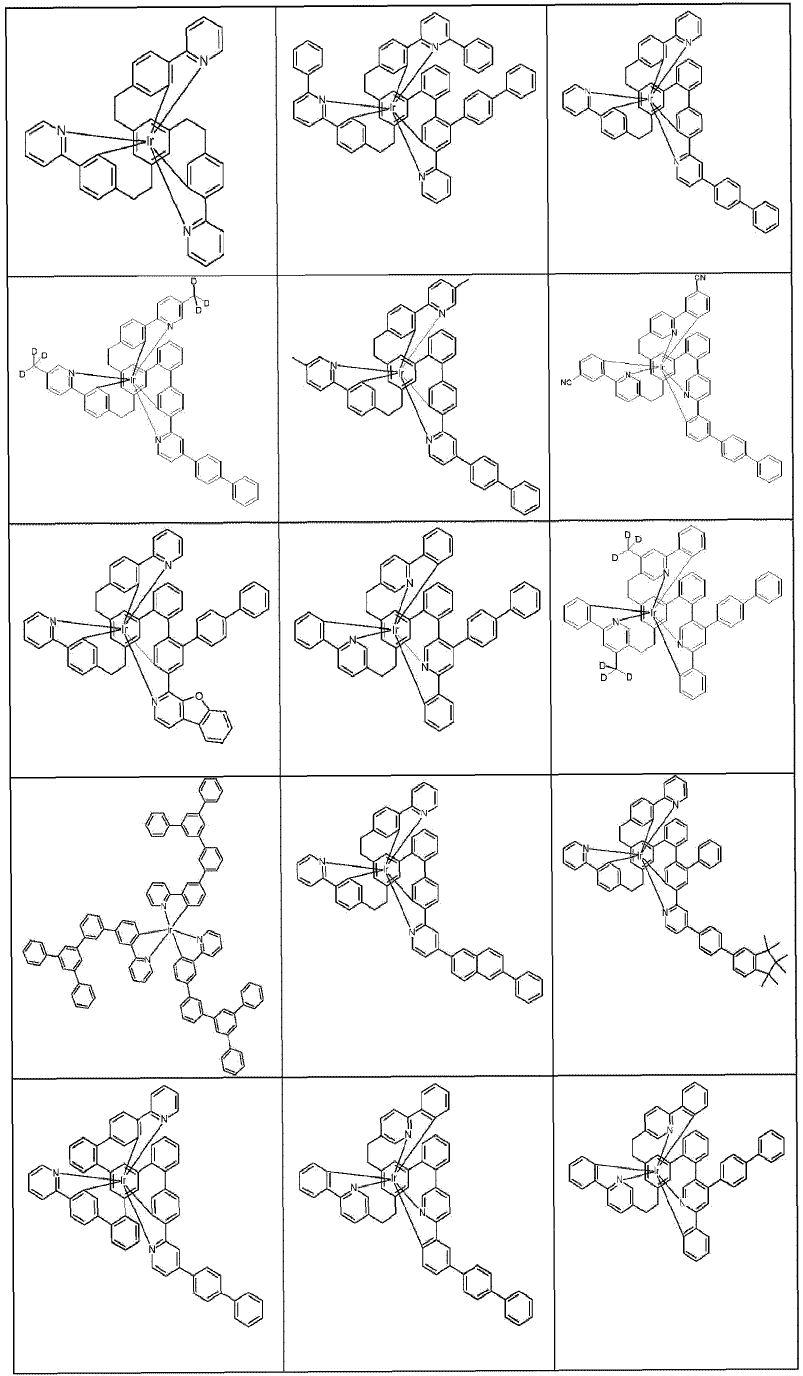

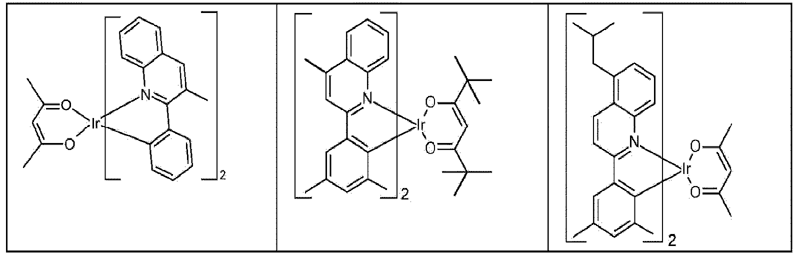

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOx) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. In einer bevorzugten Ausführungsform der Erfindung wird die Schicht, die die erfindungsgemäße Verbindung enthält, aus Lösung aufgebracht.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine Lochtransportschicht und eine emittierende Schicht enthaltend eine erfindungsgemäße Verbindung und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich gegenüber dem Stand der Technik dadurch aus, dass sie auch bei Aufbringen aus Lösung orientiert aufgebracht werden können, was zu orientierter Emission und damit zu einer Verbesserung der externen Quanteneffizienz führt. Dies gilt im Vergleich zu Komplexen, die zwar ansonsten gleich aufgebaut sind, jedoch keine Gruppen X aufweisen. Dieser Vorteil geht nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### Synthese der Gruppen X:

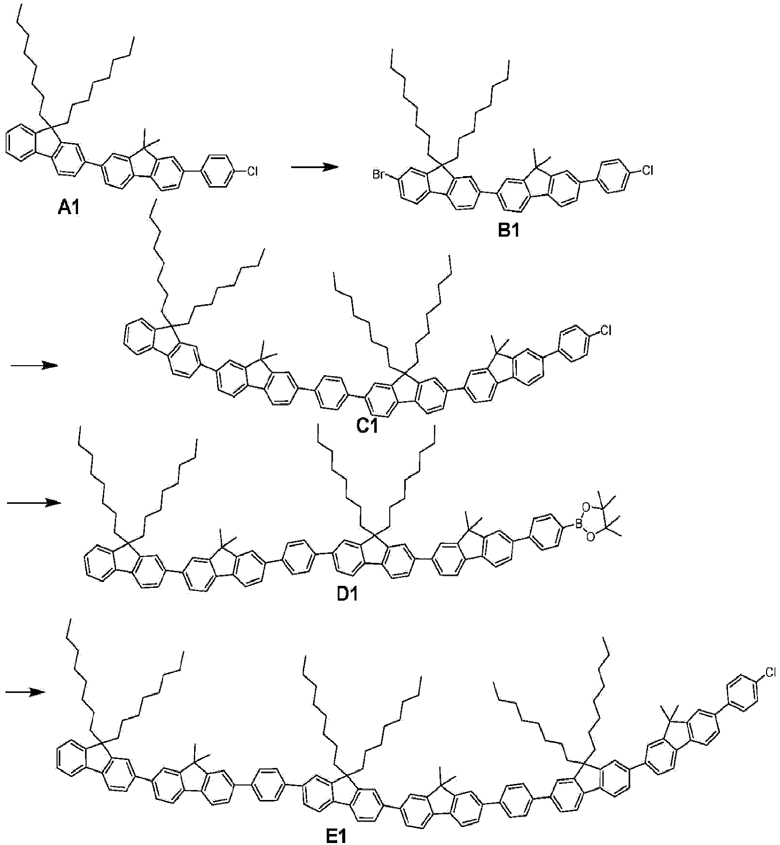

### Synthese von B1

26 g (33.7 mmol) **A1** (CAS 2171483-83-1 ) werden in 600 mL Dichlormethan gelöst. Anschließend werden 7.2 g (44 mmol) N-Bromsuccinimid portionsweise zugeben und unter Zugabe eines Tropfens HBr bei Raumtemperatur gerührt. Nach 48 h werden 200 ml wässrige Natriumhydrogensulfitlösung (30%ig) hinzugegeben und 1 h gerührt. Anschließend werden beide Phasen getrennt, die organische Phase mit Wasser extrahiert und anschließend unter vermindertem Druck eingeengt. Der Rückstand wird mit 300 mL n-Heptan versetzt und 1 h refluxiert. Nach Erkalten der Mischung, wird der farblose Feststoff filtriert und unter verminderten Druck getrocknet. Ausbeute: 25.3 g (32 mmol) entspricht 97 % d. Th).

Folgende Verbindungen können analog hergestellt werden:

| | Edukt | Produkt |
|---|---|---|
| B2 | 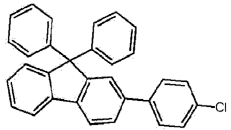 CAS 1221237-90-6 | 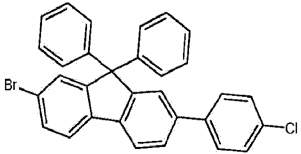 |
| B3 | 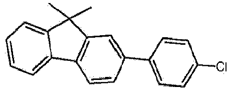 CAS 1221237-82-6 | 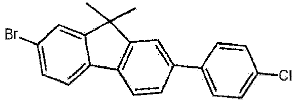 |
| B4 | 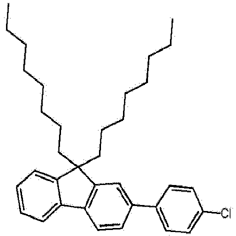 CAS1706803-15-7 | 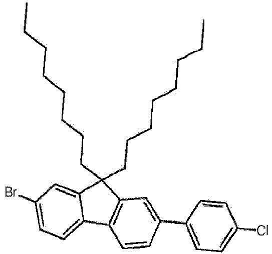 |
| B5 | 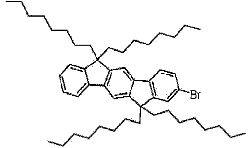 CAS 929198-27-6 | Mit NCS anstatt NBS |
| | | 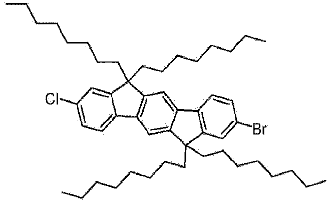 |
| B6 | C1 | 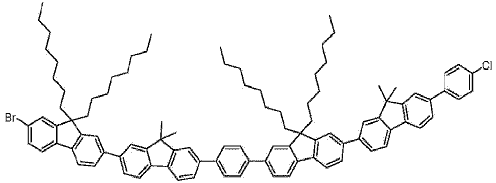 |
| B7 | C2 | 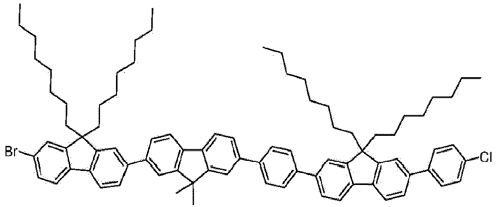 |
| B8 | C3 | 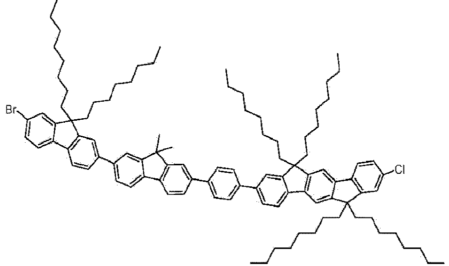 |
| B9 | C4 | 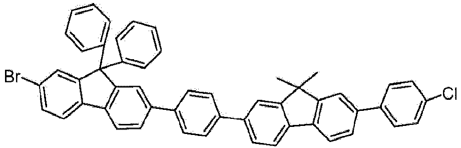 |
| B10 | C5 | 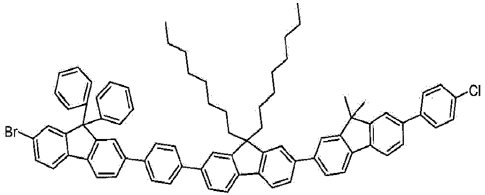 |
| B11 | C6 | 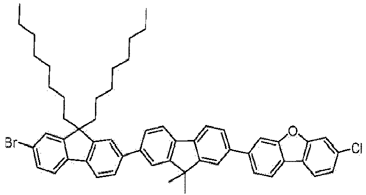 |
| B12 | C7 | 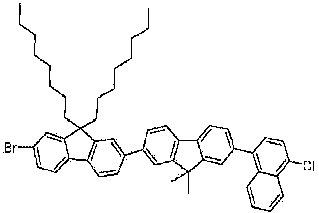 |
| B13 | C8 | 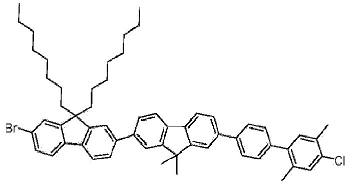 |
| B14 | C13 | 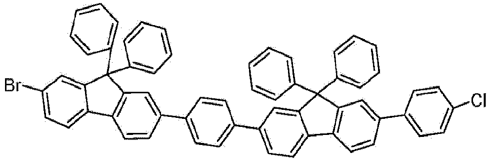 |

### Synthese von C1:

28.0 g (35.5 mmol) **B1,** 33.6 g (35.5mmol) CAS 2171483-74-0 und 9.8 g (71 mmol) Kaliumcarbonat werden mit 1100 mL THF und 550 mL Wasser versetzt. Anschließend werden 373 mg (1.4 mmol) Triphenylphosphin und 325 mg (0.4 mmol) Tri(dibenzylidenaceton)dipalladium zugegeben und 16 h refluxiert. Anschließend wird die Reaktionsmischung mit Wasser und Toluol versetzt und die Phasen werden getrennt. Die wässrige Phase wird zweimal mit Toluol extrahiert und die vereinten organischen Phasen einmal mit Wasser extrahiert. Die organische Phase wird über Aluminiumoxid filtriert und anschließend unter vermindertem Druck eingeengt. Das Produkt wird durch mehrmalige Kristallisation aus Toluol/n-Heptan 1:10 aufgereinigt und als Feststoff erhalten. Ausbeute: 41.0 g (28.8 mmol) 81 % d. Th..

Folgende Verbindungen können analog hergestellt werden:

| | Boronester | Bromid | Produkt |
|---|---|---|---|
| C2 | CAS 2171483-74-0 | B4 | 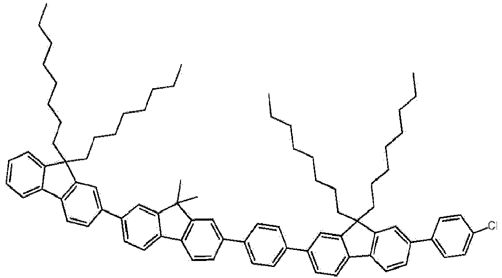 |
| C3 | CAS 2171483-74-0 | B5 | 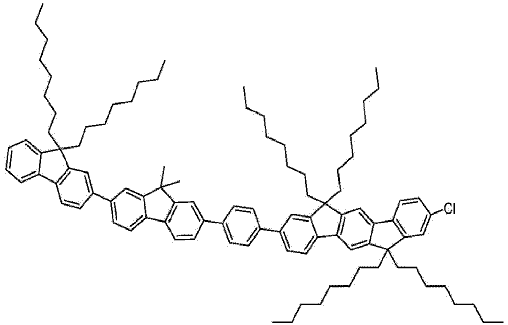 |
| C4 | CAS 1813574-72-9 | B3 | 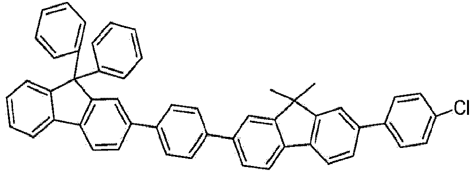 |
| C5 | CAS 1813574-72-9 | B1 | 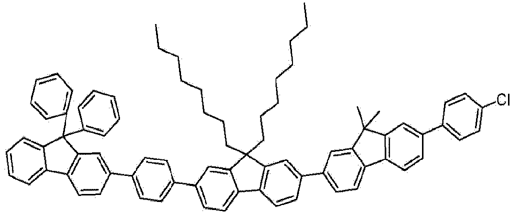 |
| C6 | CAS 2171483-74-0 | 2244910-28-7 | 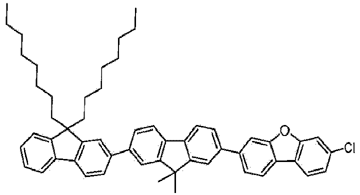 |
| C7 | CAS 2171483-74-0 | 53220-82-9 | 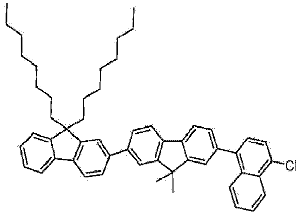 |
| C8 | CAS 85072-44-2 | B5 | 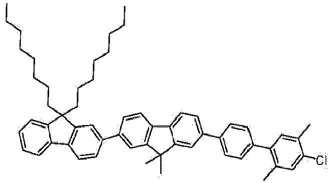 |
| C9 | CAS 85072-44-2 | B11 | 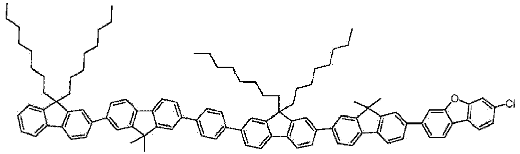 |
| C10 | CAS 85072-44-2 | B12 | 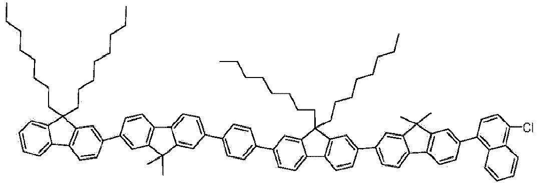 |
| C11 | CAS 85072-44-2 | B13 | 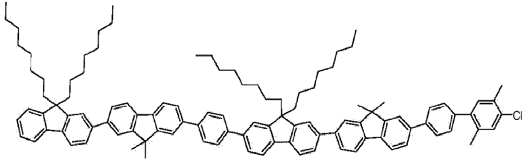 |
| C12 | CAS 1256619-36-9 | D6 | 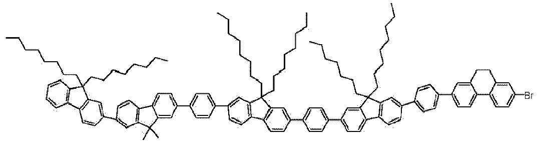 |
| C13 | CAS 1813574-72-9 | CAS 2268821-67-4 | 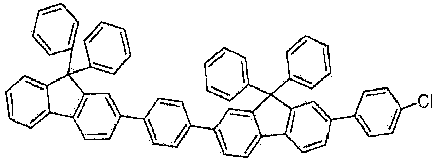 |
| C14 | CAS 24388-23-6 | CAS 198289-16-6 | 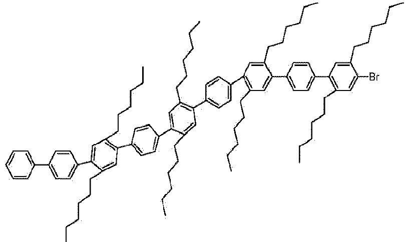 |

### Synthese von D1:

25.3 g (18.7 mmol) C1, 8.6 g (33.7 mmol) Bis-(pinacolato)-diboron, 5.5 g(56 mmol) Kaliumacetat und 830 mg (1.1 mmol) trans-Dichlorobis(tri-cyclohexylphosphin)palladium(II) werden mit 750 mL Dioxan versetzt und 48 h refluxiert. Anschließend wird das Reaktionsgemisch mit Toluol und Wasser versetzt und die Phasen getrennt. Die wässrige Phase wird zweimal mit Toluol extrahiert, die vereinten organischen Phasen werden zweimal mit Wasser extrahiert, anschließend über Aluminiumoxid filtriert und unter vermindertem Druck eingeengt. Der Rückstand wird mit heißem Ethanol ausgerührt und das Produkt als Feststoff erhalten. Ausbeute: 16.0 g (11.1 mmol), 60 % d. Th..

Folgende Verbindungen können analog hergestellt werden:

| | Edukt | |
|---|---|---|
| D2 | C2 | 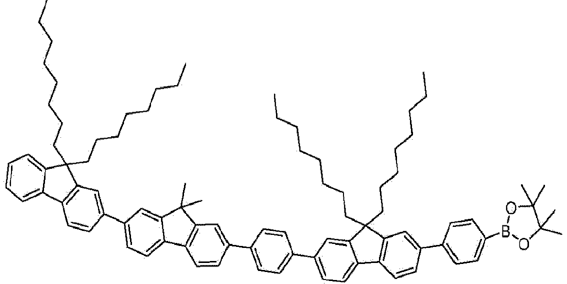 |
| D3 | C3 | 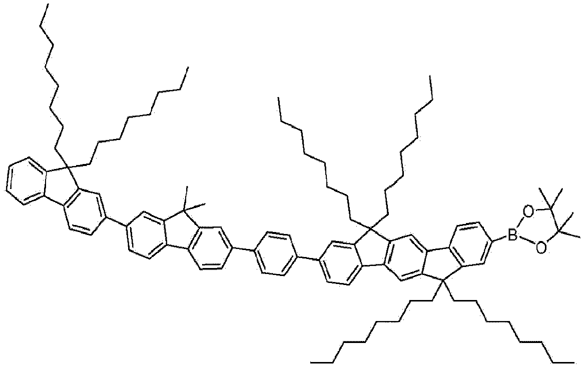 |
| D4 | C4 | 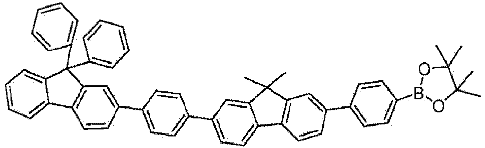 |
| D5 | C5 | 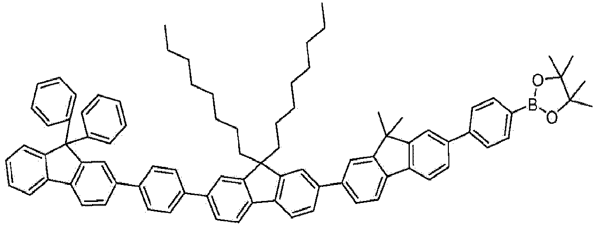 |
| D6 | E17 | 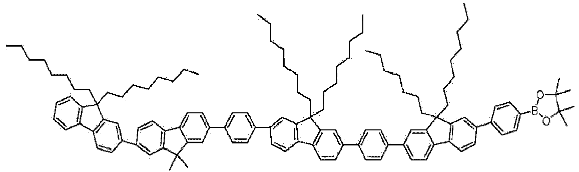 |
| D7 | C12 | 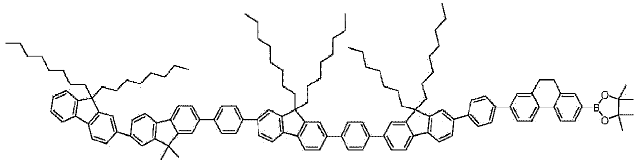 |
| D8 | C13 | 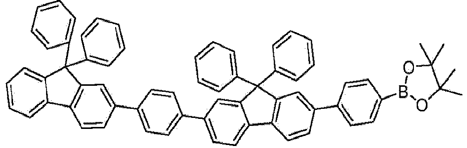 |
| D9 | C14 | 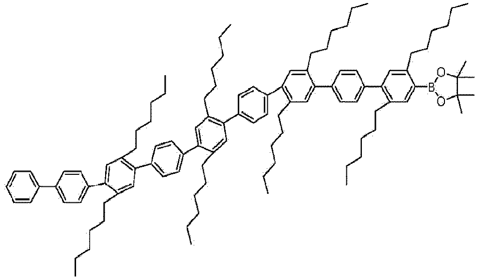 |
| D10 | CAS 2179264-15-2 | 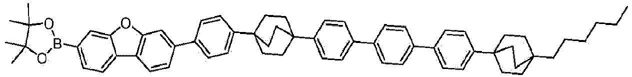 |

### Synthese von E1:

5 g (6.4 mmol) **B1,** 9.8 g (6.8 mmol) **D1** und 1.8 g (13 mmol) Kaliumcarbonat werden mit 800 mL THF und 400 mL Wasser versetzt. Anschließend werden 67 mg (0.26 mmol) Triphenylphosphin und 59 mg (0.06 mmol) Tri(dibenzylidenaceton)dipalladium zugegeben und 16 h refluxiert. Anschließend wird die Reaktionsmischung mit Wasser und Toluol versetzt und die Phasen werden getrennt. Die wässrige Phase wird zweimal mit Toluol extrahiert und die vereinten organischen Phasen einmal mit Wasser extrahiert. Die organische Phase wird über Aluminiumoxid filtriert und anschließend unter vermindertem Druck eingeengt. Das Produkt wird chromatographisch (SiO₂, Heptan/THF 1:20 > 1:10) und durch mehrmaliges Ausrühren aus heißem Toluol und als Feststoff erhalten. Ausbeute: 8.5 g (4.2 mmol) 66 % d. Th.

Folgende Verbindungen können analog hergestellt werden:

| E | Edukt | Boronester | Produkt |
|---|---|---|---|
| 2 | B1 | D2 | 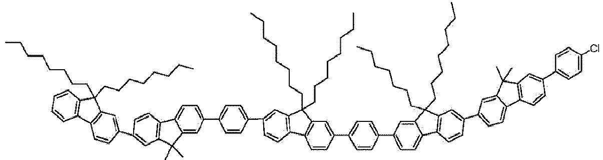 |
| 3 | B1 | D3 | 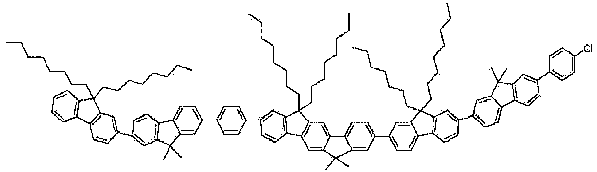 |
| 4 | B1 | D4 | 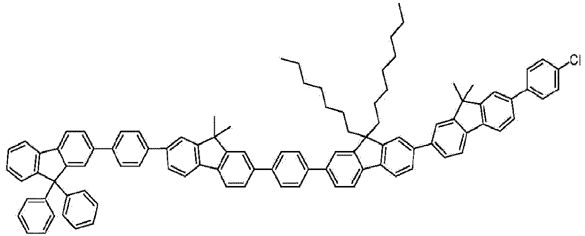 |
| 5 | B1 | D5 | 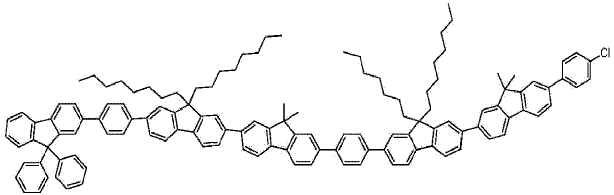 |
| 6 | B11 | D1 | 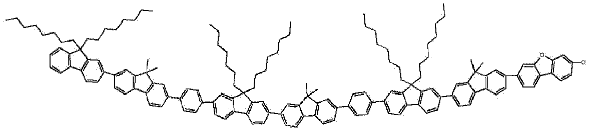 |
| 7 | B12 | D1 | 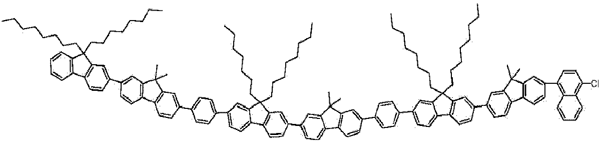 |
| 8 | B13 | D1 | 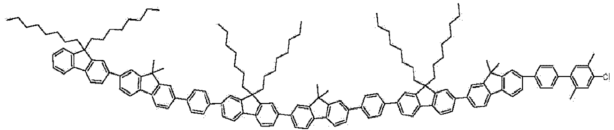 |
| 9 | B5 | D1 | 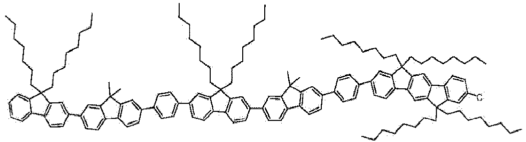 |
| 10 | B6 | D1 | 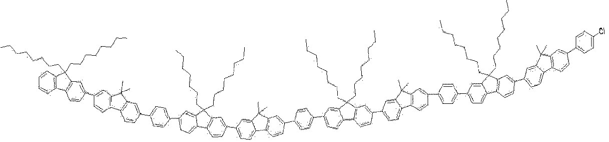 |
| 11 | B7 | D1 | 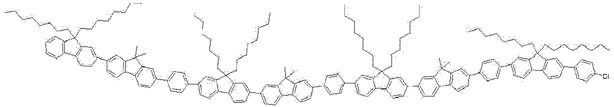 |
| 12 | B8 | D1 | 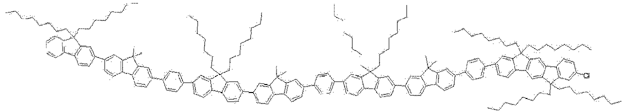 |
| 13 | B9 | D1 | 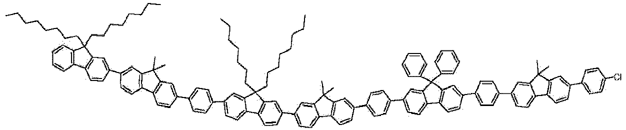 |
| 14 | B10 | D1 | 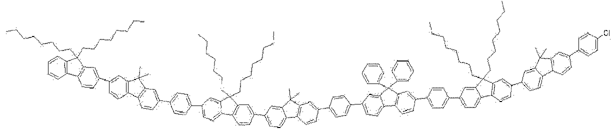 |
| 15 | CAS 19828 9-16-6 | D4 | 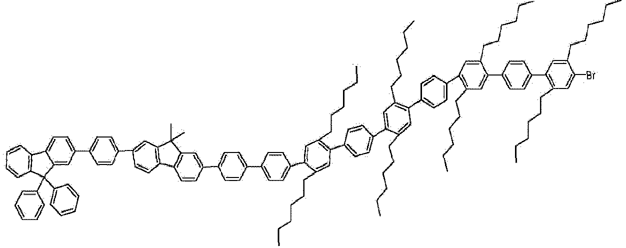 |
| 16 | CAS 19828 9-16-6 | CAS 21714 83-74-0 | 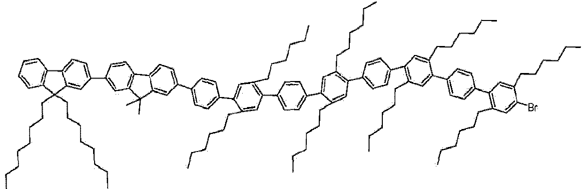 |
| 17 | CAS 18812 30-18-7 | D2 | 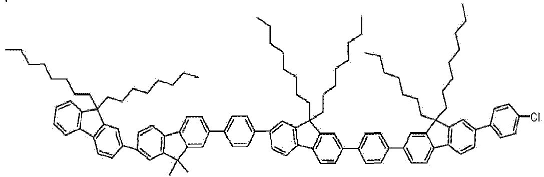 |
| 18 | CAS 53220 -829 | D6 | 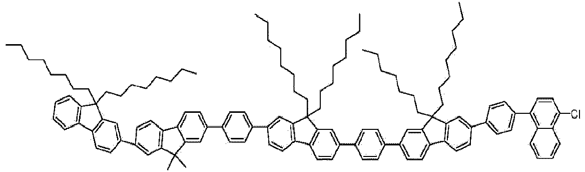 |
| 19 | CAS 18812 30-18-7 | D7 | 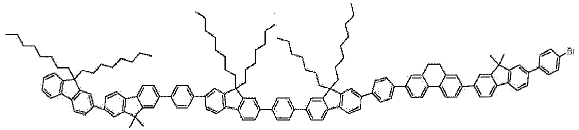 |
| 20 | CAS 19828 9-16-6 | D8 | 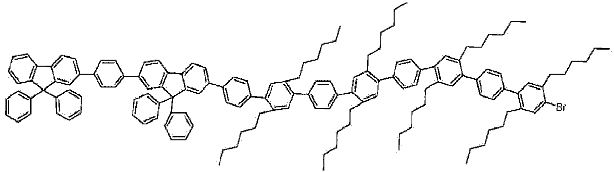 |
| 21 | CAS 19828 9-16-6 | D9 | 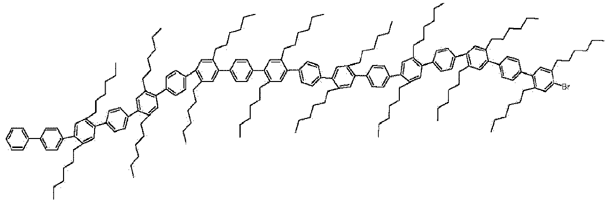 |
| 22 | B14 | D8 | 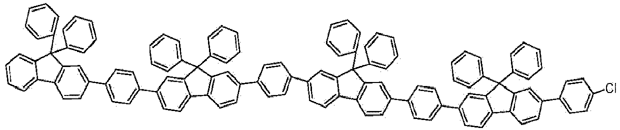 |
| 23 | B1 | D10 | 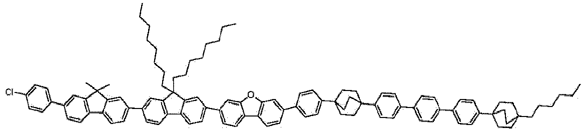 |

### Synthese des Intermediats Int-1

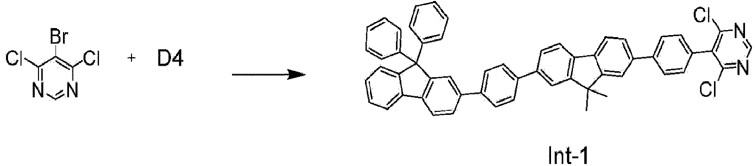

3 g (13.2 mmol) CAS 68797-61-5, 10.4 g (13.2 mmol) D4, 3.7 g (27 mmol) Kaliumcarbonat und 0.76 g (0.66 mmol) Tetrakis(triphenylphosphin)-palladium(0) werden in 500 ml Toluol/Ethanol/Wasser (2:1:1) gemischt und 18 h unter Rückfluss erhitzt. Nach vollständigem Umsatz wird das Reaktionsgemisch auf Raumtemperatur abgekühlt. Die organische Phase wird mit Toluol erweitert und zweimal mit Wasser und einmal mit gesättigter wässriger Kochsalzlösung gewaschen. Die organischen Phasen werden vereint und am Rotationsverdampfer eingeengt. Das Produkt wird säulenchromatografisch (SiO₂; THF/Heptan) aufgereinigt. Ausbeute: 4.3 g (5.3 mmol; 40%).

### Synthese des Intermediats Int-2

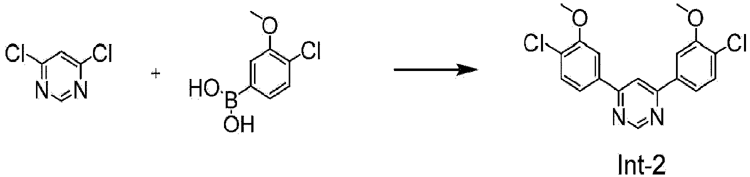

15.0 g (100.7 mmol) 4,6-Dichlorpyrimidin, 38.5 g (4-Chlor-3-methoxyphenyl)boronsäure, 55.7 g (402.7 mmol) Kaliumcarbonat und 2.8 g (4.0 mmol) Bis(triphenylphosphin)Pd(II)-chlorid werden in 300 mL Acetonitril/ Ethanol (2:1) gelöst und 16 h unter Rückfluss erhitzt. Nach vollständigem Umsatz wird das Reaktionsgemisch auf Raumtemperatur abkühlen gelassen. Der ausgefallene Feststoff wird abgesaugt und mit Toluol und Methanol gewaschen. Das Filtrat wird an einem Rotationsverdampfer eingeengt. Der erhaltene Feststoff wird durch Kristallisation aus Dichlormethan/Methanol aufgereinigt. Ausbeute: 20.9 g ( 57.9 mmol; 58%)

Analog kann die folgende Verbindung aus dem entsprechenden Boronester dargestellt werden:

| | Boronsäure | Edukt | Produkt |
|---|---|---|---|
| Int-2b | CAS 1679-18-1 | Int-1 | 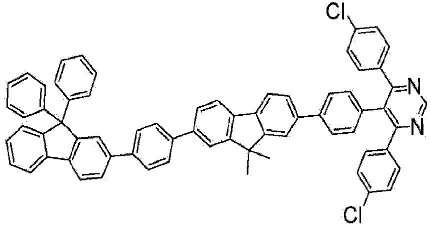 |

### Synthese der Intermediats Int-3

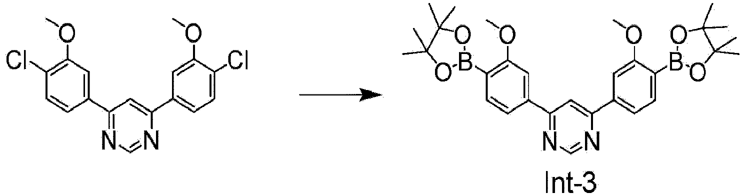

16.0 g (44.3 mmol) Int-2, 24.3 g (95.7 mmol) Bis(pinacolato)diboran und 17.4 g (177.2mmol) Kaliumacetat werden in 1000 ml THF gelöst. Nach Zugabe von 1.87 g (2.2 mmol) Xphos Pd G3 wird das Reaktionsgemisch für 48 h unter Rückfluss erhitzt. Anschließend wird das Reaktionsgemisch auf Raumtempertur abgekühlt und der Feststoff abfiltriert. Das Filtrat wird am Rotationsverdampfer eingeengt und säulenchromatographisch aufgereinigt (SiO₂, Heptan/Ethylacetat) und das Produkt isoliert. Ausbeute: 12.4 g (22.7 mmol; 51%).

Analog kann die folgende Verbindung aus dem entsprechenden Boronester dargestellt werden:

| | Chlorid | Produkt |
|---|---|---|
| Int-3b | Int-2b | 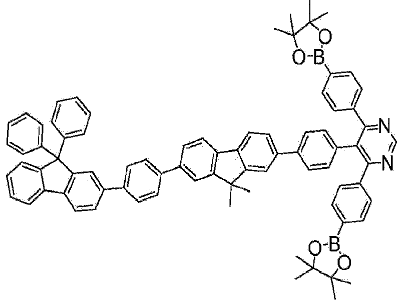 |

### Synthese der Emitter-Grundstruktur Stufe 1

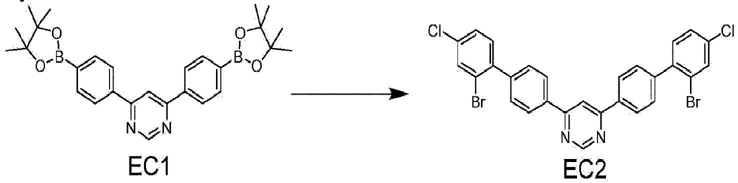

39.2 g (81 mmol) EC1 (2202712-51-2), 54.0 g (170 mmol) 2-Brom-4-chlor-1-iodbenzol, 44.8 g (324 mmol) Kaliumcarbonat und 570 mg (0.81 mmol) Bis(triphenylphosphin)palladium(II)chlorid werden in 600 ml Toluol vorgelegt und bei 80 °C gerührt. Nach 16 h werden 300 mL Wasser zugegeben. Die Phasen werden getrennt und die wässrige Phase mehrmals mit Toluol extrahiert, sowie die organischen Phase mehrmals mit Wasser gewaschen. Die organischen Phasen werden vereint und unter vermindertem Druck eingeengt. Der erhaltene Rückstand wird mehrmals mit heißem Ethanol gerührt. Der erhaltene Feststoff wird mit Toluol über Aluminiumoxid heiß extrahiert. Der ausgefallene Feststoff wird filtriert. Ausbeute: 35.1 g (57.5 mmol) 71 % d. Th..

Analog können folgende Verbindungen aus den entsprechenden Boronestern dargestellt werden:

| | Boronester | Produkt |
|---|---|---|
| EC2b | Int-3 | 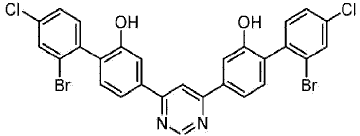 |
| EC2c | Int-3b | 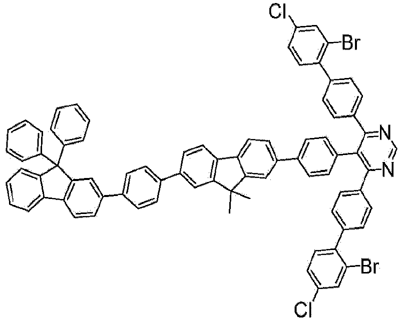 |

### Synthese der Emitter-Grundstruktur Stufe 2

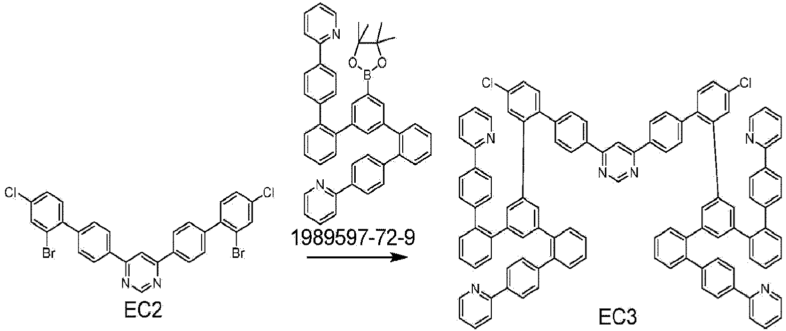

34.6 g (57 mmol) EC2, 78.8 g (118 mmol) 1989597-72-9 und 24 g (226 mmol) Natriumcarbonat werden in 1.2 L THF/Wasser (2:1) suspendiert. Nach Zugabe von 400 mg (0.57 mmol) Pd(amphos)Cl₂ wird das Reaktionsgemisch für 16 h refluxiert. Der beim Abkühlen auf Raumtemperatur ausgefallene Feststoff wird filtriert und mittels mehrmaliger Heißextraktion über Aluminiumoxid (mit Dichlormethan als Eluent) und anschließender Kristallisation aus Dichlormethan/Methanol aufgereinigt. Ausbeute: 52.3 g (34.4 mmol), 61 % d. Th..

Analog können folgende Verbindungen aus den entsprechenden Boronestern dargestellt werden

| | Boronester | Produkt |
|---|---|---|
| EC3b | 2245948-53-0 | 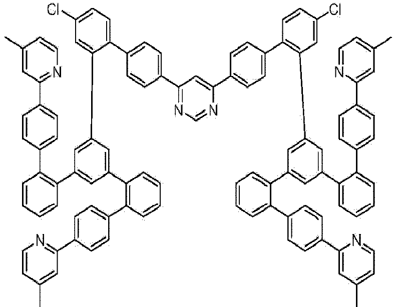 |
| EC3c | 2350247-89-9 | 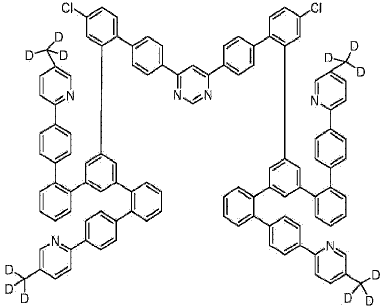 |
| EC3d | 2202718-90-7 | 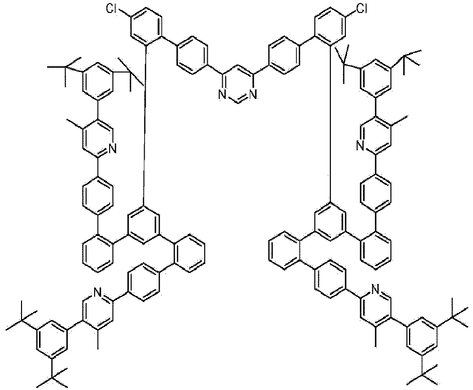 |
| EC3e | 2178101-83-0 | 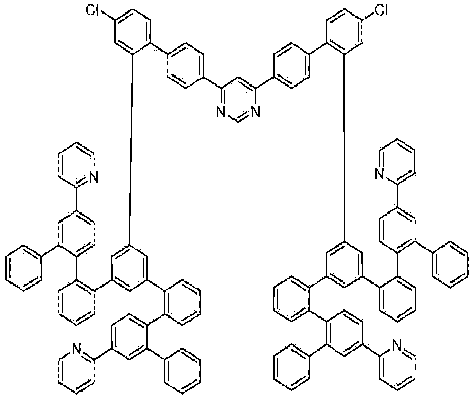 |
| EC3f | 2178101-83-0 | 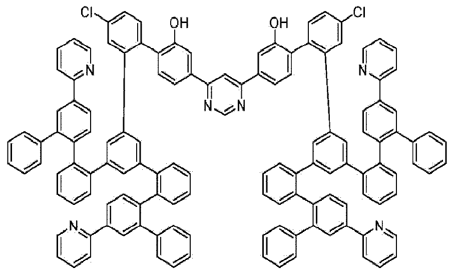 |
| | Bromid: **EC2b** | |
| EC3g | 1989597-72-9 | 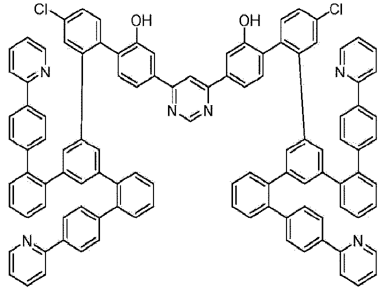 |
| | Bromid: **EC2b** | |
| EC3h | 2178101-83-0 | 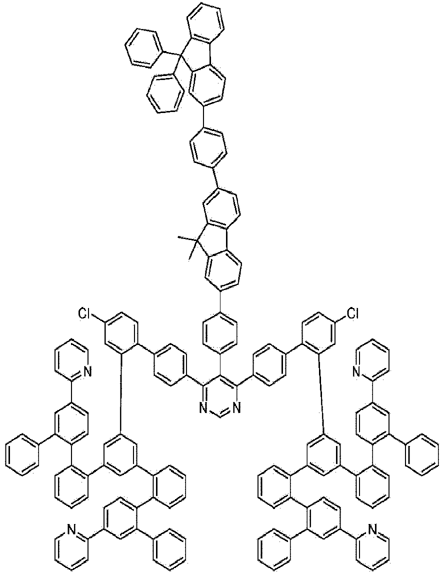 |
| | Bromid: **EC2c** | |

### Synthese des Emittercores Stufe 2-Int

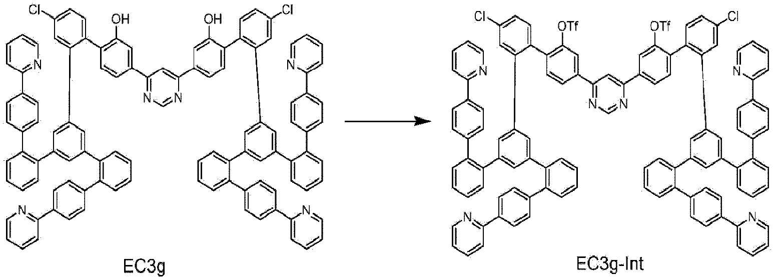

28.2 g (18.1 mmol) EC3g werden in 250 mL Dichlormethan gelöst. Nach Zugabe von 9 mL Pyridin wird die Mischung auf 0 °C gekühlt, und es werden 12 ml (73 mmol) Trifluormethansulfonsäureanhydrid so zugetropft, dass die Temperatur 2 °C nicht überschreitet. Es wird für eine weitere Stunde bei dieser Temperatur gerührt und anschließend bei Raumtemperatur 16 h gerührt. Anschließend wird die Reaktionsmischung auf 600 mL Eis gegossen und für 30 Minuten gerührt. Die Mischung wird in einen Scheidetrichter überführt, und die organische Phase wird mit Dichlormethan erweitert und dreimal mit Wasser gewaschen. Die vereinten wässrigen Phasen werden zweimal mit Dichlormethan extrahiert. Die vereinten organischen Phasen werden über Kieselgel filtriert und mit Ethylacetat nachgewasschen. Nach dem Entfernen der Lösungsmittel am Rotationsverdampfer wird der Rückstand mehrere Male mit 60 °C heißem Ethylacetat ausgerührt. Nach Abkühlen auf Raumtemperatur wird der Feststoff abfiltriert und das Produkt erhalten. Ausbeute 28.1 g (15.4 mmol; 85%).

Analog kann die folgende Verbindung aus dem entsprechenden Boronester dargestellt werden:

| | Edukt | Produkt |
|---|---|---|
| EC3f-Int | **EC3f** | 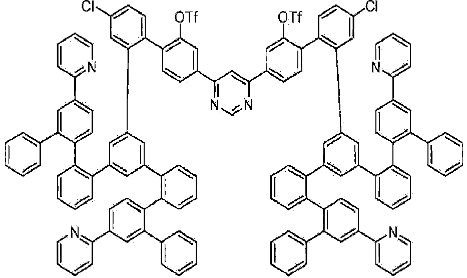 |

### Synthese von EC3i

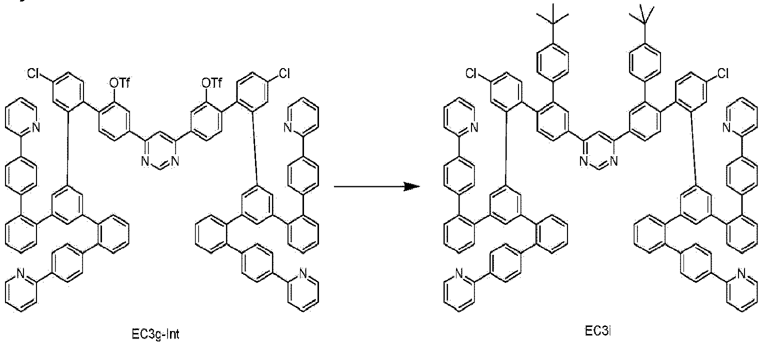

15.5 g (8.5 mmol) EC3g-Int, 6.4 g (34.1 mmol) 4-tert-Butylphenylboronsäure, 4.7 g (34.1 mmol) Kaliumcarbonat, 0.73 g (1.7 mmol) dppb und 0.39 g (0.43 mmol) Tris(dibenzylidenaceton)dipalladium(0) werden in 1000 mL Dioxan/Wasser (3:1) gelöst und 16 h bei 90 °C gerührt. Nach vollständigem Umsatz wird die organische Phase mit Etylacetat erweitert und die Phasen getrennt. Die wässrige Phase wird zweimal mit Ethylacetat extrahiert und die vereinigten organischen Phasen zweimal mit Waser gewaschen, über Magnesiumsulfat getrocknet und über Kieselgel filtriert. Das gewünschte Produkt wird nach säulenchromatographischer Aufreinigung (SiO₂; Toluol/Ethylacetat) erhalten. Ausbeute: 6.1 g (3.4 mmol; 40%).

Analog können folgende Verbindungen aus den entsprechenden Boronestern dargestellt werden:

| | Edukte | Produkt |
|---|---|---|
| EC3j | Triflat: EC3g-Int | 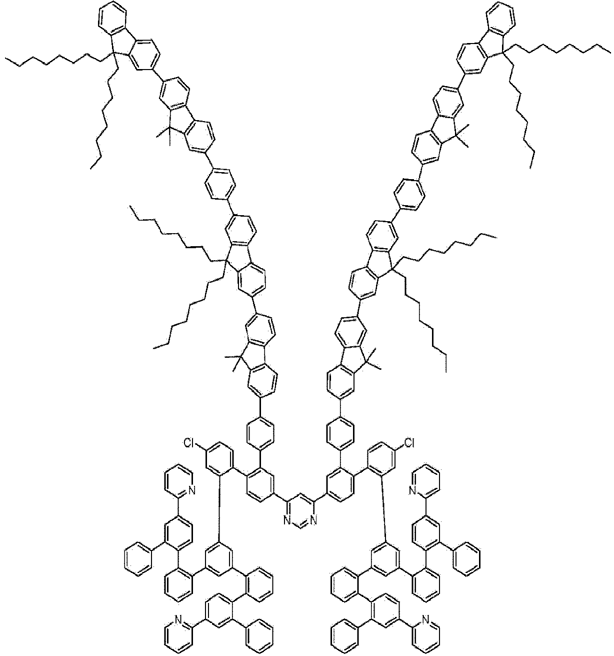 |
| | Boronester: D1 | |
| EC3k | Triflat: EC3f-Int | 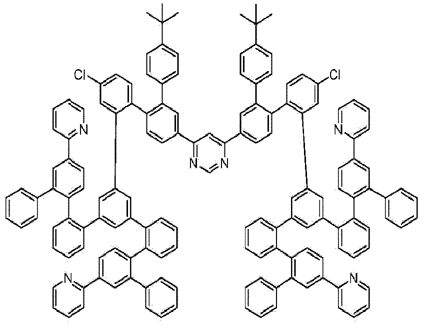 |
| | Boronsäure: 4-tert-Butylphenylboronsäure | |

### Synthese der Emitter-Grundstruktur Stufe 3

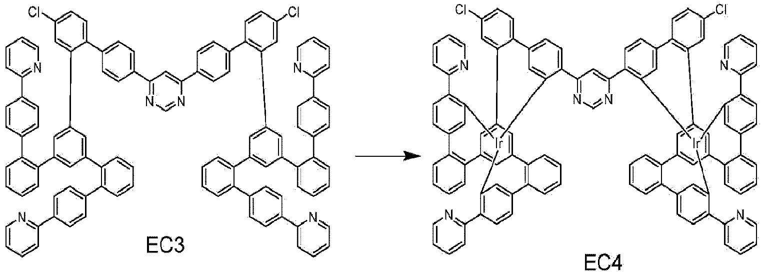

52.3 g (34.4 mmol) EC3, 35 g (71.5 mmol) Tris-(acetylacetonato)-iridium(III) und 523 g Hydrochinon werden vorgelegt und auf 260 °C erhitzt und bei dieser Temperatur für 2 h gerührt. Anschließend wird das Reaktionsgemisch abkühlen gelassen, wobei bei 220 °C 500 ml Ethylenglycol und ab 120 °C 2L Methanol zugetropft werden. Nach Abkühlen auf Raumtemperatur wird der ausgefallene Feststoff über eine Umkehrfritte filtriert. Die diastereomere Metallkomplexmischung enthaltend ΔΔ- und ΛΛ-Isomere (racemisch) sowie ΛΔ-Isomer (meso) im Stoffmengenverhältnis 1:1 (bestimmt durch ¹H-NMR) werden in 300 mL Dichlormethan gelöst, auf 100 g Kieselgel aufgezogen und über eine mit Toluol vorgeschlämmte Kieselgelsäule chromatographisch möglichst unter Lichtausschluss getrennt. Man eluiert zunächst den vorderen Spot, nachfolgend Isomer 1 (11) genannt, und dann das später eluierende Isomer, nachfolgend Isomer 2 (I2) genannt. Und erhält nach Entfernen der Lösungsmittel einen tiefroten Feststoff. Ausbeute: I1: 29 g (15.2 mmol), 45 % d. Th.; I2: 24.3 g (12.7 mmol), 37 % d. Th..

Die nachfolgend gezeigten Metallkomplexe können prinzipiell durch Chromatographie (typischerweise Verwendung eines Säulenautomaten (Torrent der Firma Axel Semrau), Umkristallisation oder Heißextraktion gereinigt werden. Im Folgenden aufgeführte Abbildungen von Komplexen zeigen üblicherweise nur ein Isomer, Die Isomerenmischung kann aufgetrennt werden, kann aber auch als Isomerengemisch in der OLED eingesetzt werden. Es gibt jedoch auch Ligandensysteme, bei denen sich aus sterischen Gründen lediglich ein Diastereomerenpaar bildet.

Analog können folgende Verbindungen synthetisiert werden. Die chromatographische Trennung der üblicherweise anfallenden Diastereomerenmischung erfolgt an Flash-Kieselgel auf einem Säulenautomaten (Torrent der Firma Axel Semrau):

| | Edukt | Produkt |
|---|---|---|
| EC4b | EC3b | 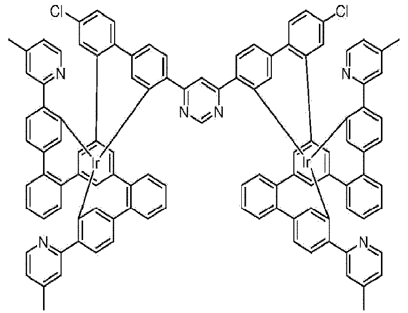 |
| EC4c | EC3c | 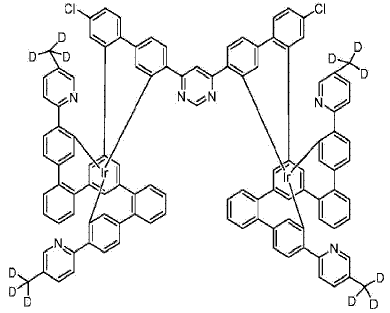 |
| EC4d | EC3d | 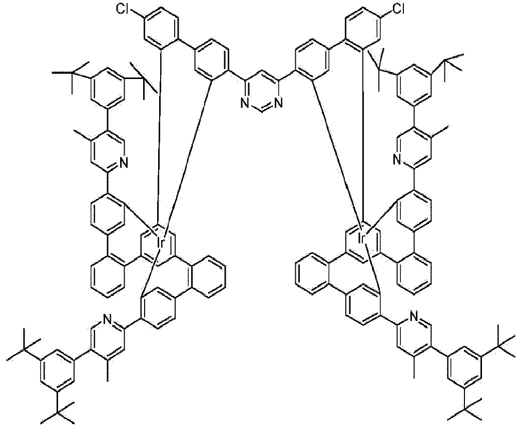 |
| EC4e | EC3e | 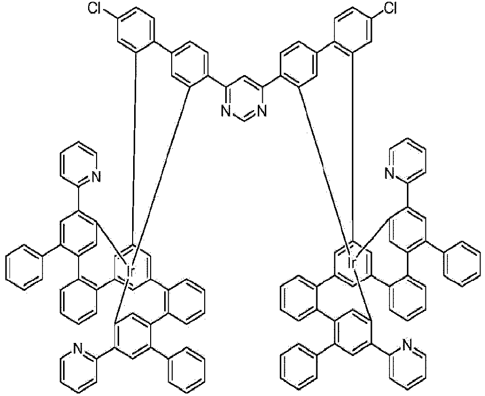 |
| EC4f | EC3h | 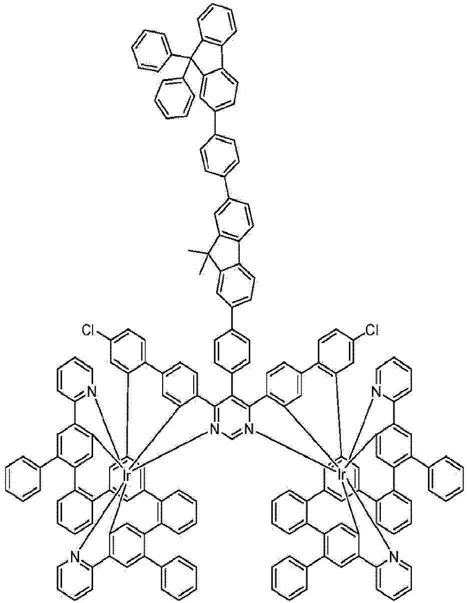 |
| EC4g | EC3k | 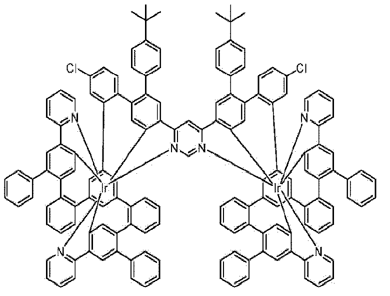 |
| EC4h | EC3j | 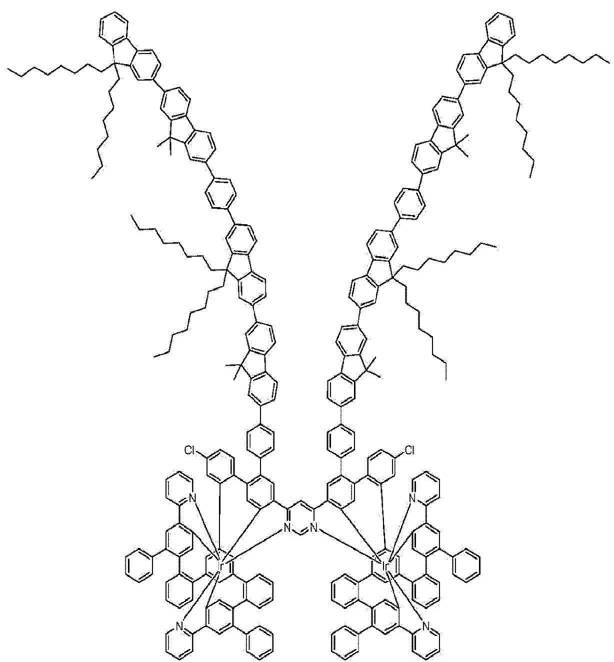 |
| EC4i | EC3i | 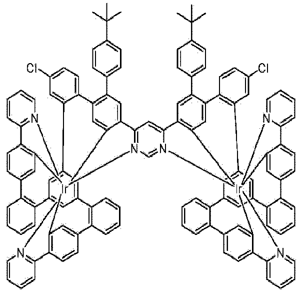 |

### Synthese der Emitter-Grundstruktur Stufe 4

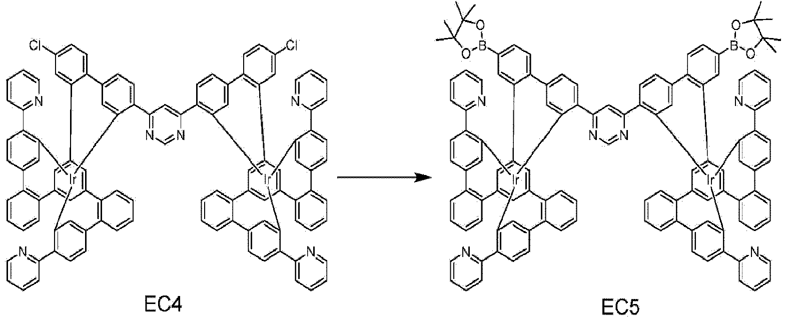

11.7 g (6.2 mmol) EC4, 3.3 g (13 mmol) Bis-(pinacolato)-diboron, 2.4 g (25 mmol) Kaliumacetat und 453 mg (0.61 mmol) trans-Dichlorobis(tricylo-hexylphosphin)palladium(II) werden in 600 mL Dioxan vorgelegt und 16 h refluxiert. Nach Abkühlen auf Raumtemperatur werden 400 mL Wasser zugegeben, anschließend mehrmals mit Dichlormethan extrahiert, und die vereinten organischen Phasen werden mehrmals mit Wasser extrahiert. Die organische Phase wird anschließend über Kieselgel (Dichlormethan) filtriert und unter vermindertem Druck eingeengt. Der erhaltene Rückstand wird aus Dichlormethan/Methanol kristallisiert. Ausbeute 12.8 g (6.1 mmol), 98 % d. Th..

Analog können folgende Verbindungen dargestellt werden:

| | Edukt | Produkt |
|---|---|---|
| EC5b | EC4b | 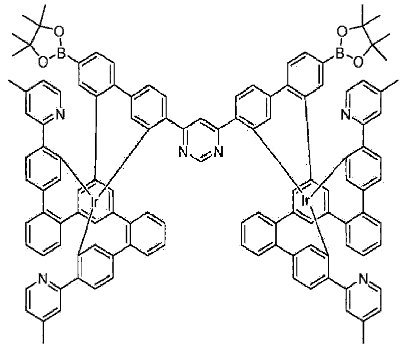 |
| EC5c | EC4c | 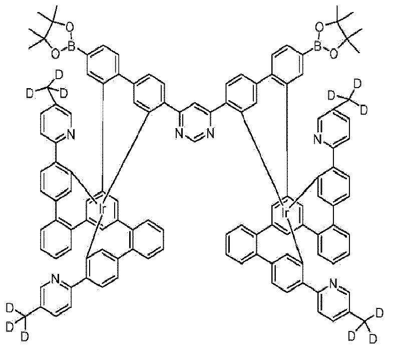 |
| EC5d | EC4d | 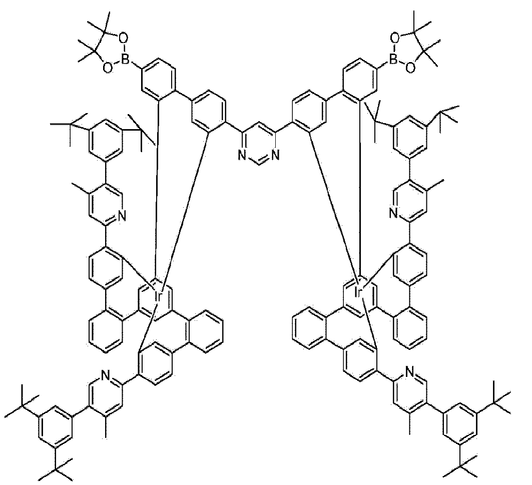 |
| EC5e | EC4e | 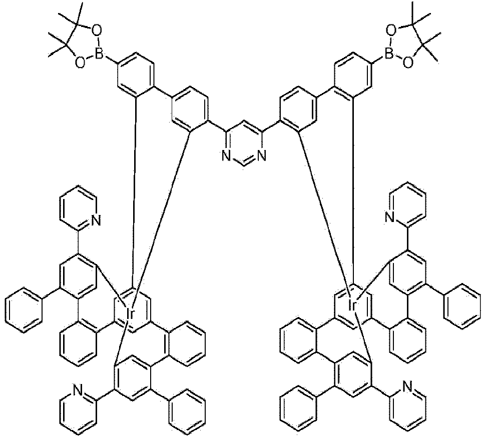 |
| EC5f | EC4f | 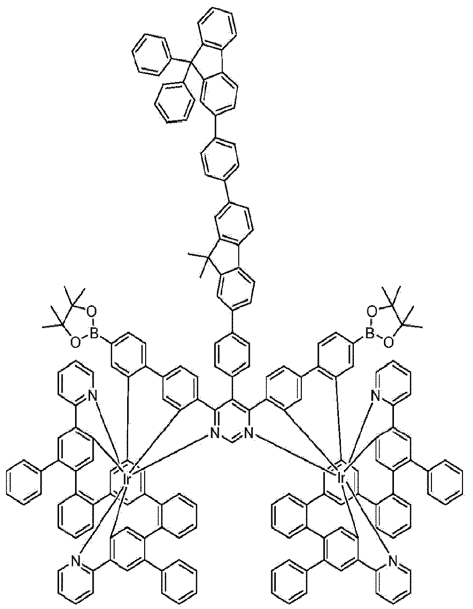 |
| EC5g | EC4g | 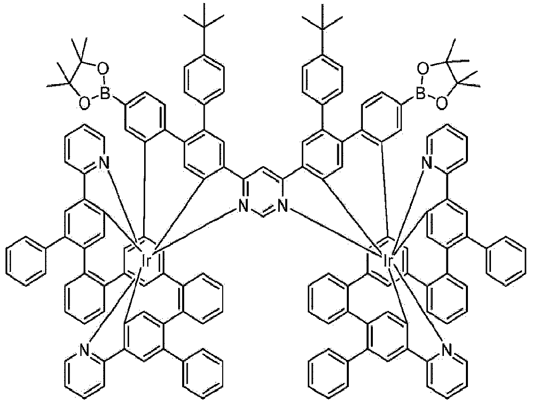 |
| EC5h | EC4h | 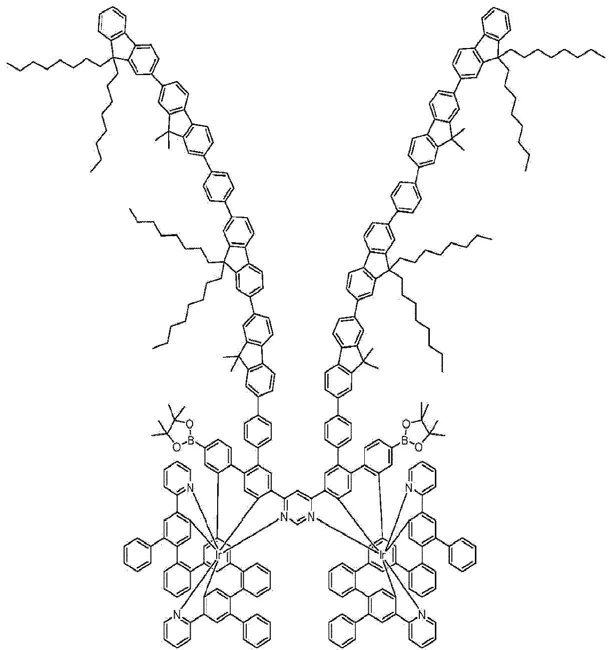 |
| EC5i | EC4i | 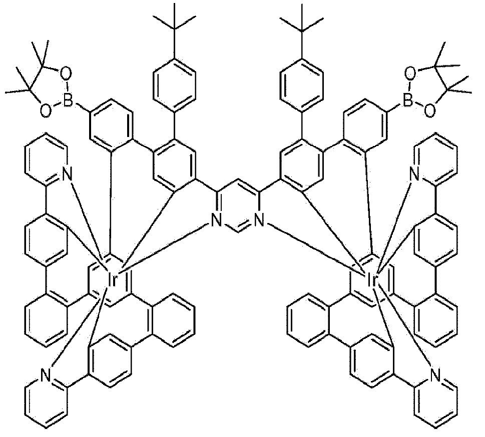 |

### Synthese des Emitters Em1

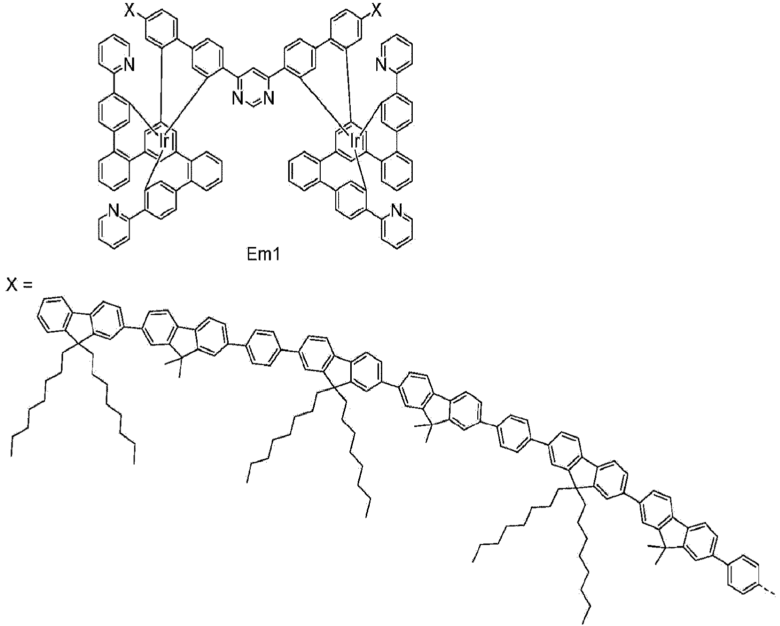

2.7 g (1.3 mmol) EC5, 5.3 g (2.6 mmol) E1, 0.79 g (5.2 mmol) Caesiumfluorid, 97 mg (0.13 mmol) trans-Dichlorobis(tricylohexylphosphin)-palladium(II) werden in 80 mL Dioxan gelöst und 16 h refluxiert. Das Reaktionsgemisch wird nach Abkühlen auf Raumtemperatur mit Dichlormethan und Wasser versetzt und die organische Phase abgetrennt. Die wässrige Phase wird zweimal mit Dichlormethan extrahiert, und die vereinten organischen Phasen werden mit Wasser extrahiert und anschließend unter vermindertem Druck eingeengt. Der Rückstand wird mehrmals chromatographisch aufgereinigt (SiO₂, Heptan/Dichlormethan) und anschließend nochmals aus Dichlormethan/Methanol kristallisiert. Der erhaltene Feststoff wird unter vermindertem Druck bei 200 °C getrocknet. Ausbeute: 2.7 g (0.47 mmol), 36% d. Th..

Analog können folgende Verbindungen dargestellt werden:

| Edukt A | Edukt B |
|---|---|
| EC5b | E1 |
| 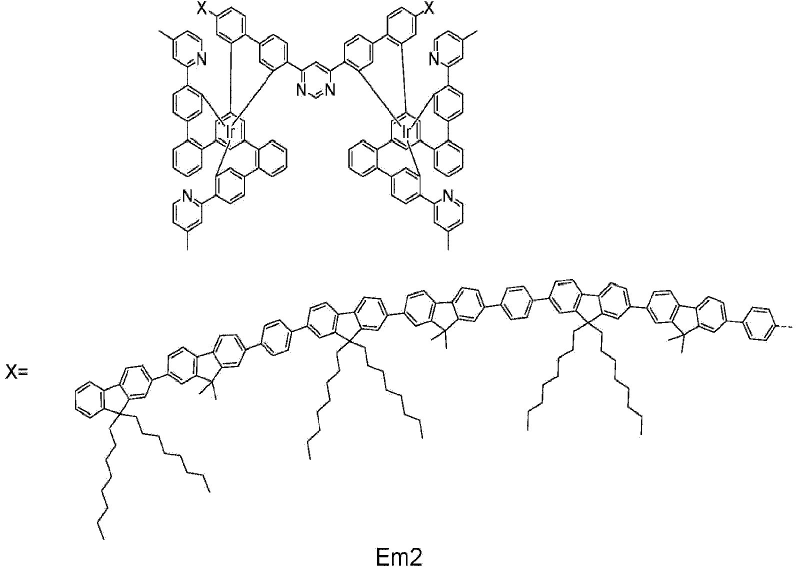 | |
| EC5c | E1 |
| 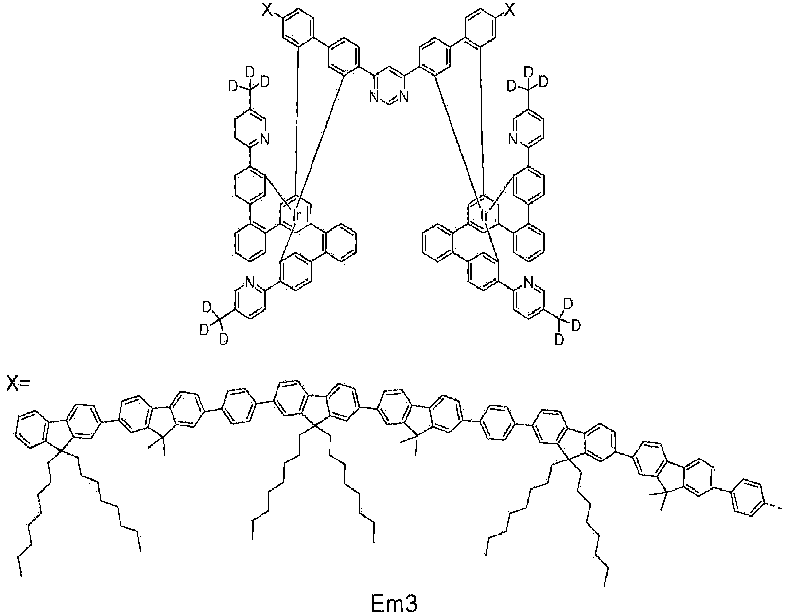 | |
| EC5d | E1 |
| 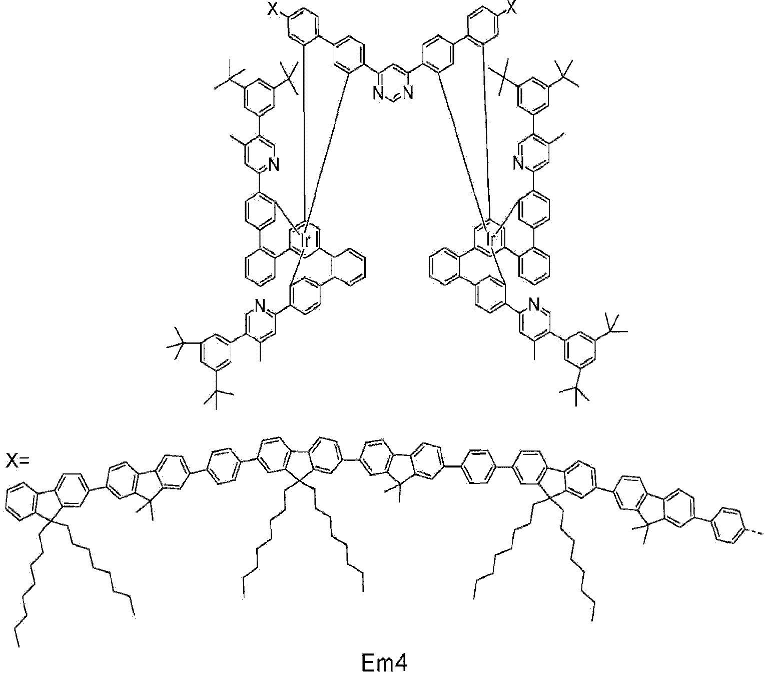 | |
| EC5e | E1 |
| 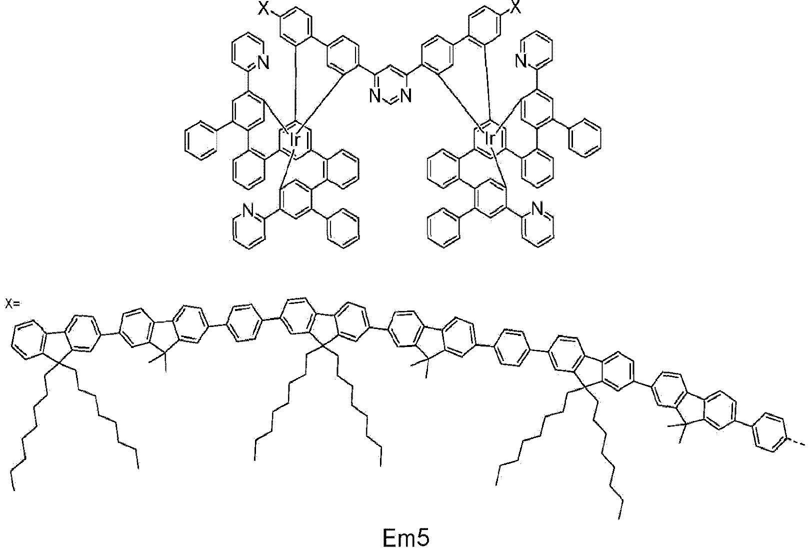 | |
| EC5a | E7 |
| 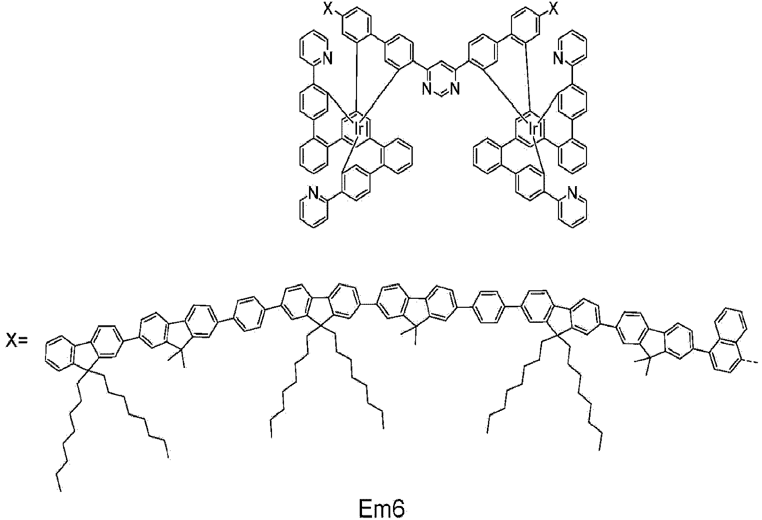 | |
| EC5a | B7 |
| 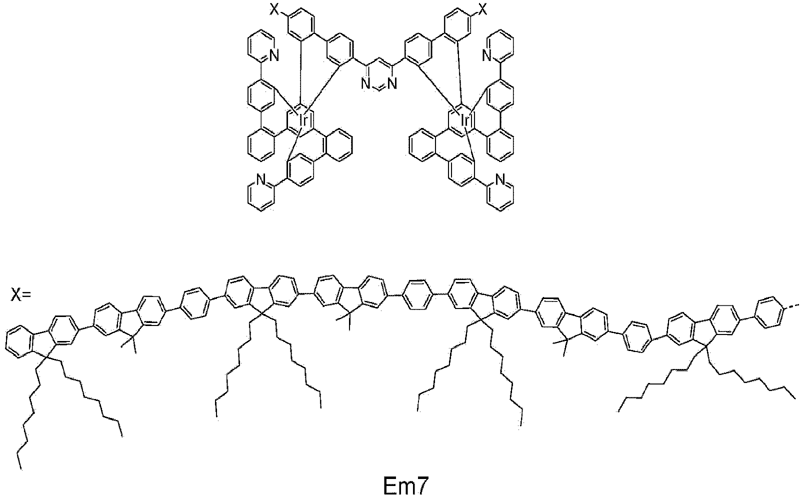 | |
| EC5a | 2179264-15-2 |
| 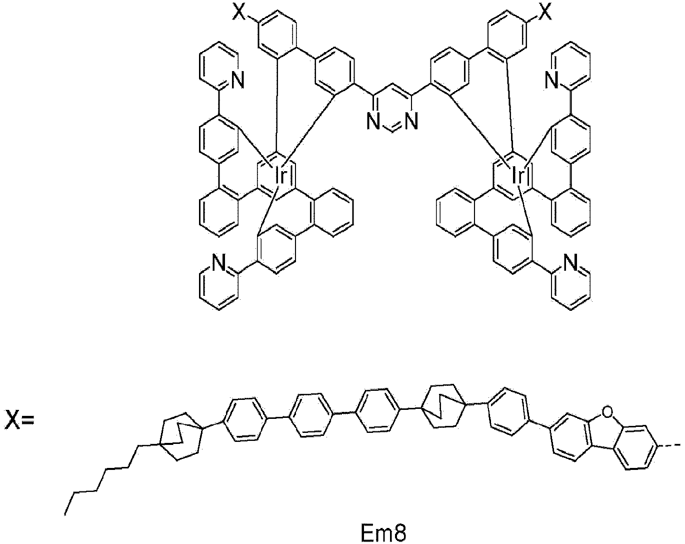 | |
| EC5a | E15 |
| 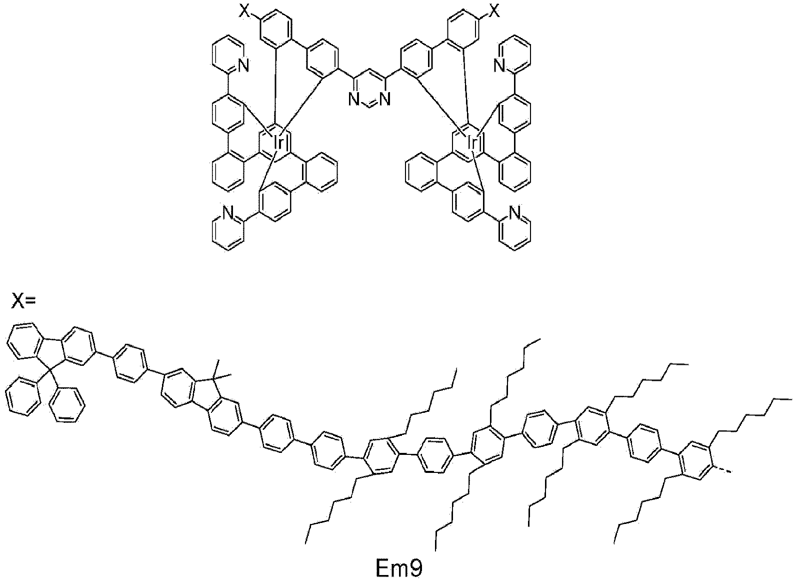 | |
| EC5a | E16 |
| 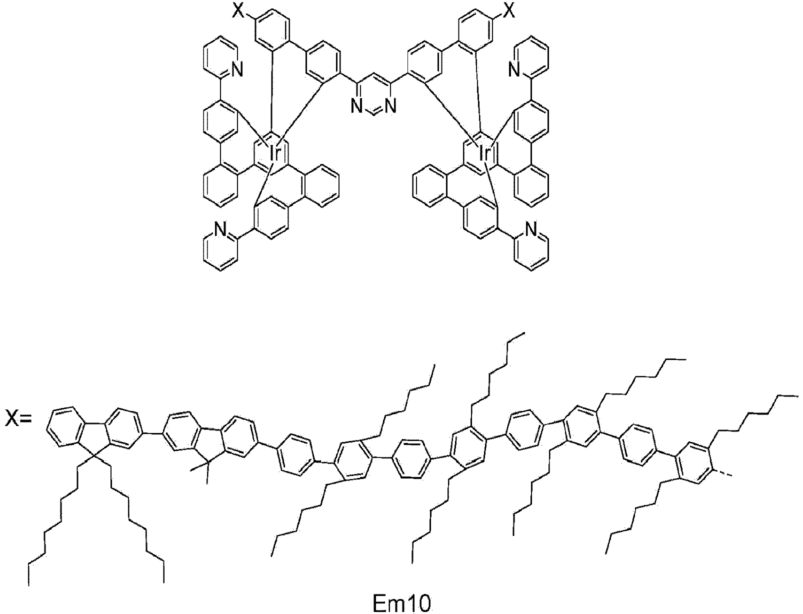 | |
| EC5a | E17 |
| 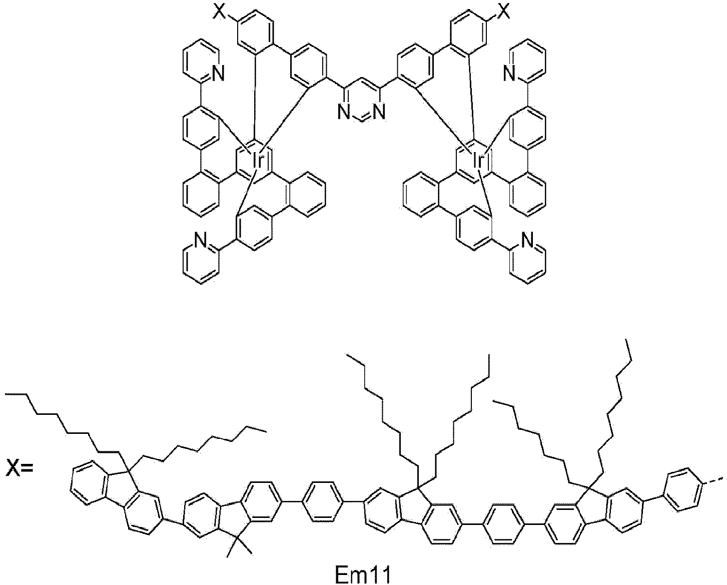 | |
| EC5a | E18 |
| 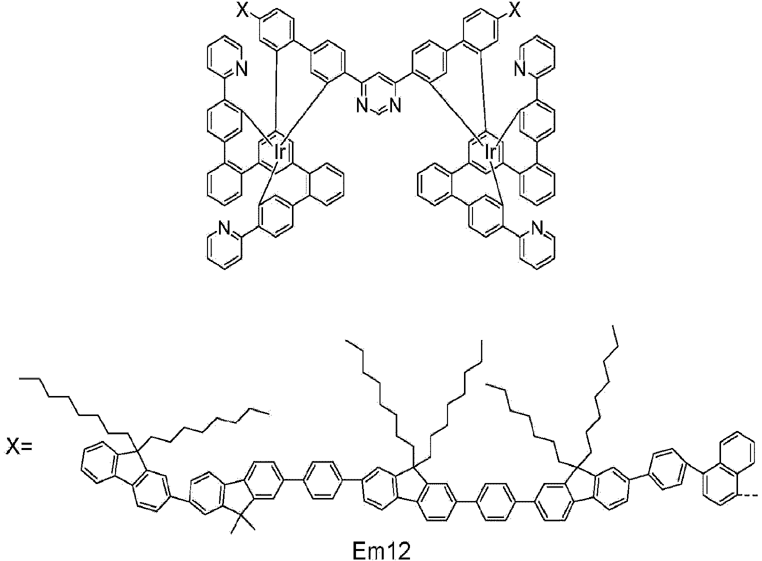 | |
| E19 | EC5a |
| 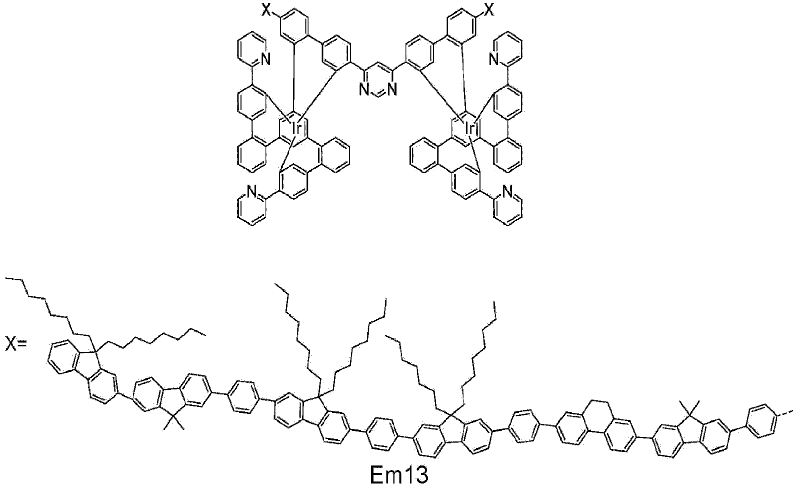 | |
| E20 | EC5a |
| 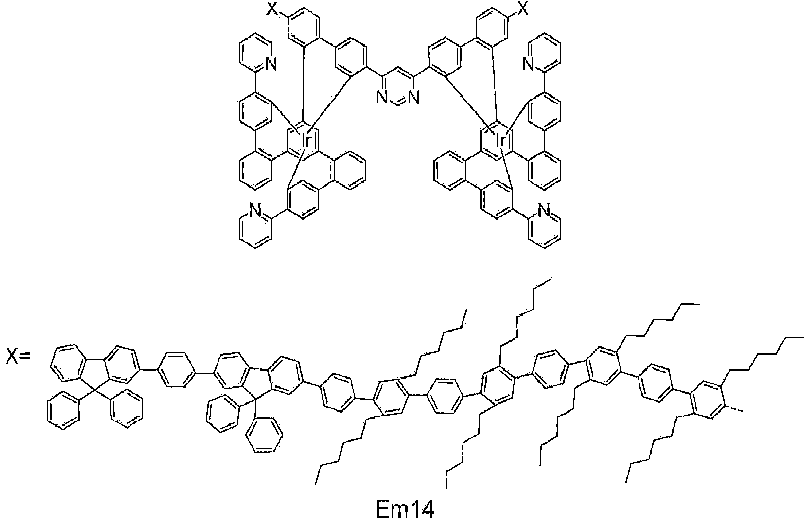 | |
| EC5e | E21 |
| 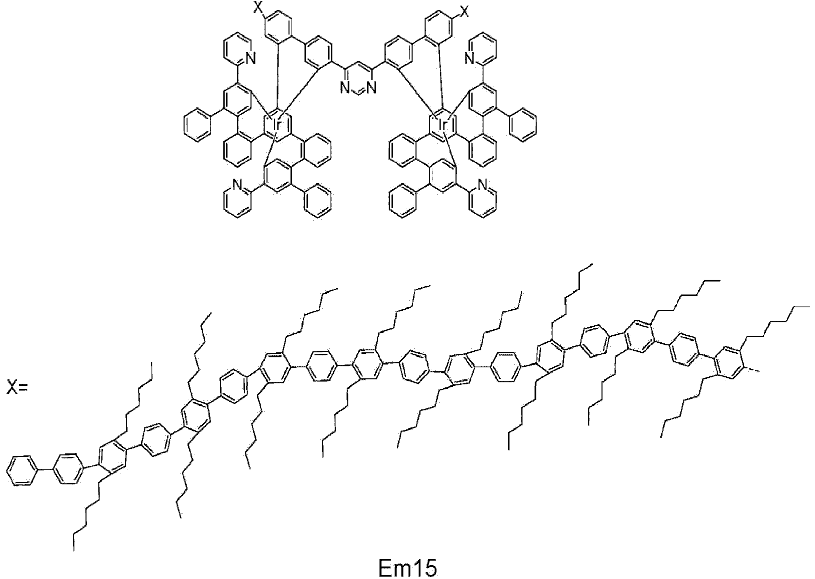 | |
| EC5e | E22 |
| 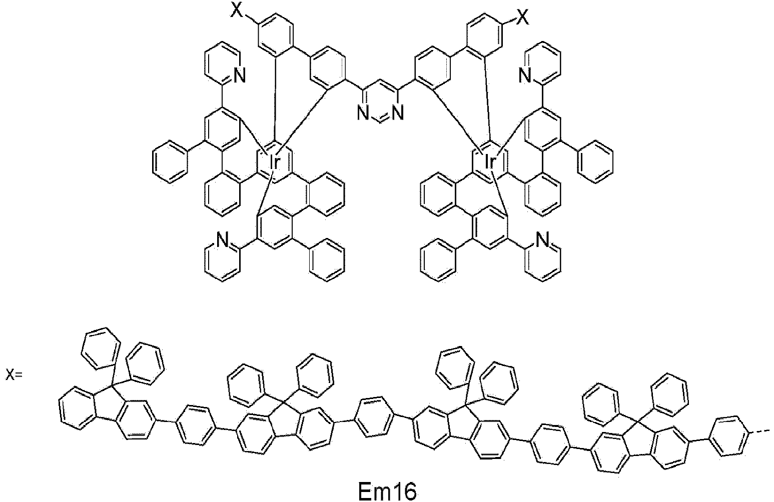 | |
| EC5a | E23 |
| 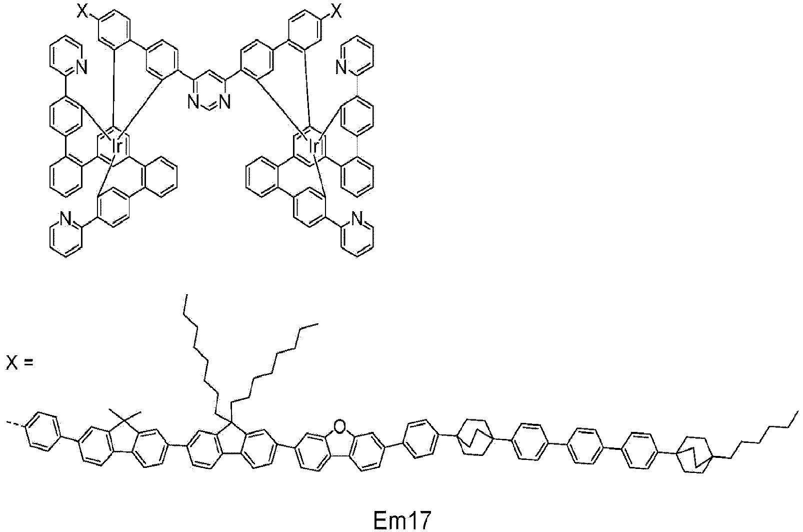 | |
| E20 | EC5g |
| 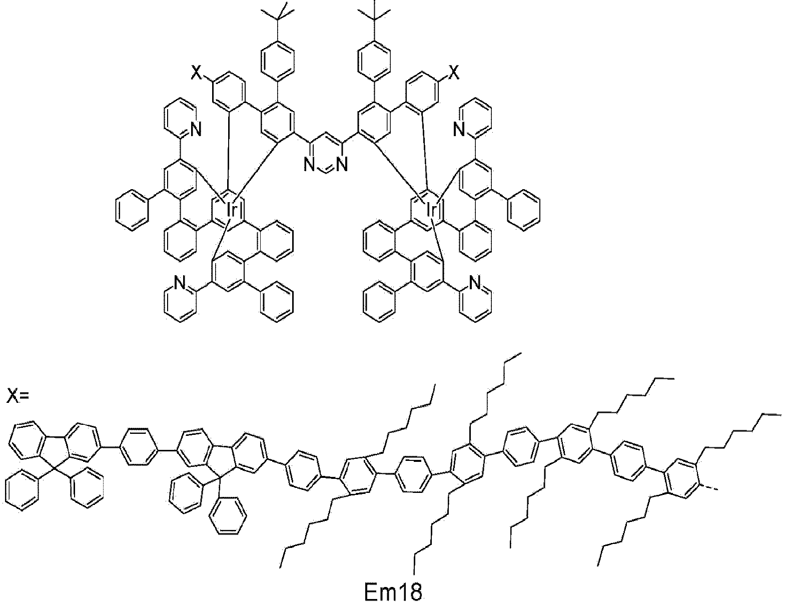 | |
| C1 | EC5h |
| 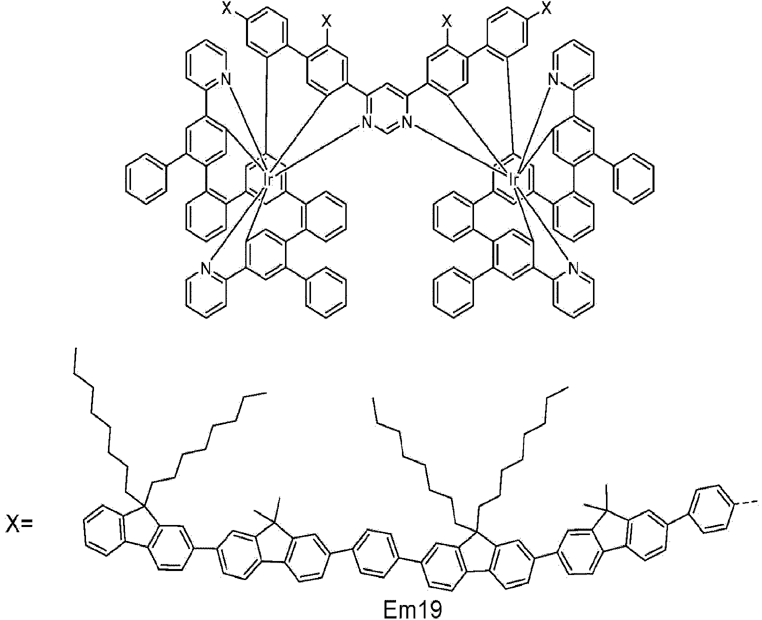 | |
| E1 | EC5h |
| 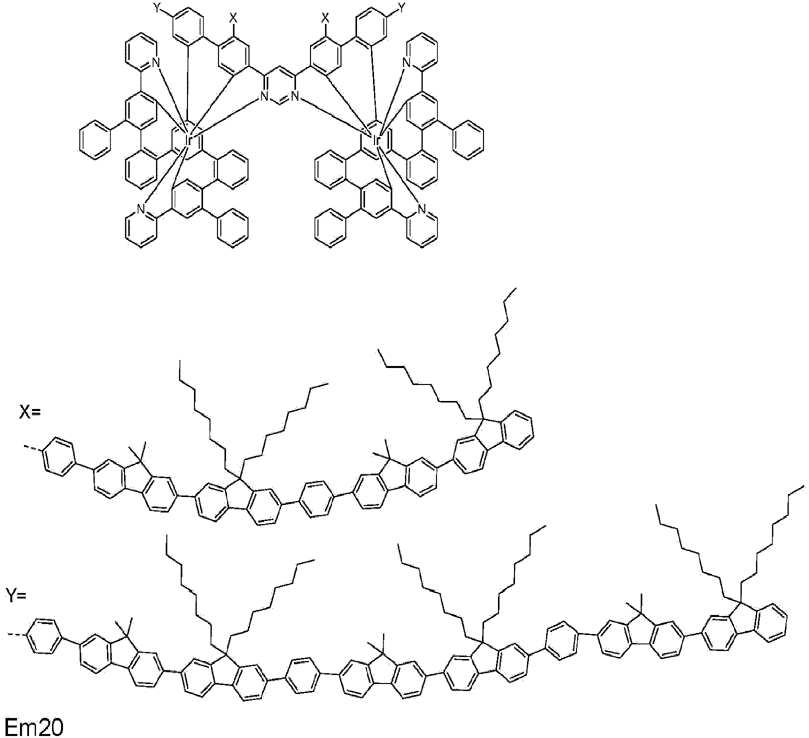 | |
| E1 | EC5f |
| 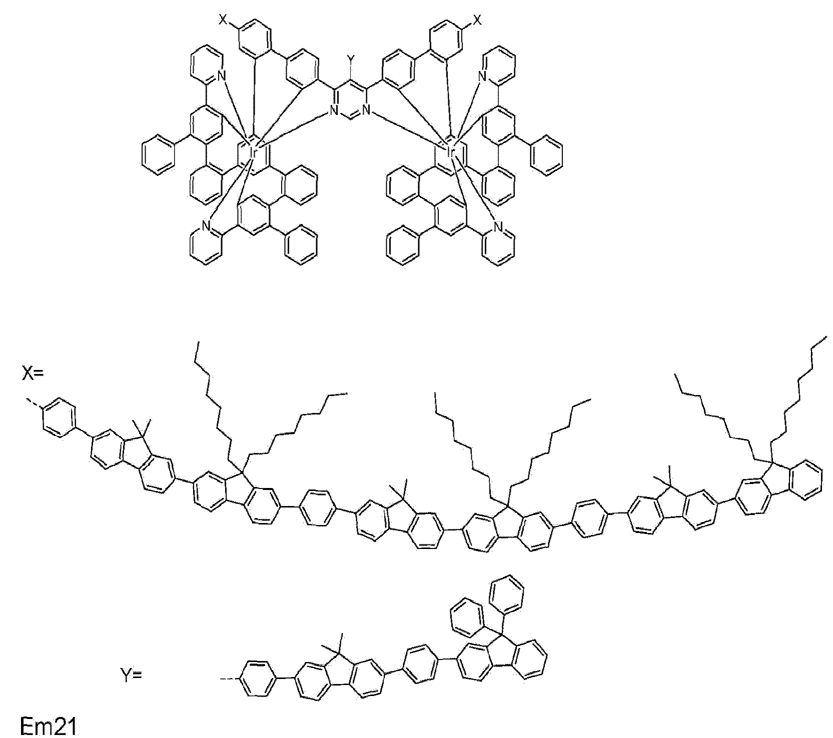 | |
| E1 | EC5i |
| 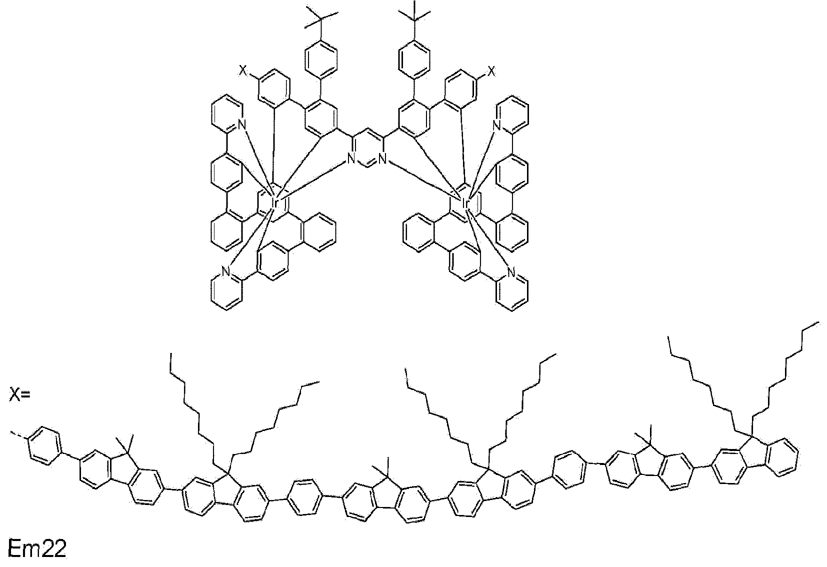 | |

### Physik-Beispiele

### Herstellung der OLEDs und der Filme für die photophysikalische Charakterisierung

Die erfindungsgemäßen Komplexe können aus Lösung verarbeitet werden. Die Herstellung vollständig lösungsbasierter OLEDs ist in der Literatur bereits vielfach beschrieben, z. B. in WO 2004/037887 mittels SpinCoating. Die Herstellung vakuumbasierter OLEDs ist ebenfalls vielfach vorbeschrieben, u.a. in WO 2004/058911. In den im Folgenden diskutierten Beispielen werden lösungsbasiert und vakuumbasiert aufgebrachte Schichten innerhalb einer OLED kombiniert, so dass die Prozessierung bis einschließlich zur Emissionsschicht aus Lösung und in den darauffolgenden Schichten (Lochblockierschicht und Elektronentransportschicht) aus dem Vakuum erfolgt. Die vorbeschriebenen allgemeinen Verfahren werden dafür wie im Folgenden beschrieben auf die hier beschriebenen Gegebenheiten (Schichtdickenvariation, Materialien) angepasst und kombiniert. Der generelle Aufbau ist wie folgt: Substrat / ITO (50 nm) / Lochinjektionsschicht (HIL) (60 nm) / Lochtransportschicht (HTL) (20 nm) / Emissionsschicht (EML) (60 nm) / Lochblockierschicht (HBL) (10 nm) / Elektronentransportschicht (ETL) (40 nm) / Kathode (Aluminium, 100 nm). Als Substrat dienen Glasplättchen, die mit strukturiertem ITO (Indium Zinn Oxid) der Dicke 50 nm beschichtet sind. Zur besseren Prozessierung werden diese mit PEDOT:PSS beschichtet (Poly(3,4-ethylendioxy-2,5-thiophen) : Polystyrolsulfonat, bezogen von Heraeus Precious Metals GmbH & Co. KG, Deutschland). PEDOT:PSS wird an Luft aus Wasser aufgeschleudert und nachfolgend an Luft bei 180 °C für 10 Minuten ausgeheizt, um Restwasser zu entfernen. Auf diese beschichteten Glasplättchen werden die Lochtransportschicht sowie die Emissionsschicht aufgebracht. Die verwendete Lochtransportschicht ist vernetzbar. Es wird ein Polymer gemäß der nachfolgend abgebildeten Struktur verwendet, das gemäß WO 2013/156130 synthetisiert werden kann:

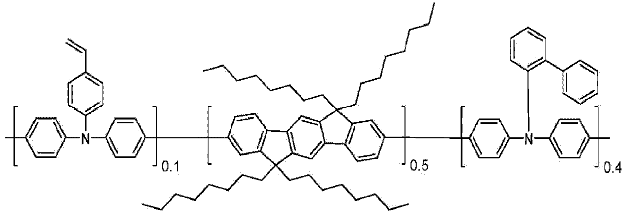

Das Lochtransport-Polymer wird in Toluol gelöst. Der typische Feststoffgehalt solcher Lösungen liegt bei ca. 5 g/l, wenn, wie hier, die für eine Device typische Schichtdicke von 20 nm mittels Spincoating erzielt werden soll. Die Schichten werden in einer Inertgasatmosphäre, im vorliegenden Fall Argon, aufgeschleudert und 30 Minuten bei 220 °C ausgeheizt.

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin können Mischungen aus mehreren Matrixmaterialien sowie Co-Dotanden verwendet werden. Eine Angabe wie TMM-A (92%) : Dotand (8%) bedeutet hierbei, dass das Material TMM-A in einem Gewichtsanteil von 92% und Dotand in einem Gewichtsanteil von 8% in der Emissionsschicht vorliegt. Die Mischung für die Emissionsschicht wird in Toluol oder ggf. Chlorbenzol gelöst. Der typische Feststoffgehalt solcher Lösungen liegt bei ca. 17 g/l, wenn, wie hier, die für eine Device typische Schichtdicke von 60 nm mittels Spincoating erzielt werden soll. Die Schichten werden in einer Inertgasatmosphäre, im vorliegenden Fall Argon, aufgeschleudert und 10 Minuten bei 160 °C ausgeheizt. Die im vorliegenden Fall verwendeten Materialien sind in Tabelle 1 gezeigt.

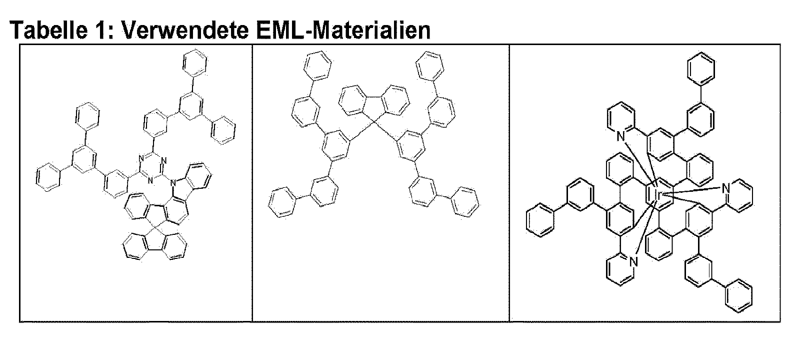

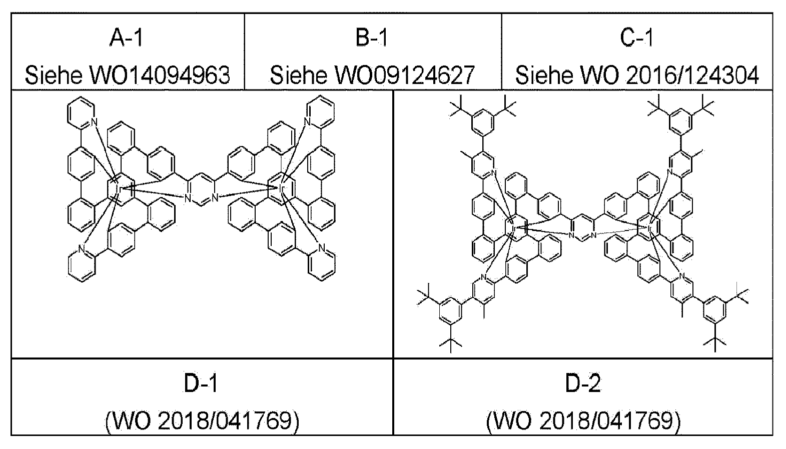

Die Materialien für die Lochblockierschicht und Elektronentransportschicht werden in einer Vakuumkammer thermisch aufgedampft. Dabei kann z. B. die Elektronentransportschicht aus mehr als einem Material bestehen, die einander durch Co-Verdampfung in einem bestimmten Volumenanteil beigemischt werden. Eine Angabe wie ETM1:ETM2 (50%:50%) bedeutet hierbei, dass die Materialien ETM1 und ETM2 in einem Volumenanteil von je 50% in der Schicht vorliegen. Die im vorliegenden Fall verwendeten Materialien sind in Tabelle 2 gezeigt. In den hier beschriebenen OLED-Bauteilen wurde ETM3 als HBL-Material verwendet und ETM1:ETM2 (50:50) als ETL-Mischung.

**Tabelle 2: Verwendete HBL- und ETL-Materialien**

| | | |
|---|---|---|
| 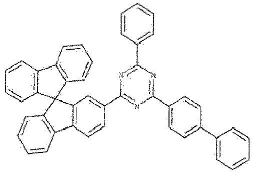 | 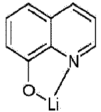 | 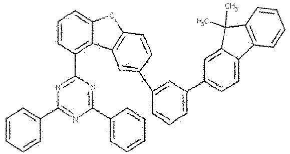 |
| ETM1 | ETM2 | ETM3 |
| [1819335-36-8] | [25387-93-3] | [2392900-45-5] |

Die Kathode wird durch die thermische Verdampfung einer 100 nm Aluminiumschicht gebildet. Die Proben werden verkapselt.

Filme für die photophysikalische Charakterisierung werden gemäß des oben für Emissionsschichten beschriebenen Prozesses als Einzelschicht auf Quarzglas-Substraten hergestellt. Dabei wird B1 als Hostmaterial verwendet, und es werden 30 nm dicke Filme hergestellt. Die Proben werden verkapselt.

### Charakterisierung:

### Messung der Emitterorientierung im lösungsprozessierten Film

Im Messaufbau wird der lösungsprozessierte Film, der den Komplex enthält, mit einem Laser bestrahlt, die Moleküle angeregt und dann winkelabhängig das emittierte Photolumineszenzspektrum gemessen. Aus den gemessenen optischen Eigenschaften des puren Matrixmaterials kann unter Anwendung von optisch-physikalischen Gesetzen ein Ergebnis für eine potenzielle 100%ige horizontale sowie 100%ige vertikale Orientierung der Moleküle berechnet werden. Anschließend werden die Messwerte an die berechneten Extremorientierungen angefittet und so der Orientierungsfaktor (optische Orientierungsanisotropie) bestimmt. Eine perfekte horizontale Orientierung der Moleküle wird beschrieben durch Θ = 0, der isotrope Fall durch Θ = 0.33 und der komplett vertikal ausgerichtete Fall mit Θ = 1. Dieser Wert spiegelt die gemittelte Orientierung über alle Moleküle in der Schicht wieder, die durch den Photolumineszenzprozess angeregt wurden, also alle Komplexmoleküle, die innerhalb des Messflecks, der durch den Laser bestrahlt wurde, liegen. Die Bestimmung der Orientierung eines einzelnen Moleküls ist mit dieser Methode nicht möglich. Frischeisen et al., Applied Physics Letters 96, 073302 (2010) sowie Schmidt et al., Phys. Rev. Appl. 8, 037001 (2017) beschreiben die Durchführung solcher optischer Messungen zur Bestimmung der Emitterorientierung.

Tabelle 3 fasst die optische Orientierung des Vergleichsmaterials und die ausgewählter erfindungsgemäßer Materialien zusammen. Die erfindungsgemäßen Komplexe werden in etwas höheren Gew-% eingesetzt, um das höhere Molekulargewicht zu kompensieren. Es zeigt sich, dass die beiden Vergleichskomplexe eine isotrope Anordnung im Film aufweisen, während erfindungsgemäße Komplexe eher horizontal ausgerichtet sind.

**Tabelle 3: Optische Orientierungsanisotropie Θ**

| | Komplex | % in host B1 | Θ |
|---|---|---|---|
| V1 | D1 | 10 | 0.33 |
| E1 | Em1 | 15 | 0.26 |
| V2 | D2 | 10 | 0.33 |
| E2 | Em4 | 15 | 0.26 |
| E3 | Em5 | 15 | 0.26 |
| E4 | Em8 | 15 | 0.29 |
| E5 | Em16 | 15 | 0.27 |
| E6 | Em13 | 15 | 0.26 |
| E7 | Em12 | 15 | 0.28 |
| E8 | Em6 | 15 | 0.26 |
| E9 | Em11 | 15 | 0.28 |
| E10 | Em15 | 15 | 0.25 |
| E11 | Em10 | 15 | 0.28 |
| E12 | Em7 | 15 | 0.24 |
| E13 | Em14 | 15 | 0.27 |
| E14 | Em2 | 15 | 0.26 |
| E15 | Em3 | 15 | 0.26 |
| E16 | Em9 | 15 | 0.26 |
| E17 | Em17 | 15 | 0.27 |
| E30 | Em18 | 15 | 0.27 |
| E31 | Em19 | 15 | 0.28 |
| E32 | Em20 | 15 | 0.25 |
| E33 | Em21 | 15 | 0.26 |
| E34 | Em22 | 15 | 0.26 |

### OLED-Bauteile:

Die OLEDs werden standardmäßig charakterisiert. Hierfür werden die Elektrolumineszenzspektren sowie die Strom-Spannungs-Leuchtdichte-Kennlinien (IUL-Kennlinien) unter Annahme einer Lambert'schen Abstrahlcharakteristik bestimmt und die externe Quanteneffizienz bei einer bestimmten Helligkeit als Kennzahl berechnet.

Alle untersuchten Bauteile leuchten rot. Die verwendeten EML-Mischungen und erzielten Ergebnisse sind in Tabelle 4 zusammengefasst. Die erfindungsgemäßen Komplexe werden in etwas höheren Gew.-% eingesetzt, um das höhere Molekulargewicht zu kompensieren. Es zeigt sich, dass erfindungsgemäße Komplexe mit ihrer eher horizontalen Ausrichtung eine deutlich erhöhte Quanteneffizienz im OLED-Bauteil erreichen. Insbesondere zeigt sich, dass im Direktvergleich bei gleichem Hilfsliganden (D2 im Vergleich zu Em4; D1 im Vergleich zu Em1, Em13, Em12, Em7, Em14, Em9 und Em17) die erfindungsgemäßen Substituenten zu einer Erhöhung der Quanteneffizienz führen.

Alle oben aufgeführten erfindungsgemäßen Komplexe können analog eingesetzt werden und führen zu vergleichbaren Ergebnissen.

**Tabelle 4: Ergebnisse lösungsprozessierter OLEDs (bei einer Helligkeit von 1000 cd/m² gemessen)**

| Bsp. | Emitter | EQE [%] | Mischungsverhältnis A1:B1:C1:Emitter |
|---|---|---|---|
| V3 | D1 | 18.7 | 40:35:17:8 |
| E18 | Em1 | 26.1 | 40:33:17:10 |
| V4 | D2 | 21.8 | 40:35:17:8 |
| E19 | Em4 | 26.5 | 40:33:17:10 |
| E20 | Em5 | 26.2 | 40:33:17:10 |
| E21 | Em13 | 25.9 | 40:33:17:10 |
| E22 | Em12 | 23.2 | 40:33:17:10 |
| E23 | Em15 | 26.3 | 40:33:17:10 |
| E24 | Em7 | 26.5 | 40:33:17:10 |
| E25 | Em14 | 23.9 | 40:33:17:10 |
| E26 | Em2 | 25.7 | 40:33:17:10 |
| E27 | Em3 | 26.0 | 40:33:17:10 |
| E28 | Em9 | 26.0 | 40:33:17:10 |
| E29 | Em17 | 24.1 | 40:33:17:10 |
| E35 | Em18 | 24.2 | 40:33:17:10 |
| E36 | Em19 | 23.4 | 40:33:17:10 |
| E37 | Em20 | 26.4 | 40:33:17:10 |
| E38 | Em22 | 26.2 | 40:33:17:10 |

## Patentansprüche

1. Verbindung gemäß Formel (1), 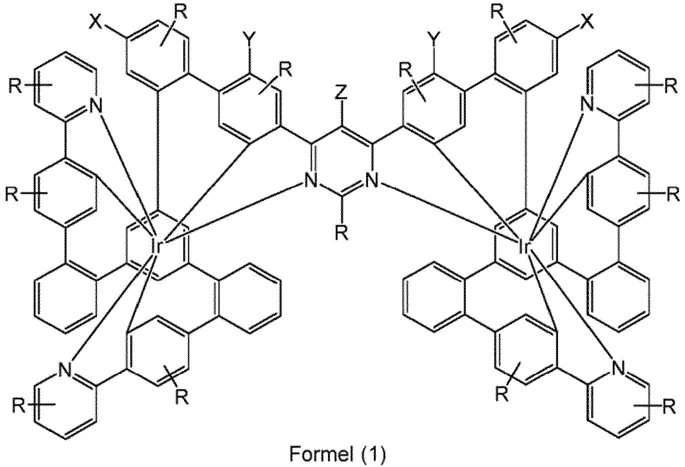 wobei für die verwendeten Symbole und Indizes gilt:
X ist bei jedem Auftreten gleich oder verschieden eine Gruppe der Formel -(Ar)ₙ-R;
Y ist bei jedem Auftreten gleich oder verschieden R oder X;
Z ist gleich oder verschieden R oder X;
Ar ist bei jedem Auftreten gleich oder verschieden eine bivalente Gruppe, welche ausgewählt ist aus den Strukturen (Ar1) bis (Ar7), 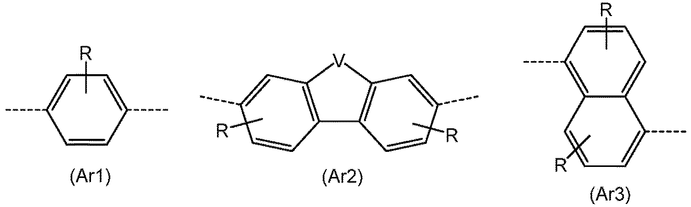 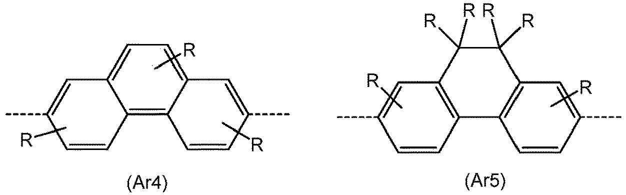 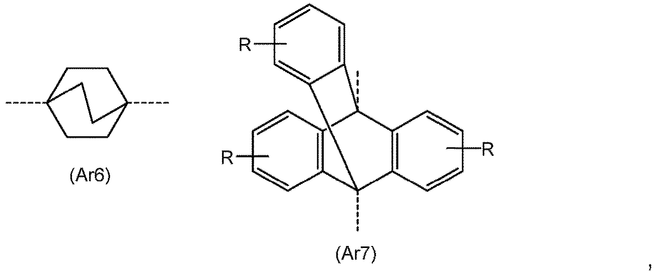 wobei die gestrichelte Bindung die Verknüpfung der Einheiten darstellt und V für CR₂, O, S oder NR steht;
n ist bei jedem Auftreten gleich oder verschieden eine ganze Zahl von 3 bis 20 mit der Maßgabe, dass in jeder Einheit -(Ar)ₙ-R mindestens 5 Phenyl- und/oder Cyclohexylgruppen linear miteinander verknüpft sind, wobei die Strukturen (Ar1) und (Ar3) jeweils eine Phenylgruppe, die Strukturen (Ar2), (Ar4) und (Ar5) jeweils zwei Phenylgruppen, und die Strukturen (Ar6) und (Ar7) jeweils eine Cyclohexangruppe beitragen;
R kann jeweils einmal oder mehrfach auftreten und ist bei jedem Auftreten gleich oder verschieden H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R' substituiert sein kann; dabei können zwei Reste R auch miteinander ein Ringsystem bilden;
R¹ ist bei jedem Auftreten gleich oder verschieden H, D, F, Cl, Br, I, N(R²)2, CN, NO², OR², SR², Si(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können.

2. Verbindung gemäß Anspruch 1 gemäß Formel (1a), 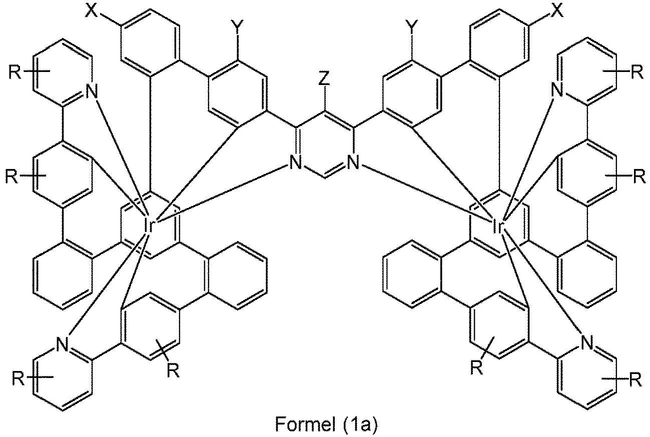 wobei die Symbole die in Anspruch 1 genannten Bedeutungen aufweisen.

3. Verbindung nach Anspruch 1 oder 2, **dadurch gekennzeichnet, dass** die beiden Substituenten X gleich sind.

4. Verbindung nach einem oder mehreren der Ansprüche 1 bis 3, ausgewählt aus den Strukturen der Formeln (1a-1), (1a-2) bzw. (1a-3), 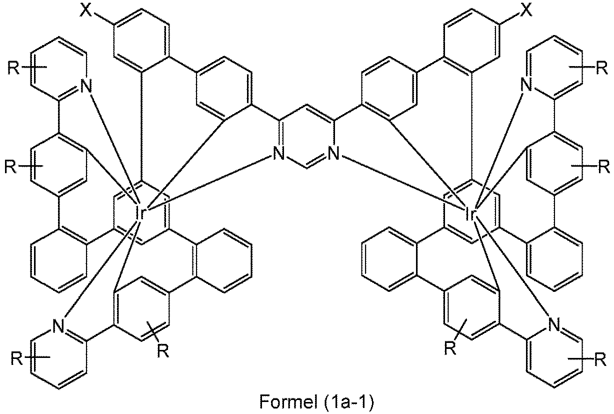 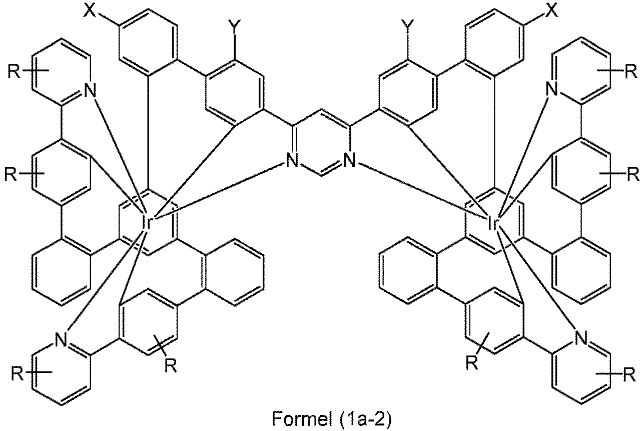 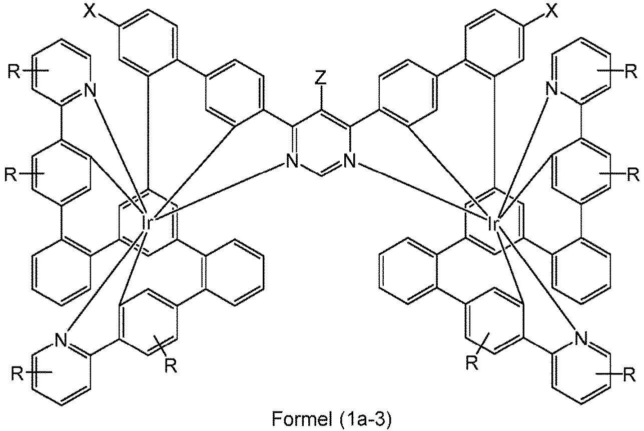 wobei beide Gruppen X gleich gewählt sind, und wobei die Gruppen Y in Formel (1a-2) jeweils für eine Gruppe -(Ar)ₙ-R stehen und gleich gewählt sind, und wobei die Gruppe Z in Formel (1a-3) für eine Gruppe -(Ar)ₙ-R steht.

5. Verbindung nach einem oder mehreren der Ansprüche 1 bis 4,
**dadurch gekennzeichnet, dass** der Rest R in der Gruppe -(Ar)ₙ-R bei jedem Auftreten gleich oder verschieden für H, eine lineare Alkylgruppe mit 1 bis 10 C-Atomen oder eine verzweigte oder cyclische Alkylgruppe mit 3 bis 10 C-Atomen steht.

6. Verbindung nach einem oder mehreren der Ansprüche 1 bis 5,
**dadurch gekennzeichnet, dass** die Strukturen (Ar1) ausgewählt sind aus den Strukturen (Ar1a) bis (Ar1f), 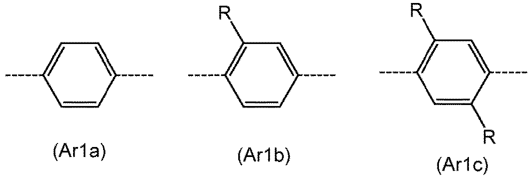 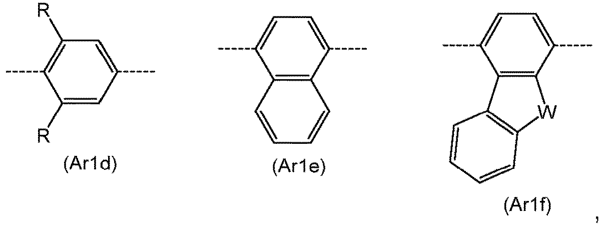
wobei die gestrichelten Bindungen die Verknüpfung der Strukturen darstellen, W für C(R¹)₂, O, S oder NR¹ steht und R und R¹ die in Anspruch 1 genannten Bedeutungen aufweisen;
und dass die Strukturen (Ar2) ausgewählt sind aus den Strukturen (Ar2a) und (Ar2b), 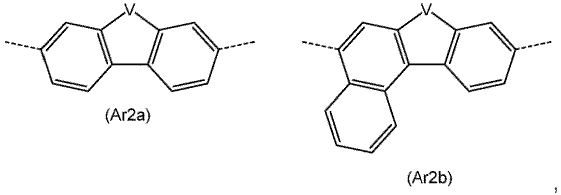
wobei die gestrichelten Bindungen die Verknüpfung der Strukturen darstellen und R und V die in Anspruch 1 genannten Bedeutungen aufweisen;
und dass die Strukturen (Ar3) ausgewählt sind aus den Strukturen (Ar3a), 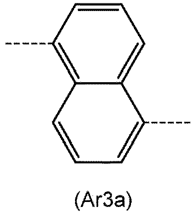
wobei die gestrichelten Bindungen die Verknüpfung der Struktur darstellen;
und dass die Strukturen (Ar4) ausgewählt sind aus den Strukturen (Ar4a) und (Ar4b), 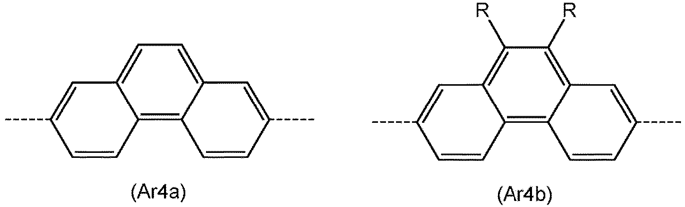
wobei die gestrichelten Bindungen die Verknüpfung der Struktur darstellen und R die in Anspruch 1 genannten Bedeutungen aufweist;
und dass die Strukturen (Ar5) ausgewählt sind aus den Strukturen (Ar5a) und (Ar5b), 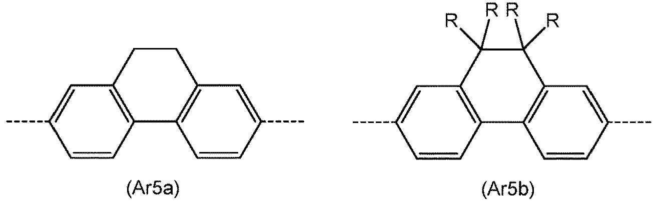
wobei die gestrichelten Bindungen die Verknüpfung der Struktur darstellen und R die in Anspruch 1 genannten Bedeutungen aufweist;
und dass die Strukturen (Ar7) ausgewählt sind aus den Strukturen (Ar7a), 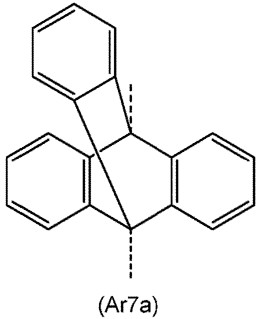
wobei die gestrichelten Bindungen die Verknüpfung der Struktur darstellen.

7. Verbindung nach einem oder mehreren der Ansprüche 1 bis 6,
**dadurch gekennzeichnet, dass** mindestens eine Gruppe Ar gleich oder verschieden bei jedem Auftreten ausgewählt ist aus den Strukturen (Ar1) und/oder (Ar2).

8. Verbindung nach einem oder mehreren der Ansprüche 1 bis 7,
**dadurch gekennzeichnet, dass** n eine ganze Zahl von 5 bis 20, insbesondere von 5 bis 15 ist, wobei die Gruppen (Ar1) bis (Ar7) so gewählt werden, dass insgesamt 8 bis 24 Phenyl- bzw. Cyclohexangruppen linear miteinander verknüpft sind.

9. Verbindung nach einem oder mehreren der Ansprüche 1 bis 8 gemäß Formel (2), 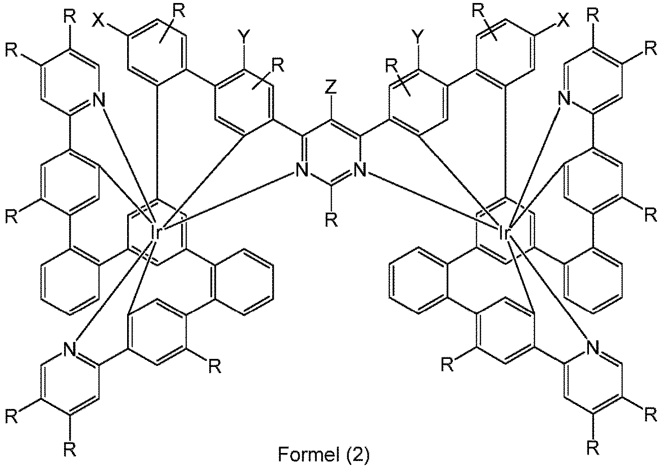 wobei die verwendeten Symbole die in Anspruch 1 aufgeführten Bedeutungen aufweisen.

10. Verbindung nach einem oder mehreren der Ansprüche 1 bis 9,
**dadurch gekennzeichnet, dass** alle vier Phenylpyridin-Teilliganden gleich substituiert sind.

11. Verfahren zur Herstellung einer Verbindung nach einem oder mehreren der Ansprüche 1 bis 10 durch Umsetzung einer Verbindung, die statt X und ggf. Y und/oder Z mit reaktiven Abgangsgruppen substituiert ist, mit einer Verbindung A-(Ar)ₙ-R, wobei A für eine reaktive Abgangsgruppe steht.

12. Formulierung, enthaltend mindestens eine Verbindung nach einem oder mehreren der Ansprüche 1 bis 10 und mindestens eine weitere Verbindung und/oder mindestens ein Lösemittel.

13. Verwendung einer Verbindung nach einem oder mehreren der Ansprüche 1 bis 10 in einer elektronischen Vorrichtung.

14. Elektronische Vorrichtung enthaltend mindestens eine Verbindung nach einem oder mehreren der Ansprüche 1 bis 10.

15. Elektronische Vorrichtung nach Anspruch 14, wobei es sich um eine organische Elektrolumineszenzvorrichtung handelt, **dadurch gekennzeichnet, dass** die Verbindung nach einem oder mehreren der Ansprüche 1 bis 10 als emittierende Verbindung in einer oder mehreren emittierenden Schichten in Kombination mit einem oder mehreren Matrixmaterialien und/oder in Kombination mit einem oder mehreren weiteren Triplettemittern eingesetzt wird.

## Claims

1. A compound according to formula (1), 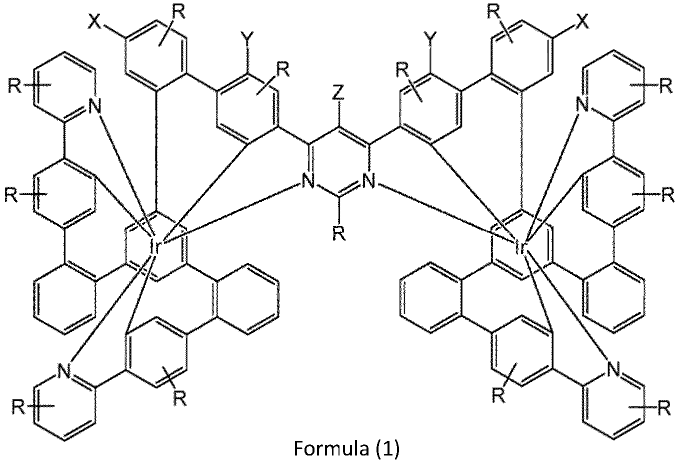 wherein the symbols and indices used are as follows:
X is the same or different at each occurrence, and is a group of the Formula -(Ar)ₙ-R;
Y is the same or different at each occurrence, and is R or X;
Z is the same or different and is R or X;
Ar is the same or different at each occurrence, and is a bivalent group selected from the structures (Ar1) to (Ar7), 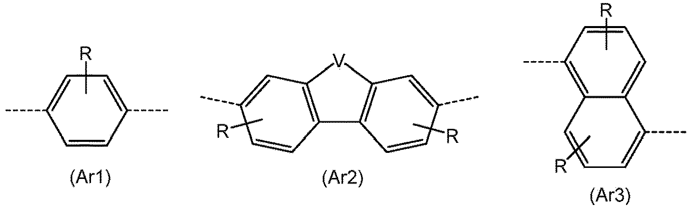 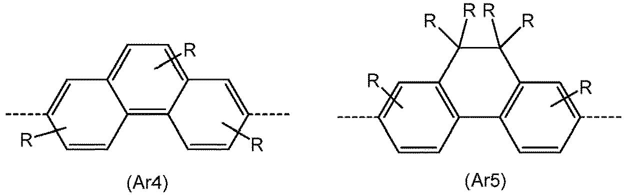 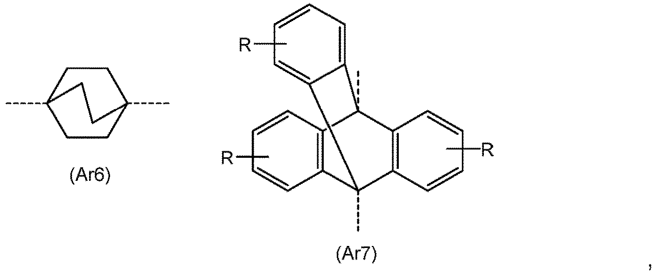 wherein the dashed bond represents the linkage of the structures and V is CR₂, O, S or NR;
n is the same or different at each occurrence, and is an integer from 3 to 20, with the proviso that in each unit -(Ar)ₙ-R at least 5 phenyl and/or cyclohexyl groups are linearly connected to each other, wherein the structures (Ar1) and (Ar3) each contribute one phenyl group, structures (Ar2), (Ar4) and (Ar5) each contribute two phenyl groups, and structures (Ar6) and (Ar7) each contribute one cyclohexane group;
R can occur once or more than once, and is the same or different at each occurrence, and is H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, a linear-chain alkyl group having 1 to 20 C-atoms or an alkenyl or alkynyl group having 2 to 20 C-atoms or a branched or cyclic alkyl group having 3 to 20 C-atoms, wherein the alkyl, alkenyl or alkynyl group can each be substituted by one or more groups R', wherein one or more non-adjacent CH₂-groups can be replaced by Si(R¹)₂, C=O, NR¹, O, S or CONR¹, or can be an aromatic or heteroaromatic ring system having 5 to 40 aromatic ring atoms, which may each be substituted by one or more groups R¹; and wherein two groups R can optionally together form a ring system;
R ¹ is the same or different at each occurrence, and is H, D, F, Cl, Br, I, N(R²)2, CN, NO₂, OR², SR², Si(R²)₃, B(OR²)₂, C(=O)R², P(=O)(R²)₂, S(=O)R², S(=O)₂R², OSO₂R², a straight-chain alkyl group having 1 to 20 C-atoms or an alkenyl or alkynyl group having 2 to 20 C-atoms or a branched or cyclic alkyl group having 3 to 20-C atoms, wherein the alkyl, alkenyl or alkynyl group may each be substituted with one or more R² radicals, wherein one or more non-adjacent CH₂ groups may be replaced by Si(R²)₂, C=O, NR², O, S or CONR², or an aromatic or heteroaromatic ring system having 5 to 40 aromatic ring atoms, each of which may be substituted by one or more radicals R²; and wherein two groups R¹ together can form a ring system;
R² is the same or different at each occurrence, and is H, D, F or an aliphatic, aromatic or heteroaromatic organic radical, in particular a hydrocarbon radical, having 1 to 20 C-atoms, in which one or more H-atoms may optionally be replaced by F.

2. The compound according to claim 1 according to formula (1a), 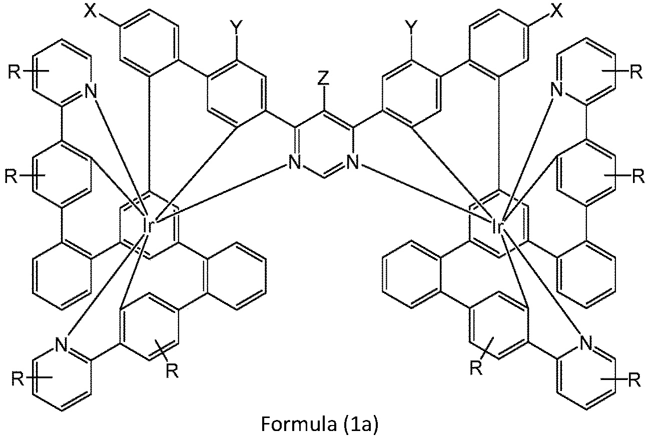 wherein the symbols have the meanings set forth in claim 1.

3. The compound according to claim 1 or 2, **characterized in that** the two substituents X are the same.

4. The compound according to any one or more of claims 1 to 3, selected from the structures of the formulas (1a-1), (1a-2) and (1a-3), respectively, 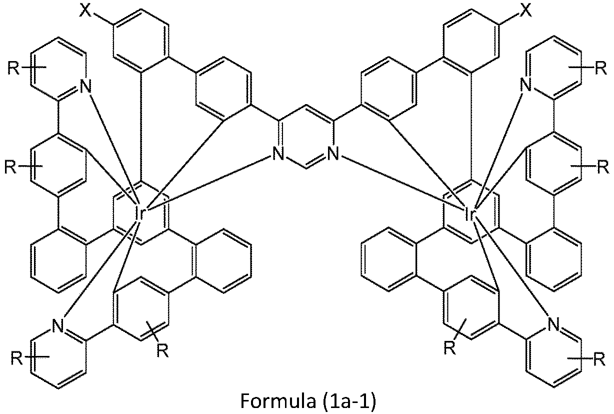 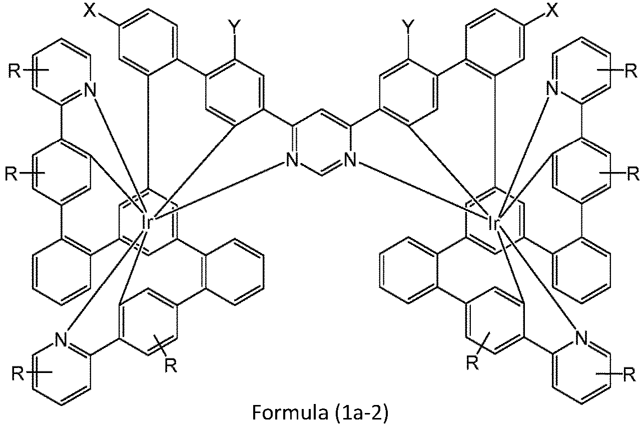 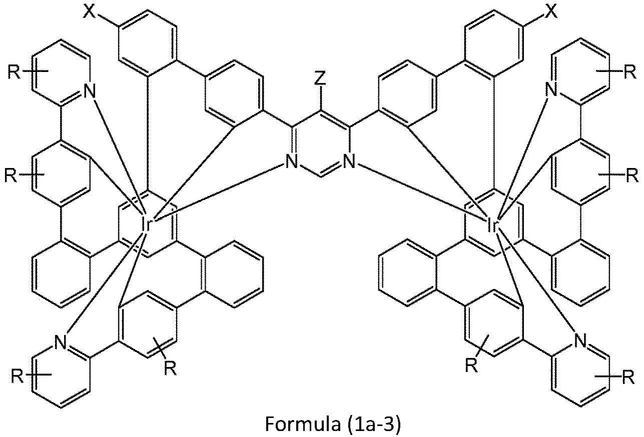
wherein both groups X are the same, and wherein groups Y in formula (1a-2) each represent a unit -(Ar)ₙ-R and are the same,
and wherein the group Z in formula (1a-3) is a unit -(Ar)ₙ-R.

5. The compound according to any one or more of claims 1 to 4,
**characterized in that** the R group in the unit -(Ar)ₙ-R is, at each occurrence, the same or different and is H, a linear alkyl group having 1 to 10 C-atoms or a branched or cyclic alkyl group having 3 to 10 C-atoms.

6. The compound according to any one or more of claims 1 to 5,
**characterized in that** the structures (Ar1) are selected from the structures (Ar1a) to (Ar1f), 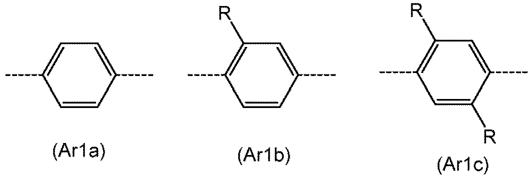 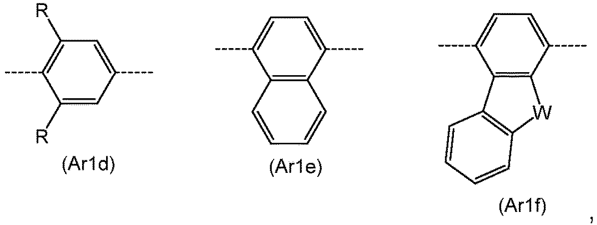
wherein the dashed bonds represent the linkage of the structures, W is C(R¹)₂, O, S, or NR¹, and R and R¹ have the meanings given in claim 1;
and that the structures (Ar2) are selected from the structures (Ar2a) and (Ar2b), 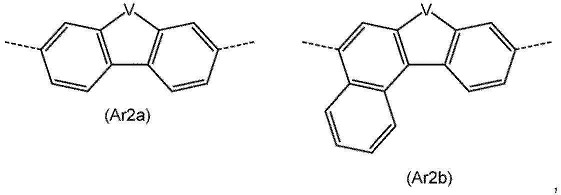
wherein the dashed bonds represent the linkage of the structures, and R and V have the meanings given in claim 1;
and that the structures (Ar3) are selected from the structures (Ar3a), 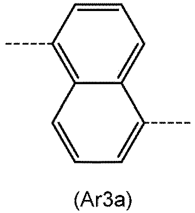
wherein the dashed bonds represent the linkage of the structure;
and that the structures (Ar4) are selected from the structures (Ar4a) and (Ar4b), 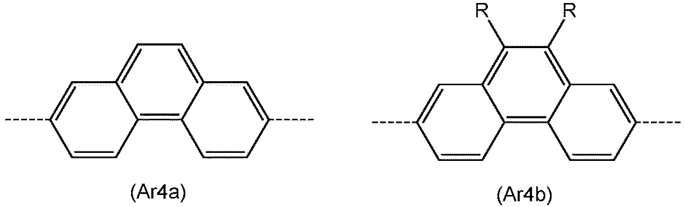
wherein the dashed bonds represent the linkage of the structure, and R has the meanings given in claim 1;
and that the structures (Ar5) are selected from the structures (Ar5a) and (Ar5b), 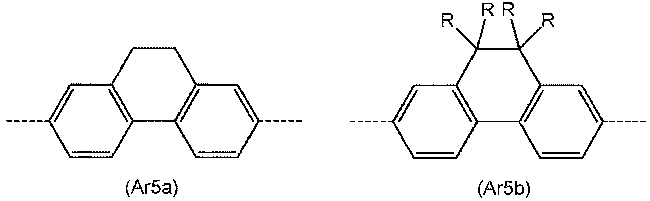
wherein the dashed bonds represent the linkage of the structure, and R has the meanings given in claim 1;
and that the structures (Ar7) are selected from the structures (Ar7a), 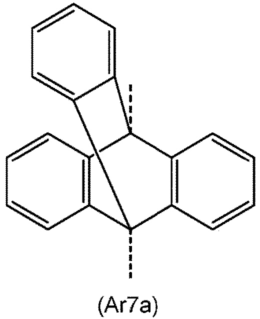
wherein the dashed bonds represent the linkage of the structure.

7. The compound according to any one or more of claims 1 to 6,
**characterized in that** at least one group Ar is the same or different at each occurrence and is selected from the structures (Ar1) and/or (Ar2).

8. The compound according to any one or more of claims 1 to 7,
**characterized in that** n is an integer from 5 to 20, in particular from 5 to 15, wherein the groups (Ar1) to (Ar7) are being chosen so that a total of 8 to 24 phenyl or cyclohexane groups are linearly connected to each other.

9. The compound according to any one or more of claims 1 to 8 according to Formula (2), 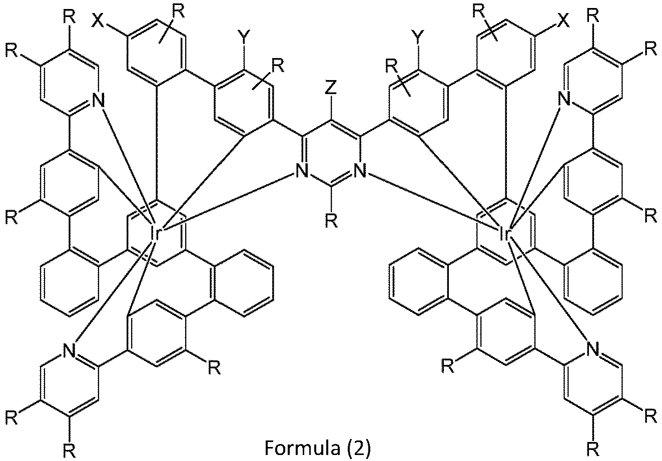 wherein the symbols used have the meanings as set forth in claim 1.

10. The compound according to any one or more of claims 1 to 9,
**characterized in that** all four phenylpyridine partial ligands are equally substituted.

11. A method for preparing a compound according to one or more of claims 1 to 10 by reacting a compound, which instead of X and optionally Y and/or Z is substituted with reactive leaving groups, with a compound A-(Ar)ₙ-R, wherein A is a reactive leaving group.

12. A formulation comprising at least one compound according to any one or more of claims 1 to 10 and at least a further compound and/or at least a solvent.

13. A use of a compound according to any one or more of the claims 1 to 10 in an electronic device.

14. An electronic device comprising at least one compound according to any one or more of claims 1 to 10.

15. The electronic device of claim 14, wherein the device is an organic electroluminescent device, **characterized in that** the compound according to any one or more of claims 1 to 10 is used as an emitting compound in one or more emitting layers in combination with one or more matrix materials and/or in combination with one or more other triplet emitters.

## Revendications

1. Composé de Formule (1), 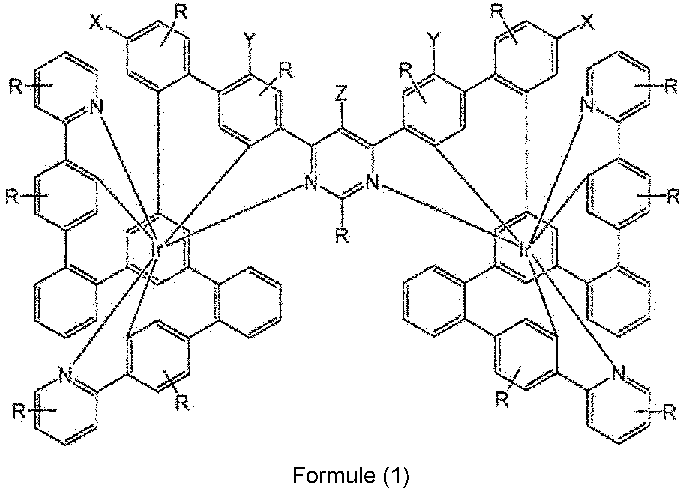 dans laquelle les symboles et les indices utilisés sont comme suit :
X est identique ou différent à chaque occurrence et est un groupe de formule - (Ar)ₙ-R,
Y est identique ou différent à chaque occurrence et est R ou X,
Z est identique ou différent et est R ou X,
Ar est identique ou différent à chaque occurrence et est un groupe bivalent qui est choisi parmi les structures (Ar1) à (Ar7), 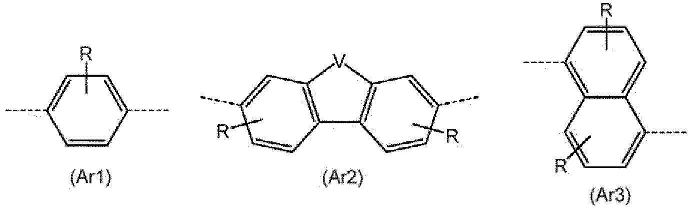 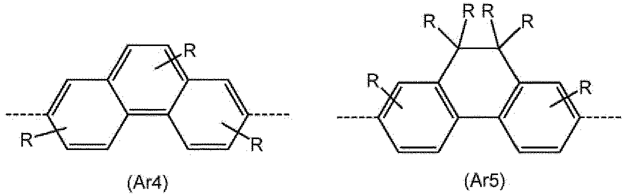 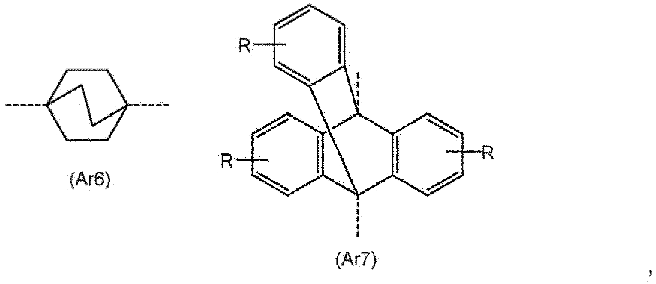
dans lesquelles la liaison en pointillés indique l'association des unités et V représente CR₂, O, S ou NR,
n est identique ou différent à chaque occurrence et est un nombre entier de 3 à 20, à condition que dans chaque unité -(Ar)ₙ-R au moins 5 groupes phényle et/ou cyclohexyle soient liés linéairement les uns aux autres, dans lequel les structures (Ar1) et (Ar3) fournissent respectivement un groupe phényle, les structures (Ar2), (Ar4) et (Ar5) deux groupes phényle et les structures (Ar6) et (Ar7) un groupe cyclohexane.
R peut respectivement apparaître une ou plusieurs fois et est identique ou différent à chaque occurrence et est H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, un groupe alkyle à chaîne droite possédant 1 à 20 atomes de C ou un groupe alcényle ou alcynyle possédant 2 à 20 atomes de C ou un groupe alkyle ramifié ou cyclique possédant 3 à 20 atomes de C, dans lequel le groupe alkyle, alcényle ou alcynyle peut respectivement être substitué par un ou plusieurs radicaux R¹ et dans lequel un ou plusieurs groupes CH₂ non adjacents peuvent être remplacés par Si(R₁)₂, C=O, NR¹, O, S ou CONR¹, ou un système cyclique aromatique ou hétéroaromatique possédant 5 à 40 atomes de cycle aromatique, qui peut respectivement être substitué par un ou plusieurs radicaux R', deux radicaux R pouvant ainsi également former un système cyclique l'un avec l'autre,
R¹ est identique ou différent à chaque occurrence et est H, D, F, Cl, Br, I, N(R²)2, CN, NO², OR², SR², Si(R²)₃, B(OR²)₂, C(=O)R², P(=O)(R²)₂, S(=O)R², S(=O)₂R², OSO₂R², un groupe alkyle à chaîne droite possédant 1 à 20 atomes de C ou un groupe alcényle ou alcynyle possédant 2 à 20 atomes de C ou un groupe alkyle ramifié ou cyclique possédant 3 à 20 atomes de C, dans lequel le groupe alkyle, alcényle ou alcynyle peut respectivement être substitué par un ou plusieurs radicaux R², dans lequel un ou plusieurs groupes CH₂ non adjacents peuvent être remplacés par Si(R²)₂, C=O, NR², O, S ou CONR², ou un système cyclique aromatique ou hétéroaromatique possédant 5 à 40 atomes de cycle aromatique, qui peut respectivement être substitué par un ou plusieurs radicaux R², deux radicaux R¹ ou plus pouvant ainsi également former un système cyclique les uns avec les autres,
R² est identique ou différent à chaque occurrence et est H, D, F ou un radical organique aliphatique, aromatique et/ou hétéroaromatique, en particulier un radical hydrocarbure possédant 1 à 20 atomes de C, dans lequel un ou plusieurs atomes de H peuvent également être remplacés par F.

2. Composé selon la revendication 1 de Formule (1a), 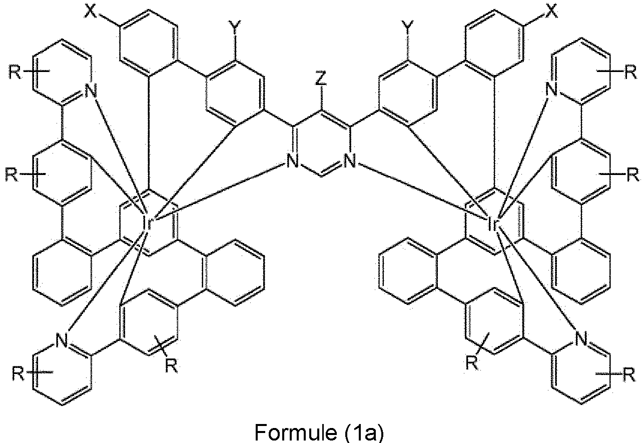 dans laquelle les symboles ont les significations indiquées dans la revendication 1.

3. Composé selon la revendication 1 ou 2, **caractérisé en ce que** les deux substituants X sont identiques.

4. Composé selon une ou plusieurs des revendications 1 à 3, choisi parmi les structures de Formules (1a-1), (1a-2) ou (1a-3), 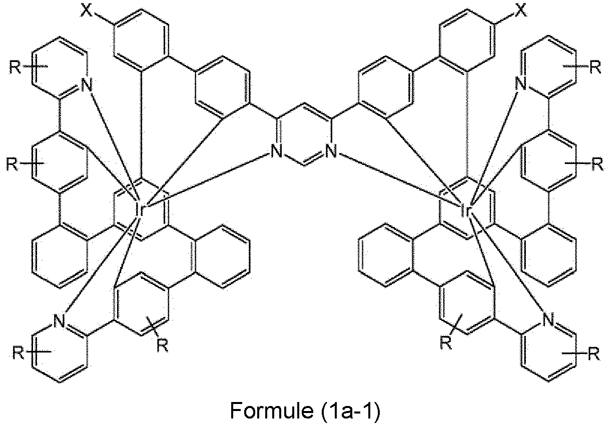 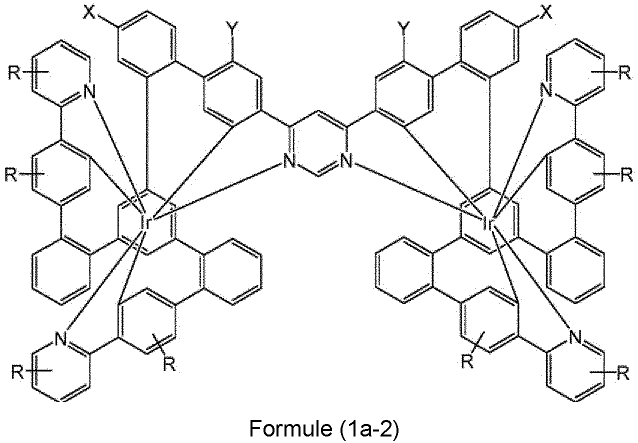 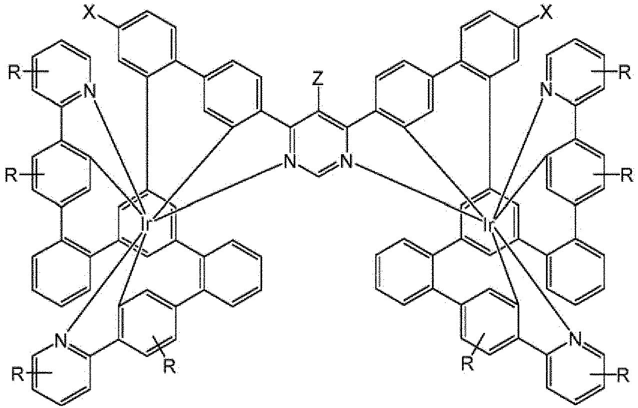 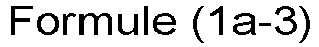 dans lesquelles les deux groupes X sont choisis identiques, et dans lesquelles les groupes Y dans la Formule (1a-2) représentent chacun un groupe -(Ar)ₙ-R et sont choisis identiques, et dans lesquelles le groupe Z dans la Formule (1a-3) représente un groupe - (Ar)n-R.

5. Composé selon une ou plusieurs des revendications 1 à 4, **caractérisé en ce que** le radical R dans le groupe -(Ar)ₙ-R est identique ou différent à chaque occurrence et est H, un groupe alkyle linéaire possédant 1 à 10 atomes de carbone ou un groupe alkyle ramifié ou cyclique possédant 3 à 10 atomes de carbone.

6. Composé selon une ou plusieurs des revendications 1 à 5, **caractérisé en ce que** les structures (Ar1) sont choisies parmi les structures (Ar1a) à (Ar1f), 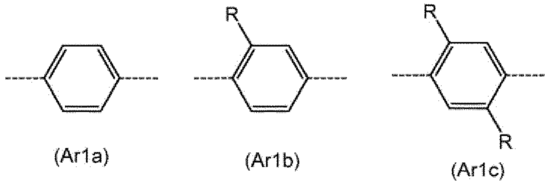 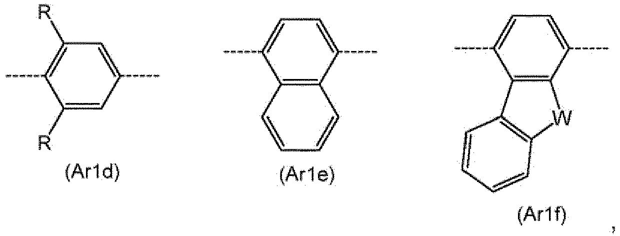 dans lesquelles les liaisons en pointillés représentent l'association des structures, W représente C(R¹)₂, O, S ou NR¹ et R et R¹ ont les significations indiquées dans la revendication 1,
et les structures (Ar2) sont choisies parmi les structures (Ar2a) et (Ar2b), 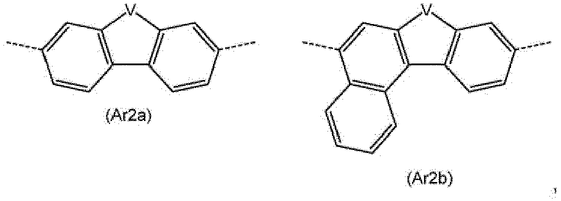
dans lesquelles les liaisons en pointillés représentent l'association des structures et R et V ont les significations indiquées dans la revendication 1,
et les structures (Ar3) sont choisies parmi les structures (Ar3a), 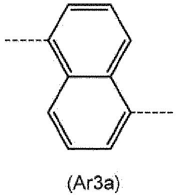
dans laquelle les liaisons en pointillés représentent l'association de la structure, et les structures (Ar4) sont choisies parmi les structures (Ar4a) et (Ar4b), 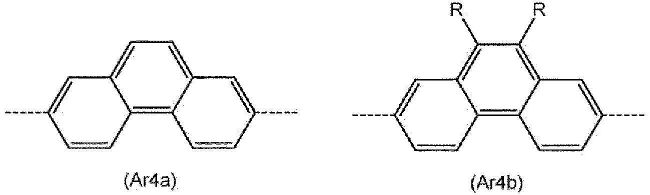
dans lesquelles les liaisons en pointillés représentent l'association de la structure et R a les significations indiquées dans la revendication 1,
et les structures (Ar5) sont choisies parmi les structures (Ar5a) et (Ar5b), 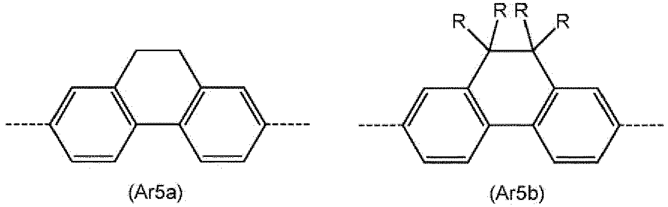
dans lesquelles les liaisons en pointillés représentent l'association de la structure et R a les significations indiquées dans la revendication 1,
et les structures (Ar7) sont choisies parmi les structures (Ar7a), 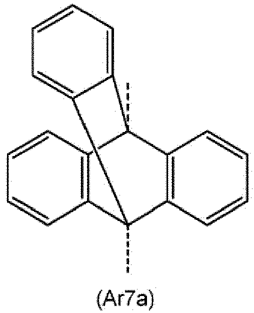
dans laquelle les liaisons en pointillés représentent l'association de la structure.

7. Composé selon une ou plusieurs des revendications 1 à 6, **caractérisé en ce qu'**au moins un groupe Ar est identique ou différent à chaque occurrence et est choisi parmi les structures (Ar1) et/ou (Ar2).

8. Composé selon une ou plusieurs des revendications 1 à 7, **caractérisé en ce que** n est un nombre entier de 5 à 20, en particulier de 5 à 15, dans lequel les groupes (Ar1) à (Ar7) sont choisis de telle sorte qu'au total 8 à 24 groupes phényle ou cyclohexane sont liés linéairement les uns aux autres.

9. Composé selon une ou plusieurs des revendications 1 à 8 de Formule (2), 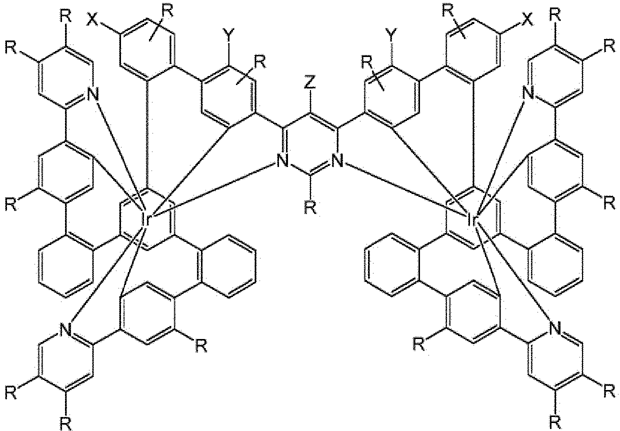 dans laquelle les symboles utilisés ont les significations indiquées dans la revendication 1.

10. Composé selon une ou plusieurs des revendications 1 à 9, **caractérisé en ce que** les quatre sous-ligands phénylpyridine sont tous substitués de manière identique.

11. Procédé de préparation d'un composé selon une ou plusieurs des revendications 1 à 10, consistant à faire réagir un composé qui est substitué par des groupes partants réactifs à la place de X et éventuellement Y et/ou Z, avec un composé A-(Ar)ₙ-R, dans lequel A représente un groupe partant réactif.

12. Formulation contenant au moins un composé selon une ou plusieurs des revendications 1 à 10 et au moins un composé supplémentaire et/ou au moins un solvant.

13. Utilisation d'un composé selon une ou plusieurs des revendications 1 à 10 dans un dispositif électronique.

14. Dispositif électronique contenant au moins un composé selon une ou plusieurs des revendications 1 à 10.

15. Dispositif électronique selon la revendication 14, qui est un dispositif électroluminescent organique, **caractérisé en ce que** le composé selon une ou plusieurs des revendications 1 à 10 est utilisé comme composé émetteur dans une ou plusieurs couches émettrices en combinaison avec un ou plusieurs matériaux de matrice et/ou en combinaison avec un ou plusieurs émetteurs triplets supplémentaires.
